# EUROPEAN PATENT APPLICATION

(11) **EP 4 636 410 A1**
(43) Date of publication of application: **22.10.2025**
(21) Application number: 24170993.0
(22) Date of filing: 18.04.2024
(51) Int. Cl.: G01R 19/165, G01R 31/396, G01R 31/40, H02J 7/00

(54) **ELECTRICAL SYSTEM WITH VOLTAGE SENSING**

(71) Applicant: Instagrid GmbH, 71636 Ludwigsburg (DE)
(72) Inventor: Gutknecht, Philipp, Mönsheim (DE)
(74) Representative: Eisenführ Speiser

(57) **Abstract**

An example power circuit may include a first set of voltage sources and a second set of voltage sources. The first set of voltage sources and the second set of voltage sources may be connected via an inductor. In a mode of operation, the inductor may be disposed in a series connection between the first set of voltage sources and the second set of voltage sources. An example method for monitoring an output voltage of the power circuit may include measuring, via a first differential amplifier, a first voltage across the first set of voltage sources to generate a first signal and measuring, via a second differential amplifier, a second voltage across the second set of voltage sources to generate a second signal. A total voltage signal may be evaluated based on the first signal and the second signal. The output voltage may be calculated from the total voltage signal.

## Description

### BACKGROUND

### 1. Technical Field

This disclosure relates generally to electrical power systems, such as power inverters, and, in some non-limiting embodiments or aspects, to power supply systems with selectable output voltage and voltage sensing, methods of monitoring voltages of such power supply systems, and computer program products for monitoring voltages of such power supply systems.

### 2. Technical Considerations

Mains electric power (e.g., power grid, utility power, domestic power, and/or the like) can be used to power many different types of electrical devices. However, mains electric power may not be readily available or accessible everywhere. For example, to provide electric power at sites lacking a fixed or reliable mains electric power connection, combustion engine-based generators may be used. Such generators can cause local air and noise pollution. Moreover, such generators can be unsuitable for certain applications such as operating in enclosed spaces with limited air circulation.

Power supplies based on electric batteries can be a more suitable alternative to generators, e.g., in terms of quiet operation and no exhaust gases. However, batteries provide direct current (DC) voltage. The DC voltage must be converted to alternating current (AC) voltage to be suitable for electrical devices designed to be connected to (e.g., plugged into) mains electric power.

Additionally, the nominal AC voltage of mains electric power varies based on location (e.g., nation and/or region). For example, mains electric power in some areas (e.g., the United States of America, North America, etc.) may have a nominal AC voltage of about 110 or 120 volts (V). However, mains electric power in other areas (e.g., the European Union, etc.) may have a nominal AC voltage of about 220 or 240 V. Due to different mains electrical power available in different areas, usability of electrical devices designed and/or rated for one area may be limited and/or unusable in another area with different mains electrical power. Even electrical power systems such as uninterruptible power supply (UPS) systems are usually designed for just one of the areas.

In certain electrical systems, e.g., those operable for converting DC voltage to AC voltage, the output voltage may need to be measured to properly control the circuitry for converting DC voltage to AC voltage (e.g., an inverter, a pulse-width modulation (PWM) controller, and/or the like). However, when a filter (e.g., LC filter) is included at the output, the filter may introduce a phase shift (e.g., -180° phase shift when above a certain frequency) and/or otherwise make direct measurement of voltage at the output difficult and/or unsuitable for control of the circuitry. Moreover, if the inductor (L) and capacitor (C) of an LC filter are not directly connected in the circuitry (e.g., due to other circuit components being connected between the inductor and capacitor), it can be difficult to determine where to measure voltage within the circuitry (e.g., to avoid the aforementioned effects of the LC filter).

There exists a need for an electrical system (e.g., power supply) that can be configured for multiple types of output power (e.g., output power with different ranges of AC voltage) and techniques for monitoring voltages of such power supply systems.

### SUMMARY

Accordingly, provided are improved power systems such as inverters selectable output voltage and voltage sensing, methods of monitoring voltages of such power supply systems, and computer program products for monitoring voltages of such power supply systems (e.g., that overcome some or all of the deficiencies identified above).

According to non-limiting embodiments or aspects, provided is a method for monitoring an output voltage of a power circuit, which may include a first set of voltage sources and a second set of voltage sources. The first set of voltage sources and the second set of voltage sources may be connected via an inductor. In a mode of operation, the inductor may be disposed in a series connection between the first set of voltage sources and the second set of voltage sources. The method may include measuring, via a first differential amplifier, a first voltage across the first set of voltage sources to generate a first signal, measuring, via a second differential amplifier, a second voltage across the second set of voltage sources to generate a second signal, evaluating a total voltage signal based on the first signal and the second signal, and/or calculating the output voltage from the total voltage signal.

In some non-limiting embodiments or aspects, the output voltage may be controlled based on the total voltage signal.

In some non-limiting embodiments or aspects, a fixed reference voltage may be provided to at least one of the first differential amplifier, the second differential amplifier, or any combination thereof.

In some non-limiting embodiments or aspects, the fixed reference voltage may include substantially half of a reference voltage of an analog-to-digital converter (ADC).

In some non-limiting embodiments or aspects, the fixed reference voltage may be provided to the second differential amplifier. The second signal generated by the second differential amplifier may be provided as a reference voltage to the first differential amplifier.

In some non-limiting embodiments or aspects, a filtering operation may be performed by at least one of the first differential amplifier, the second differential amplifier, or any combination thereof.

In some non-limiting embodiments or aspects, the filtering operation may include a low-pass filtering operation.

In some non-limiting embodiments or aspects, a plurality of resistors and zero or more capacitors may be connected to the at least one of the first differential amplifier, the second differential amplifier, or any combination thereof. Performing the filtering operation may include performing the filtering operation based on the plurality of resistors and the zero or more capacitors.

In some non-limiting embodiments or aspects, the plurality of resistors may include two resistors for each of the first differential amplifier and the second differential amplifier. The zero or more capacitors may include zero capacitors. The filtering operation may include a first order filtering operation.

In some non-limiting embodiments or aspects, the plurality of resistors may include four resistors for each of the first differential amplifier and the second differential amplifier. The zero or more capacitors may include one capacitor for each of the first differential amplifier and the second differential amplifier. The filtering operation may include a second-order filtering operation.

In some non-limiting embodiments or aspects, the plurality of resistors may include six resistors for each of the first differential amplifier and the second differential amplifier. The zero or more capacitors may include two capacitors for each of the first differential amplifier and the second differential amplifier. The filtering operation may include a third-order filtering operation.

In some non-limiting embodiments or aspects, the first set of voltage sources may include a first set of energy storage modules. The second set of voltage sources may include a second set of energy storage modules.

In some non-limiting embodiments or aspects, at least one energy storage module of the first set of energy storage modules or the second set of energy storage modules may include an inverter circuit.

In some non-limiting embodiments or aspects, the inverter circuit may include an H-bridge inverter circuit.

In some non-limiting embodiments or aspects, an output of at least one energy storage module of the first set of energy storage modules or the second set of energy storage modules may include a pulse-width modulation (PWM) waveform.

In some non-limiting embodiments or aspects, the inductor may include a choke.

In some non-limiting embodiments or aspects, the output voltage may be provided by at least some voltage sources from the first set of voltage sources and the second set of voltage sources.

In some non-limiting embodiments or aspects, evaluating the total voltage signal may include inputting at least one of the first signal, the second signal, or any combination thereof to an analog-to-digital converter.

In some non-limiting embodiments or aspects, the total voltage signal may include a sum of the first signal and the second signal.

In some non-limiting embodiments or aspects, calculating the output voltage may include calculating the output voltage based on the total voltage signal without measuring a voltage at an output of the power circuit.

According to non-limiting embodiments or aspects, provided is an electrical system, which may include a power circuit including a first set of voltage sources and a second set of voltage sources. The first set of voltage sources and the second set of voltage sources may be connected via an inductor. In a mode of operation the inductor may be disposed in a series connection between the first set and the second set. A first differential amplifier may be configured to measure a first voltage across the first set of voltage sources to generate a first signal. A second differential amplifier may be configured to measure a second voltage across the second set of voltage sources to generate a second signal. Circuitry may be configured to monitor an output voltage of the power circuit by evaluating a total voltage signal using the first signal and the second signal and calculating the output voltage from the total voltage signal.

In some non-limiting embodiments or aspects, the circuitry may be further configured to control the output voltage based on the total voltage signal.

In some non-limiting embodiments or aspects, a fixed reference voltage may be provided to at least one of the first differential amplifier, the second differential amplifier, or any combination thereof.

In some non-limiting embodiments or aspects, the fixed reference voltage may include substantially half of a reference voltage of an analog-to-digital converter (ADC).

In some non-limiting embodiments or aspects, the fixed reference voltage may be provided to the second differential amplifier, and the second signal generated by the second differential amplifier may be provided as a reference voltage to the first differential amplifier.

In some non-limiting embodiments or aspects, at least one of the first differential amplifier, the second differential amplifier, or any combination thereof may be configured to perform a filtering operation.

In some non-limiting embodiments or aspects, the filtering operation comprises a low-pass filtering operation.

In some non-limiting embodiments or aspects, a plurality of resistors and zero or more capacitors may be connected to the at least one of the first differential amplifier, the second differential amplifier, or any combination thereof. Performing the filtering operation may include performing the filtering operation based on the plurality of resistors and the zero or more capacitors.

In some non-limiting embodiments or aspects, the plurality of resistors may include two resistors for each of the first differential amplifier and the second differential amplifier. The zero or more capacitors may include zero capacitors. The filtering operation may include a first order filtering operation.

In some non-limiting embodiments or aspects, the plurality of resistors may include four resistors for each of the first differential amplifier and the second differential amplifier. The zero or more capacitors may include one capacitor for each of the first differential amplifier and the second differential amplifier. The filtering operation may include a second-order filtering operation.

In some non-limiting embodiments or aspects, the plurality of resistors may include six resistors for each of the first differential amplifier and the second differential amplifier. The zero or more capacitors may include two capacitors for each of the first differential amplifier and the second differential amplifier. The filtering operation may include a third-order filtering operation.

In some non-limiting embodiments or aspects, the first set of voltage sources may include a first set of energy storage modules. The second set of voltage sources may include a second set of energy storage modules.

In some non-limiting embodiments or aspects, at least one energy storage module of the first set of energy storage modules or the second set of energy storage modules may include an inverter circuit.

In some non-limiting embodiments or aspects, the inverter circuit may include an H-bridge inverter circuit.

In some non-limiting embodiments or aspects, an output of at least one energy storage module of the first set of energy storage modules or the second set of energy storage modules may include a pulse-width modulation (PWM) waveform.

In some non-limiting embodiments or aspects, the inductor may include a choke.

In some non-limiting embodiments or aspects, the output voltage may be provided by at least some voltage sources from the first set of voltage sources and the second set of voltage sources.

In some non-limiting embodiments or aspects, evaluating the total voltage signal may include inputting at least one of the first signal, the second signal, or any combination thereof to an analog-to-digital converter.

In some non-limiting embodiments or aspects, the total voltage signal may include a sum of the first signal and the second signal.

In some non-limiting embodiments or aspects, calculating the output voltage may include calculating the output voltage based on the total voltage signal without measuring a voltage at an output of the power circuit.

In some non-limiting embodiments or aspects, a fixed reference voltage may be connected to a first input of the second differential amplifier via a first capacitor and a first resistor. An output of the second differential amplifier may be connected to a second input of the second amplifier via a second capacitor and a second resistor. The output of the second differential amplifier may be connected to a first input of the first differential amplifier via a third capacitor and a third resistor. An output of the first differential amplifier may be connected to a second input of the first differential amplifier via a fourth capacitor and a fourth resistor.

In some non-limiting embodiments or aspects, a first side of the first set of voltage sources may be connected to the first input of the first differential amplifier via at least one fifth resistor. A second side of the first set of voltage sources may be connected to the second input of the first differential amplifier via at least one sixth resistor. A first side of the second set of voltage sources may be connected to the first input of the second amplifier via at least one seventh resistor. A second side of the second set of voltage sources may be connected to is connected to the second input of the second amplifier via at least one eighth resistor. The first side of the first set of voltage sources may be connected to a first winding of the inductor. The second side of the second set of voltage sources may be connected to a second winding of the inductor.

In some non-limiting embodiments or aspects, the at least one fifth resistor may include a plurality of fifth resistors, and the at least one sixth resistor may include a plurality of sixth resistors. At least one fifth capacitor may be connected between at least one pair of the plurality of fifth resistors and at least one pair of the plurality of sixth resistors. The at least one seventh resistor may include a plurality of seventh resistors, and the at least one eighth resistor may include a plurality of eighth resistors. At least one sixth capacitor may be connected between at least one pair of the plurality of seventh resistors and at least one pair of the plurality of eighth resistors.

In some non-limiting embodiments or aspects, an output of the second differential amplifier may be connected to a first input of the first differential amplifier. An output of the first differential amplifier may be connected to an analog-to-digital converter (ADC).

In some non-limiting embodiments or aspects, a third differential amplifier may be connected to the inductor. An output of the third amplifier may be connected to the ADC.

In some non-limiting embodiments or aspects, a switch may be configured to switch between a first state associated with a first mode of operation and a second state associated with a second mode of operation. For example, the mode of operation may include the second mode of operation. In some non-limiting embodiments or aspects, upon switching the switch to the first state, the first set of voltage sources may be connected in parallel with the second set of voltage sources and the circuitry may be configured to measure the output voltage based on the output of the third amplifier. Upon switching the switch to the second state, the first set of voltage sources may be connected in series with the second set of voltage sources and the circuitry may be configured to measure the voltage based on the output of the first amplifier.

In some non-limiting embodiments or aspects, a third differential amplifier may be configured to additively combine the output of the first amplifier and the output of the second amplifier.

In some non-limiting embodiments or aspects, the circuitry may include at least one analog-to-digital converter (ADC). The at least one ADC may be configured to convert at least one of the first signal, the second signal, or any combination thereof to at least one digital output.

In some non-limiting embodiments or aspects, the at least one ADC may be configured to convert the first signal to a first digital output and convert the second signal to a second digital output.

In some non-limiting embodiments or aspects, the circuitry may be further configured to remove a direct current (DC) offset from the first digital output to provide a first intermediate digital output, remove the DC offset from the second digital output to provide a second intermediate digital output, and/or additively combine the first intermediate digital output and the second intermediate digital output.

According to non-limiting embodiments or aspects, provided is a computer program product for monitoring an output voltage of a power circuit, which may include a first set of voltage sources and a second set of voltage sources. The first set of voltage sources and the second set of voltage sources may be connected via an inductor. In a mode of operation, the inductor may be disposed in a series connection between the first set and the second set. The computer program product may include at least one non-transitory computer-readable medium including program instructions that, when executed by at least one processor, cause the at least one processor to evaluate a total voltage signal using a first signal and a second signal and/or calculate the output voltage from the total voltage signal. The first signal may be generated by a first differential amplifier measuring a first voltage across the first set of voltage sources, and the second signal may be generated by a second differential amplifier measuring a second voltage across the second set of voltage sources.

In some non-limiting embodiments or aspects, the instructions, when executed by the at least one processor, may further cause the at least one processor to control the output voltage based on the total voltage signal.

In some non-limiting embodiments or aspects, a fixed reference voltage may be provided to at least one of the first differential amplifier, the second differential amplifier, or any combination thereof.

In some non-limiting embodiments or aspects, the fixed reference voltage may include substantially half of a reference voltage of an analog-to-digital converter (ADC).

In some non-limiting embodiments or aspects, the fixed reference voltage may be provided to the second differential amplifier, and the second signal generated by the second differential amplifier may be provided as a reference voltage to the first differential amplifier.

In some non-limiting embodiments or aspects, at least one of the first differential amplifier, the second differential amplifier, or any combination thereof may be configured to perform a filtering operation.

In some non-limiting embodiments or aspects, the filtering operation may include a low-pass filtering operation.

In some non-limiting embodiments or aspects, a plurality of resistors and zero or more capacitors may be connected to the at least one of the first differential amplifier, the second differential amplifier, or any combination thereof. The filtering operation may include performing the filtering operation based on the plurality of resistors and the zero or more capacitors.

In some non-limiting embodiments or aspects, the plurality of resistors may include two resistors for each of the first differential amplifier and the second differential amplifier. The zero or more capacitors may include zero capacitors. The filtering operation may include a first order filtering operation.

In some non-limiting embodiments or aspects, the plurality of resistors may include four resistors for each of the first differential amplifier and the second differential amplifier. The zero or more capacitors may include one capacitor for each of the first differential amplifier and the second differential amplifier. The filtering operation may include a second-order filtering operation.

In some non-limiting embodiments or aspects, the plurality of resistors may include six resistors for each of the first differential amplifier and the second differential amplifier. The zero or more capacitors may include two capacitors for each of the first differential amplifier and the second differential amplifier. The filtering operation may include a third-order filtering operation.

In some non-limiting embodiments or aspects, the first set of voltage sources may include a first set of energy storage modules. The second set of voltage sources comprises a second set of energy storage modules.

In some non-limiting embodiments or aspects, at least one energy storage module of the first set of energy storage modules or the second set of energy storage modules may include an inverter circuit.

In some non-limiting embodiments or aspects, the inverter circuit may include an H-bridge inverter circuit.

In some non-limiting embodiments or aspects, an output of at least one energy storage module of the first set of energy storage modules or the second set of energy storage modules may include a pulse-width modulation (PWM) waveform.

In some non-limiting embodiments or aspects, the inductor may include a choke.

In some non-limiting embodiments or aspects, the output voltage may be provided by at least some voltage sources from the first set of voltage sources and the second set of voltage sources.

In some non-limiting embodiments or aspects, evaluating the total voltage signal may include inputting at least one of the first signal, the second signal, or any combination thereof to an analog-to-digital converter.

In some non-limiting embodiments or aspects, the total voltage signal may include a sum of the first signal and the second signal.

In some non-limiting embodiments or aspects, calculating the output voltage may include calculating the output voltage based on the total voltage signal without measuring a voltage at an output of the power circuit.

In some non-limiting embodiments or aspects, a fixed reference voltage may be connected to a first input of the second differential amplifier via a first capacitor and a first resistor. An output of the second differential amplifier may be connected to a second input of the second amplifier via a second capacitor and a second resistor. The output of the second differential amplifier may be connected to a first input of the first differential amplifier via a third capacitor and a third resistor. An output of the first differential amplifier is connected to a second input of the first differential amplifier via a fourth capacitor and a fourth resistor.

In some non-limiting embodiments or aspects, a first side of the first set of voltage sources may be connected to the first input of the first differential amplifier via at least one fifth resistor. A second side of the first set of voltage sources may be connected to the second input of the first differential amplifier via at least one sixth resistor. A first side of the second set of voltage sources may be connected to the first input of the second amplifier via at least one seventh resistor. A second side of the second set of voltage sources may be connected to is connected to the second input of the second amplifier via at least one eighth resistor. The first side of the first set of voltage sources may be connected to a first winding of the inductor. The second side of the second set of voltage sources may be connected to a second winding of the inductor.

In some non-limiting embodiments or aspects, the at least one fifth resistor may include a plurality of fifth resistors, and the at least one sixth resistor may include a plurality of sixth resistors. At least one fifth capacitor may be connected between at least one pair of the plurality of fifth resistors and at least one pair of the plurality of sixth resistors. The at least one seventh resistor may include a plurality of seventh resistors, and the at least one eighth resistor may include a plurality of eighth resistors. At least one sixth capacitor may be connected between at least one pair of the plurality of seventh resistors and at least one pair of the plurality of eighth resistors.

In some non-limiting embodiments or aspects, an output of the second differential amplifier may be connected to a first input of the first differential amplifier. An output of the first differential amplifier may be connected to an analog-to-digital converter (ADC).

In some non-limiting embodiments or aspects, the power circuit further may include a third differential amplifier connected to the inductor. An output of the third amplifier may be connected to the ADC.

In some non-limiting embodiments or aspects, the power circuit may further include a switch configured to switch between a first state associated with a first mode of operation and a second state associated with a second mode of operation. For example, the mode of operation may include the second mode of operation. Upon switching the switch to the first state, the first set of voltage sources may be connected in parallel with the second set of voltage sources, and the instructions, when executed by the at least one processor, may further cause the at least one processor to measure the output voltage based on the output of the third amplifier. Upon switching the switch to the second state, the first set of voltage sources may be connected in series with the second set of voltage sources, and the instructions, when executed by the at least one processor, may further cause the at least one processor to measure the voltage based on the output of the first amplifier.

In some non-limiting embodiments or aspects, the power circuit may further include a third differential amplifier configured to additively combine the output of the first amplifier and the output of the second amplifier.

In some non-limiting embodiments or aspects, the power circuit may further include at least one analog-to-digital converter (ADC). The at least one ADC may be configured to convert at least one of the first signal, the second signal, or any combination thereof to at least one digital output.

In some non-limiting embodiments or aspects, the at least one ADC may be configured to convert the first signal to a first digital output and convert the second signal to a second digital output.

In some non-limiting embodiments or aspects, the instructions, when executed by the at least one processor, may further cause the at least one processor to remove a direct current (DC) offset from the first digital output to provide a first intermediate digital output, remove the DC offset from the second digital output to provide a second intermediate digital output, and/or additively combine the first intermediate digital output and the second intermediate digital output.

These and other features and characteristics of the present disclosure, as well as the methods of operation and functions of the related elements of structures and the combination of parts and economies of manufacture, will become more apparent upon consideration of the following description and the appended claims with reference to the accompanying drawings, all of which form a part of this specification, wherein like reference numerals designate corresponding parts in the various figures. It is to be expressly understood, however, that the drawings are for the purpose of illustration and description only and are not intended as a definition of the limits of the disclosed subject matter.

### BRIEF DESCRIPTION OF THE DRAWINGS

Additional advantages and details are explained in greater detail below with reference to the non-limiting, exemplary embodiments that are illustrated in the accompanying schematic figures, in which:
FIG. 1A is a schematic diagram of an example energy storage module, according to some non-limiting embodiments or aspects;
FIGS. 1B and 1C are circuit diagrams of an example energy storage module, according to some non-limiting embodiments or aspects;
FIGS. 2A-2C are schematic diagrams of an example energy storage module container of energy storage modules, according to some non-limiting embodiments or aspects;
FIGS. 3A and 3B are schematic diagrams of an example power supply system, according to some non-limiting embodiments or aspects;
FIGS. 4A and 4B are circuit diagrams of example power supply systems, according to some non-limiting embodiments or aspects;
FIGS. 5A and 5B are circuit diagrams showing load and circular currents of an example power supply system in a first mode of operation, according to some non-limiting embodiments or aspects;
FIG. 6A is a circuit diagram of an example power supply system in a first mode of operation, according to some non-limiting embodiments or aspects;
FIG. 6B shows graphs of voltages of the example power supply system of FIG. 6A, according to some non-limiting embodiments or aspects;
FIG. 7A is a circuit diagram of an example power supply system in a second mode of operation, according to some non-limiting embodiments or aspects;
FIG. 7B shows graphs of voltages of the example power supply system of FIG. 7A, according to some non-limiting embodiments or aspects;
FIG. 8 is a circuit diagram of an example power supply system in a second mode of operation, according to some non-limiting embodiments or aspects;
FIG. 9 is a circuit diagram of an example power supply system, according to some non-limiting embodiments or aspects;
FIG. 10 is a circuit diagram of an example power supply system, according to some non-limiting embodiments or aspects;
FIG. 11 is a flow diagram of an example method for using a power supply system, according to some non-limiting embodiments or aspects;
FIG. 12 is a schematic diagram of example components of one or more devices, according to some non-limiting embodiments or aspects;
FIGS. 13A-13D are circuit diagrams of example power supply systems with voltage sensing, according to some non-limiting embodiments or aspects;
FIG. 14 is a circuit diagram of an example power supply system with voltage sensing, according to some non-limiting embodiments or aspects;
FIGS. 15A-15C are circuit diagrams of an example power supply system with voltage sensing, according to some non-limiting embodiments or aspects;
FIGS. 16A-16C are circuit diagrams of an example power supply system with voltage sensing, according to some non-limiting embodiments or aspects; and
FIG. 17 is a flow diagram of an example method of monitoring voltages of power supply systems, according to some non-limiting embodiments or aspects.

### DESCRIPTION

For purposes of the description hereinafter, the terms "end," "upper," "lower," "right," "left," "vertical," "horizontal," "top," "bottom," "lateral," "longitudinal," and derivatives thereof shall relate to the embodiments as they are oriented in the drawing figures. However, it is to be understood that the present disclosure may assume various alternative variations and step sequences, except where expressly specified to the contrary. It is also to be understood that the specific devices and processes illustrated in the attached drawings, and described in the following specification, are simply exemplary and non-limiting embodiments or aspects of the disclosed subject matter. Hence, specific dimensions and other physical characteristics related to the embodiments or aspects disclosed herein are not to be considered as limiting.

Some non-limiting embodiments or aspects are described herein in connection with thresholds. As used herein, satisfying a threshold may refer to a value being greater than the threshold, more than the threshold, higher than the threshold, greater than or equal to the threshold, less than the threshold, fewer than the threshold, lower than the threshold, less than or equal to the threshold, equal to the threshold, etc.

No aspect, component, element, structure, act, step, function, instruction, and/or the like used herein should be construed as critical or essential unless explicitly described as such. Also, as used herein, the articles "a" and "an" are intended to include one or more items and may be used interchangeably with "one or more" and "at least one." Furthermore, as used herein, the term "set" is intended to include one or more items (e.g., related items, unrelated items, a combination of related and unrelated items, and/or the like) and may be used interchangeably with "one or more" or "at least one." Where only one item is intended, the term "one" or similar language is used. Also, as used herein, the terms "has," "have," "having," or the like are intended to be open-ended terms. Further, the phrase "based on" is intended to mean "based at least partially on" unless explicitly stated otherwise. In addition, reference to an action being "based on" a condition may refer to the action being "in response to" the condition. For example, the phrases "based on" and "in response to" may, in some non-limiting embodiments or aspects, refer to a condition for automatically triggering an action (e.g., a specific operation of an electronic device, such as a computing device, a processor, and/or the like).

In this disclosure, the terms "electrical power system", "electrical system", "power supply" and "power supply system" may be used interchangeably. It shall be appreciated that the present teachings can be applied in such suitable systems without limitation of scope and generality of the present teachings.

Non-limiting embodiments or aspects of the disclosed subject matter are directed to an electrical system, such as a power supply system, e.g., with a coupled choke and selectable output voltage. For example, non-limiting embodiments or aspects of the disclosed subject matter provide a first set of energy storage modules, a second set of energy storage modules, a choke connected to the first set of energy storage modules and the second set of energy storage modules, and a switch configured to switch between a first state and a second state. Upon switching the switch to the first state, the first set of energy storage modules may be connected in parallel with the second set of energy storage modules to provide a first voltage to at least one output. Upon switching the switch to the second state, the first set of energy storage modules may be connected in series with the second set of energy storage modules to provide a second voltage to the at least one output. As such, the disclosed subject matter allows for providing power at any location (e.g., even if mains electric power is not readily available or accessible). Even when mains electric power is available, the disclosed subject matter may allow for providing to prevent interruptions in power (e.g., used as an uninterruptable power supply (UPS)) and/or to condition power (e.g., as the output power is controllable/selectable, devices connected to a power supply system according to the disclosed subject matter may receive well-conditioned power that is free from voltage spikes, current surges, interruptions or reductions in power, and/or the like, which may occur from time to time with mains electric power). Additionally, the voltage (e.g., AC voltage) of the supplied power may be selectable (e.g., by the user). As such, a user may use electrical devices rated for different mains electric power with the same electrical system (e.g., power supply system). Additionally or alternatively, even if the output voltage is set to a certain mains power in production it can make the production line scalable and more economical for manufacture of systems suitable for multiple mains power domains (e.g., areas with different mains electric power). Additionally, effective output power of the electrical system (e.g., power supply system) maybe maintained irrespective of the mains electric power voltage. For example, the voltage may be twice as high when the sets of energy storage modules are in series compared to when they are in parallel (e.g., because voltage capacity is twice as high in series, especially when a buck-type inverter is used, which steps down the energy storage module/battery voltage), and the current may be half as much when the sets of energy storage modules are in series compared to when they are in parallel (e.g., because current handling capacity is twice as high in parallel), thereby maintaining the same nominal output power at two different nominal output voltage levels. For example, the first voltage may within a first range of 100-127 V (e.g., at a suitable frequency, such as 60 Hz suitable for the United States of America, North America, etc.), and the second voltage may be within a second range of 200-240 V (e.g., at a suitable frequency, such as a frequency of 50 Hz suitable for the European Union, etc.). Accordingly, different electrical devices designed to be connected to (e.g., plugged into) mains electric power in different regions can be suitably connected to and powered by the disclosed power supply system. It shall be appreciated that the ranges, frequencies, and/or types of mains electric power mentioned in the examples above are non-limiting to the teachings of the present disclosure. Accordingly, other standard or non-standard output voltages may be implemented when benefiting from the teachings of the present disclosure.

Furthermore, upon configuring the switch to the first state to connect the first set of energy storage modules in parallel with the second set of energy storage modules, the choke may be configured such that there is reduced (e.g., little or no) inductive impedance to load currents through the first and second sets of energy storage modules, and thus no, or significantly reduced, impedance to the combined load current (e.g., the total load current). For example, the choke may include bifilar windings (e.g., a first winding and a second winding in a bifilar arrangement) around a toroidal core. A first magnetic flux of the first winding caused by a first load current through the first set of energy storage modules may combine subtractively with a second magnetic flux of the second winding caused by a second load current through the second set of energy storage modules. It shall be appreciated that the total load current in this case may be a combination (e.g., sum) of the first load current and the second load current. For example, it shall be appreciated that the choke having equal impedance on both windings may offer reduced or negligible impedance to load current, which may be evenly shared between the two sets. This may be due to the magnetic flux caused by the evenly shared load currents in the sets canceling out (e.g., combining subtractively). For example, in situations where the load current is not evenly shared between the sets, a portion of the magnetic flux may remain uncanceled. It shall be appreciated that the uncanceled portion of the magnetic flux may be dependent on the difference between the load current between the two sets. Hence, this difference in load current will experience impedance from the choke.

Thus, the coupled choke may impede a loop (e.g., circular) current which may sometimes tend to flow between the first and second sets of energy storage modules. Such a loop current may arise, e.g., from a mismatch between the first and second sets of energy storage modules. The mismatch may even arise, for example, from a scenario when exactly the same voltage is not being generated in the two sets, thus such voltage mismatch may lead also to a load current mismatch between the sets. For example, due to a mismatch between the energy storage modules (e.g., state of charge) of the two sets, a loop current may tend to flow between the first set and the second set, and the direction of the flow of the loop current may depend upon the relative mismatch between the first and second sets. In other words, it may happen that one of the two sets of energy storage modules is generating slightly higher voltage than the other and/or slightly higher current than the other. In such cases, a loop current (e.g., proportional to this voltage difference and/or current different) may tend to flow from the set producing a higher voltage and/or current towards the other set producing a lower voltage and/or current. The choke may impede such loop current by reacting to the difference in current (e.g., caused by a difference of voltages) between the first set and the second set and/or may allow for introducing pulse-width modulation (PWM), which may allow for cancelling the voltage difference. Thus, the disclosed subject matter can allow the combined load current to flow essentially inductively unimpeded through the coupled choke, while the loop current is inductively impeded. Such loop currents can be undesirable in parallel-connected energy storage modules, so the disclosed subject matter may prevent mismatches or imbalance between the two sets from affecting (e.g., damaging, disrupting, and/or the like) components of the energy storage modules of the power supply unit. This can, for example, reduce tolerance requirements for the components of the power supply unit, especially those components which are susceptible to the loop current. It shall be appreciated that the choke (e.g., when connected as described herein) can experience a loop current which is proportional to the difference of voltages between the first set and the second set. This voltage difference may be DC and/or low-frequency (e.g., caused due to differences in battery voltages between the sets, measurement error or offsets, etc.) and/or may be high-frequency (e.g., kilo-Hertz (kHz) range or above), for example, caused by switched operation of the modules/inverter. It shall be appreciated that the choke can substantially reduce or cancel the loop current corresponding to the high-frequency voltage difference, whilst allowing the balanced load currents to flow essentially unimpeded. For example, by switching one or more of the energy storage modules at high frequency (e.g., in kHz range or above) the voltage imbalance between the sets may be shifted to higher frequencies, thus more effectively being blocked by the choke. This has an effect of normalizing and/or canceling the imbalance (e.g., load current imbalance) between the sets. In certain embodiments (e.g., inverter circuits and/or the like), at least one energy storage module may be operating at high frequency (e.g., generating a PWM output), so this shift of the voltage imbalance to higher frequency can be established without requiring extra circuitry. Thus, in some embodiments, high-frequency (e.g., PWM) switching of at least one of the energy storage modules can allow equalizing voltage differences between the sets on a time averaged manner. In some embodiments, the choke allows leveraging a switching operation (e.g., PWM) in such a manner that even a slight low-frequency (e.g., DC) voltage difference is level-shifted (e.g., converted to a larger voltage difference) at higher frequency (e.g., several orders more than the low-frequency, e.g., kHz range or higher) for a part of the switching operation. The level-shifted voltage difference however gets substantially canceled out over a cycle of the switching operation (e.g., a PWM period). It shall be appreciated that this level-shifted voltage difference gets more effectively impeded by the choke. As a non-limiting example of a switching operation, assuming that one of the sets comprising a single energy storage module is producing 20 V output, while the other set comprising a single energy storage module is producing 22 V output. Without the choke, when these sets are connected in parallel, a loop current proportional to a 2 V difference may flow as a loop current between the sets. Now assuming that the set producing 20V is being operated with a PWM with 50% duty-cycle, while the other set producing 22V is operated with a PWM with 45.45% duty-cycle, will cause both sets to produce 10 V averaged over one PWM cycle. The choke prevents any excessive current from flowing between the sets which are operating in accordance with the waveform of the switching operation. It shall be appreciated that the example does not limit the number of energy storage modules in any set or the frequencies or duty cycles or type of any suitable switching operation.

In some cases, a DC or low-frequency voltage difference may be deliberately tolerated or imposed, which can be used e.g., for measurements, calibration or balancing energy storage elements between the two sets.

In addition, non-limiting embodiments or aspects of the disclosed subject matter can provide energy storage modules having an energy storage component (e.g., at least one rechargeable battery cell, supercapacitor, and/or the like), a first electrical connection, a second electrical connection, and a plurality of switching elements. The switching elements may be configured to selectively connect the energy storage component to the first electrical connection and the second electrical connection to control a module voltage across the first electrical connection and the second electrical connection of the battery module. Each energy storage module may include a module controller, and the power supply system may include a system controller and at least one communication connection, thereby connecting each module controller to the system controller. The system controller may control the module controllers to operate the switching elements of each respective energy storage module to generate an output voltage based on a combination of the respective module voltage of each respective energy storage module. The system controller may define a respective duty cycle which a respective module voltage should have at a given time. The module controller may operate the switching elements associated with its energy storage module accordingly. Thus, the output voltage of an energy storage module may be a switched output such as a pulse-width modulated (PWM) output which is specified by the system controller. In some cases, a module controller may at least partially define a respective duty cycle which a respective module voltage should have at a given time. In other words, it may be contemplated that the module controller acts autonomously from the system controller for performing at least some of the functions such as defining a duty cycle for its output voltage. As such, voltage from the individual energy storage modules (e.g., DC voltage) may be converted to suitable output voltages (e.g., AC voltages suitable for electrical devices designed to be connected to mains electric power in different regions).

With reference to the above, it shall be appreciated that the teachings of the disclosed subject matter add additional advantages when high-frequency signals/components (such as those caused by switching of module outputs, e.g., in a PWM manner) are present in the branches (e.g., sets of energy storage modules) in which the proposed coupled choke is disposed (e.g., by allowing for equalizing different voltages on a time-averaged basis). For example, the energy storage modules may be operating at high frequency (e.g., at or above kHz range). An example of such high-frequency operation may include when output of the energy storage modules have a switched output such as a PWM type output. In such cases, currents caused by such high-frequency switching may tend to flow, e.g., from the first set to the second set, or vice-versa, when the sets are configured to operate parallelly. When parallelly operating, the high-frequency switched output voltages between the sets may encounter at times voltage differences with respect to each another which may cause these high-frequency voltage transients to appear between the sets. It shall be appreciated that the coupled choke as proposed is selectively sensitive to impeding currents caused by such voltage differences as the magnetic flux causes by these components does not get subtractively canceled in the choke. Moreover, the choke has high impedance for high-frequency components. Accordingly, the choke acts as a selective filter for significantly reducing or eliminating such high-frequency loop currents.

Moreover, non-limiting embodiments or aspects of the disclosed subject matter provide that, upon configuring the switch to the first state to connect the first set of energy storage modules in parallel with the second set of energy storage modules, the system controller may operate or control the module controllers to cause one or more first module voltages of the first set of energy storage modules to be interleaved with one or more second module voltages of the second set of energy storage modules. As such, the effective level of the voltage jumps at the output may be reduced (e.g., halved) by the choke, which may act as an inductive voltage divider. In this way, components of a filter (e.g., LC filter) at the output may be smaller (e.g., reduced inductance (L) and/or capacitance (C)) while maintaining a suitable filter effect.

Furthermore, non-limiting embodiments or aspects of the disclosed subject matter provide that, upon switching the switch to the second state to connect the first set of energy storage modules in series with the second set of energy storage modules, the system controller may control the module controllers to cause one or more first module voltages of the first set of energy storage modules to be inverted with respect to one or more second module voltages of the second set of energy storage modules. As such, voltages from the first set of energy storage modules and the second set of energy storage modules may combine additively (e.g., instead of subtractively such that they would cancel each other out). Moreover, in this mode of operation, the inductance of the choke may be utilized in conjunction with a capacitor to act as a filter (e.g., LC filter) at the output (e.g., without the need for another separate inductor).

Additionally, non-limiting embodiments or aspects of the disclosed subject matter provide an electrical system, such as a power circuit (e.g., power supply system) with selectable output voltage and voltage sensing, methods of monitoring voltages of such power supply systems, and computer program products for monitoring voltages of such power supply systems. For example, non-limiting embodiments or aspects of the disclosed subject matter provide a power circuit comprising a first set of voltage sources (e.g., energy storage modules) and a second set of voltage sources (e.g., energy storage modules). The first set of voltage sources and the second set of voltage sources may be connected via an inductor (e.g., a choke). In a mode of operation (e.g., one of a plurality of modes of operation), the inductor may be disposed in a series connection between the first set of voltage sources and the second set of voltage sources. A first differential amplifier may measure a first voltage across the first set of voltage sources to generate a first signal. A second differential amplifier may measure a second voltage across the second set of voltage sources to generate a second signal. A total voltage signal may be evaluated based on the first signal and the second signal. An output voltage of the power circuit may be calculated from the total voltage signal. As such, voltage can be measured across each set of voltage sources, rather than being measured at the output of the power circuit. In this way, voltage can be measured before any filtering components (e.g., LC filters, etc.). Additionally, since the voltage is measured across each set of voltage sources, it can be assured that the measured voltage is as accurate as possible (e.g., for using the measured voltage to control the voltage sources, such as PWM control and/or the like). Moreover, even if the inductor (e.g., choke) is separated from (e.g., not directly connected to) a capacitor (e.g., of an LC filter), for example, because the inductor is coupled between the sets of voltage sources, measuring the voltages in this manner ensures that the measured voltages are before any part of the filter (e.g., LC filter). Also, non-limiting embodiments or aspects of the disclosed subject matter provide inputting a reference voltage (e.g., fixed reference voltage, such as half of a reference voltage of an analog-to-digital converter) (ADC) to at least one of the differential amplifiers to provide a DC offset and/or to allow the signal(s) output by the amplifier(s) to be directly sampled (e.g., by an ADC). Furthermore, non-limiting embodiments or aspects of the disclosed subject matter provide using the output of one of the differential amplifiers (e.g., the second differential amplifier) as a reference voltage (e.g., input) to the other differential amplifier (e.g., the first differential amplifier), thereby allowing the output signals of the two differential amplifiers to be combined (e.g., summed), for example, without the need for extra circuit components (e.g., an extra ADC channel, an additional amplifier to sum the signals, and/or the like). In addition, by inputting the fixed reference voltage was provided to the second differential amplifier, the resulting output of the first differential amplifier (e.g., when the output of the second differential amplifier is provided as the reference voltage to the first differential amplifier) may be centered around the fixed reference voltage, thereby providing a DC offset and/or allowing the signal(s) output by the amplifier(s) to be directly sampled (e.g., by an ADC). Additionally, non-limiting embodiments or aspects of the disclosed subject matter provide using one or more of the differential amplifiers as filters and/or as part of filtering (e.g., first-order, second-order, third-order, filtering). For example, this filtering may be useful for sampling the signal(s) via the ADC (e.g., the signal(s) may need to be filtered before sampling via the ADC).

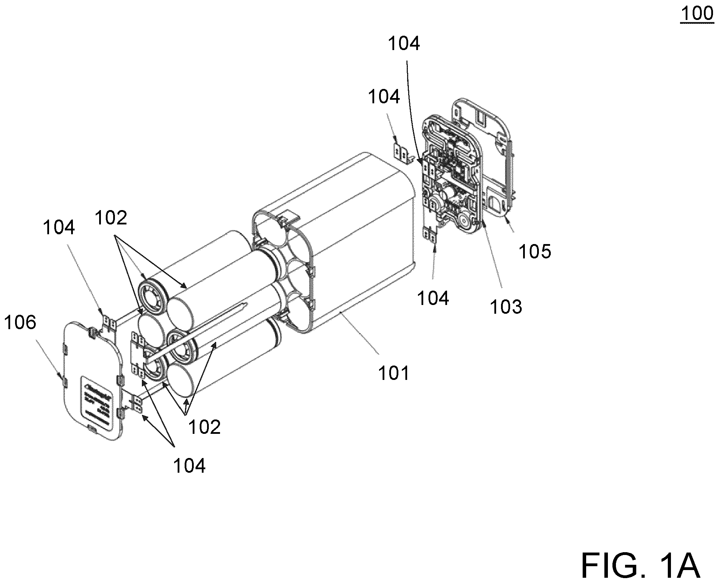

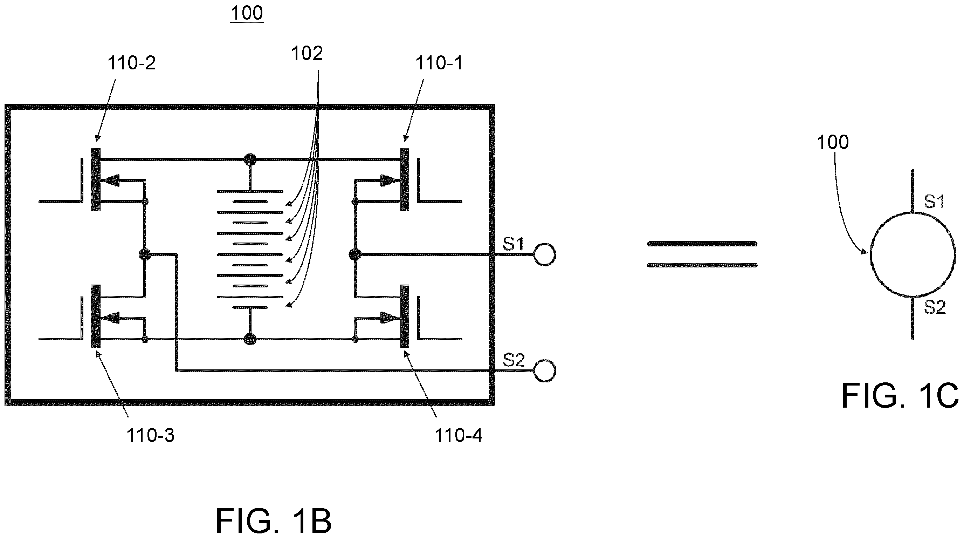

Referring now to FIG. 1A, depicted is a schematic diagram of an example energy storage module 100, according to some non-limiting embodiments or aspects. As shown in FIG. 1, energy storage module 100 may include housing 101, at least one energy storage component 102, module controller 103, connectors 104, top cover 105, and bottom cover 106. The number and arrangement of components shown are provided as an example. In some non-limiting embodiments or aspects, energy storage module 100 may include additional components, fewer components, different components, or differently arranged components than those shown. Additionally or alternatively, a set of components (e.g., one or more components) of energy storage module 100 may perform one or more functions described as being performed by another set of components of energy storage module 100.

In some non-limiting embodiments or aspects, housing 101 may include plastic, metal, any combination thereof, and/or the like. For example, housing 101 may include a plastic housing.

In some non-limiting embodiments or aspects, housing 101 may be configured to hold at least one (e.g., a plurality of) energy storage components 102. For example, as shown in FIG. 1, housing 101 may be shaped to have six energy storage components 102 uniformly distributed in an interior space defined by housing 101.

In some non-limiting embodiments or aspects, each energy storage component 102 may include at least one of a battery, a rechargeable battery (e.g., a lithium-ion battery), a cell (e.g., battery cell, an electrochemical cell, and/or the like), a rechargeable cell, a capacitor, an ultra-capacitor, any combination thereof, and/or the like. For example, as shown in FIG. 1, each energy storage component 102 may include a cylindrical cell (e.g., lithium-ion battery cell).

In some non-limiting embodiments or aspects, module controller 103 may include a controller and associated circuitry. Optionally, module controller 103 may include a microcontroller, a computing device, a processor, a microprocessor, a digital signal processor (DSP), and/or any processing component (e.g., a field-programmable gate array (FPGA), an application-specific integrated circuit (ASIC), etc.) that can be configured to perform at least one function.

In some non-limiting embodiments or aspects, connectors 104 may connect the terminals (e.g., ends) of each energy storage component 102 to module controller 103. Additionally or alternatively, at least one connector 104 may connect at least one terminal (e.g., end) of one energy storage component 102 to another terminal of another energy storage component 102. For example, connectors 104 may include a conductive (e.g., electrically conductive) material, such as metal and/or the like. In some non-limiting embodiments or aspects, some or all of the connectors 104 may be used for energy storage component 102 (e.g., cell) voltage measurements.

In some non-limiting embodiments or aspects, each of top cover 105 and bottom cover 106 may include plastic, metal, any combination thereof, and/or the like. For example, each of top cover 105 and bottom cover 106 may include a plastic cover. In some non-limiting embodiments or aspects, top cover 105 and bottom cover 106 may be configured to (e.g., sized and shaped to) cover openings at top and bottom ends, respectively, of housing 101. In some non-limiting embodiments or aspects, top cover 105 may include a first electrical connection (e.g., S1, as described herein), a second electrical connection (e.g., S2, as described herein), and/or at least one communication connection, as described herein. For example, these connections may allow for electrical and/or communicative connection between module controller 103 and external components (e.g., other components of the power supply system external to the energy storage module housing).

In some non-limiting embodiments or aspects, energy storage module 100 may include a battery module. For example, the battery module may include at least one cell (e.g., a battery cell, such as a rechargeable battery cell). For the purpose of illustration, as shown in FIG. 1A, the battery module may include six cells (e.g., rechargeable battery cells, such as lithium-ion cells, supercapacitors, and/or the like).

In some non-limiting embodiments or aspects, energy storage components 102 (e.g., battery cells) of battery storage module 100 may be connected in series. In some non-limiting embodiments or aspects, energy storage components 102 (e.g., battery cells) of battery storage module 100 may be connected in parallel.

In some non-limiting embodiments or aspects, at least some (e.g., a subset of) energy storage components 102 may be connected in series, for example, so that the combined (e.g., summed and/or the like) voltage of the series-connected components satisfies (e.g., equals, exceeds, and/or the like) the target (e.g., desired) operating voltage of energy storage module 100. In some non-limiting embodiments or aspects, at least some (e.g., a subset of) energy storage components 102 may be connected in parallel, for example, so that the combined (e.g., summed and/or the like) capacity (e.g., current) of the parallel-connected components satisfies (e.g., equals, exceeds, and/or the like) the target (e.g., desired) a target capacity (e.g., operating current of energy storage module 100). For example, energy storage module 100 may include a plurality of subsets of energy storage components 102 such that energy storage components 102 of each subset are connected in series (e.g., to combine to output the desired module voltage), and the subsets may be connected in parallel (e.g., to combine to output the desired module current).

In some non-limiting embodiments or aspects, energy storage module 100 may be the same as or similar to or include at least some components that are the same as or similar to the battery modules described in at least one of U.S. Patent Application Pub. No. 2022/0037891, U.S. Patent Application Pub. No. 2022/0247030, U.S. Patent Application Pub. No. 2022/0359918, and/or U.S. Patent Application Pub. No. 2022/0360094, the disclosures of each of which are hereby incorporated by reference in their entireties.

In some non-limiting embodiments or aspects, energy storage module 100 may include an inverter circuit, as described herein. For example, the inverter circuit may include an H-bridge inverter circuit.

In some non-limiting embodiments or aspects, an output of energy storage module 100 may include a PWM waveform, as described herein.

Referring now to FIGS. 1B and 1C, shown are circuit diagrams of an example energy storage module 100, according to some non-limiting embodiments or aspects. In some non-limiting embodiments or aspects, as shown in FIGS. 1B and 1C, energy storage module 100 may include energy storage components 102, at least one switching element (e.g., first switching element 110-1, second switching element 110-2, third switching element 110-3, and/or fourth switching element 110-4, collectively referred to as "switching elements 110," and individually referred to as "switching element 110"), first electrical connection S1, and second electrical connection S2. In some non-limiting embodiments or aspects, switching elements 110 may be part of (e.g., integrated on, connected to, and/or the like) module controller 103. In some non-limiting embodiments or aspects, first electrical connection S1 and/or second electrical connection S2 may be part of (e.g., integrated on, connected to, and/or the like) module controller 103 and/or may extend through top cover 105. The number and arrangement of components shown are provided as an example. In some non-limiting embodiments or aspects, energy storage module 100 may include additional components, fewer components, different components, or differently arranged components than those shown. Additionally or alternatively, a set of components (e.g., one or more components) of energy storage module 100 may perform one or more functions described as being performed by another set of components of energy storage module 100.

As shown in the example in FIG. 1B, energy storage module 100 may include six energy storage components 102 (e.g., rechargeable battery cells and/or the like) connected in series. In some non-limiting embodiments or aspects, energy storage components 102 may be in other arrangements and/or have other connections, as described herein.

In some non-limiting embodiments or aspects, switching elements 110 may be switched (e.g., opened, closed, activated, deactivated, and/or the like) to selectively connect energy storage component(s) 102 to first electrical connection S1 and/or second electrical connection S2, e.g., to control a module voltage across first electrical connection S1 and second electrical connection S2. For example, switching elements 110 may be switched so that (1) first electrical connection S1 and second electrical connection S2 are both connected to negative side (e.g., DC minus) of energy storage component(s) 102, (2) first electrical connection S1 is connected to the negative side (e.g., DC minus) of energy storage component(s) 102 and second electrical connection S2 is connected to the positive side (e.g., DC plus) of energy storage component(s) 102, or (3) first electrical connection S1 is connected to the positive side (e.g., DC plus) of energy storage component(s) 102 and second electrical connection S2 is connected to the negative side (e.g., DC minus) of energy storage component(s) 102. As such, the voltage across first electrical connection S1 and second electrical connection S2 may be zero, negative, or positive, respectively.

For the purpose of illustration by way for a few examples, to connect both first electrical connection S1 and second electrical connection S2 to the negative side (e.g., DC minus) of energy storage component(s) 102, fourth switching element 110-4 and third switching element may both be activated (e.g., closed, set to act as a closed switch, and/or the like), while second switching element 110-2 and first switching element 110-1 are deactivated (e.g., open, set to act as an open switch, and/or the like). To connect first electrical connection S1 to the negative side (e.g., DC minus) and connect second electrical connection S2 to the positive side (e.g., DC plus) of energy storage component(s) 102, fourth switching element 110-4 and second switching element 110-2 may be activated, while third switching element 110-3 and first switching element 110-1 are deactivated. To connect first electrical connection S1 to the positive side (e.g., DC plus) and second electrical connection S2 to the negative side (e.g., DC minus) of energy storage component(s) 102, first switching element 110-1 and third switching element 110-3 may be activated, and fourth switching element 110-4 and second switching element 110-2 may be deactivated. In some non-limiting embodiments or aspects, the switching elements 110 may be operated to be in states such as: a high-impedance (Hi-Z) state (e.g., in which all of the switching elements 110 are deactivated), a bypass state (e.g., in which the low-side switching elements 110-3 and 110-4 are activated while the high-side switching elements 110-1 and 110-2 are deactivated), and two polarity states (e.g., in which the energy storage component(s) 102 are connected between the first electrical connection S1 and the second electrical connection S2 in opposite polarity manner).

In some non-limiting embodiments or aspects, each switching element 110 may include at least one of a transistor (e.g., bipolar transistor, field-effect transistor (FET), metal-oxide-semiconductor field-effect transistor (MOSFET), and/or the like), a switch, a contactor, any combination thereof, and/or the like. In some non-limiting embodiments or aspects, the energy storage module 100 may include one or more driver circuits, such as a gate driver circuit, for driving each switching element 110. For example, the driver circuits may be part of (e.g., integrated on, connected to, and/or the like) module controller 103.

In some non-limiting embodiments or aspects, each switching element 110 may be driven, or controlled, via the module controller 103. For example, module controller 103 may control the switching elements 110 to selectively connect energy storage component(s) 102 to first electrical connection S1 and/or second electrical connection S2, as described herein. For example, module controller 103 may be connected to each switching element 110 in order to drive, or optionally control, such switching element 110. In some non-limiting embodiments or aspects, the module controller 103 provides signals to the gate driver circuit for driving the switching elements 110.

As shown in FIG. 1C, each energy storage module 100 may be represented by the symbol shown in FIG. 1C (e.g., for brevity and clarity of the following drawings).

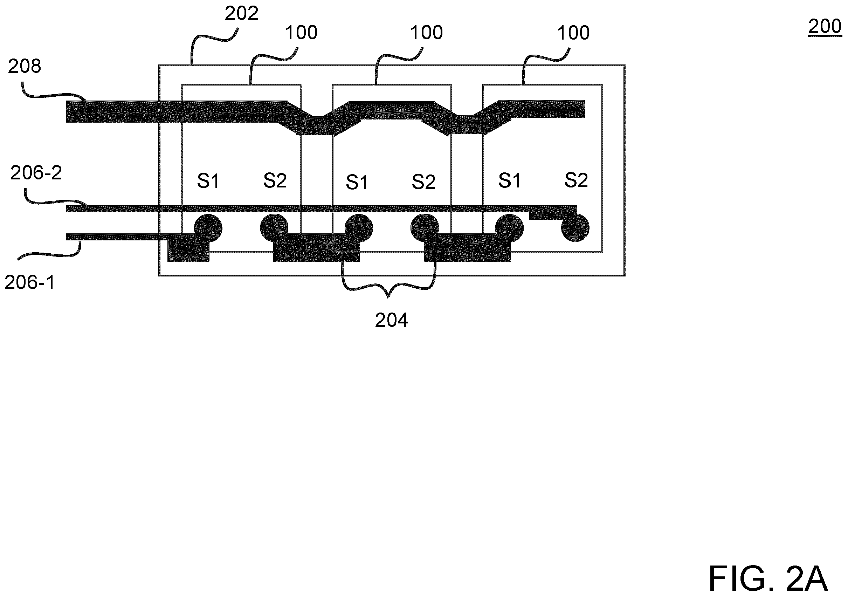

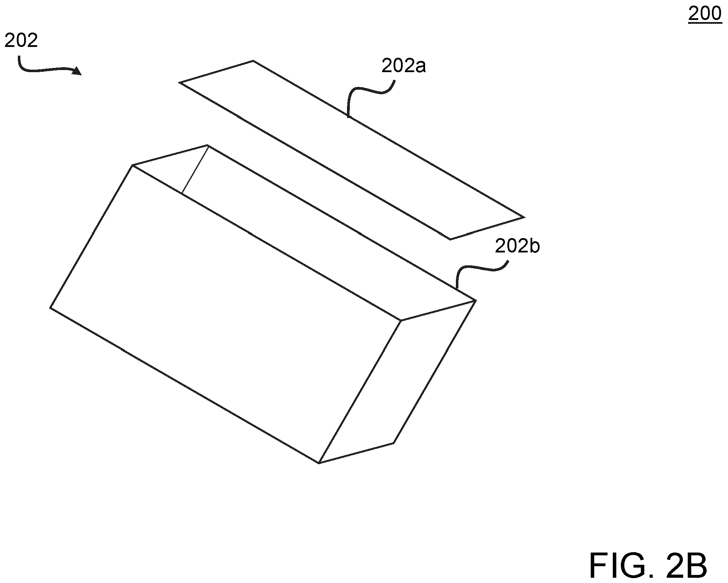

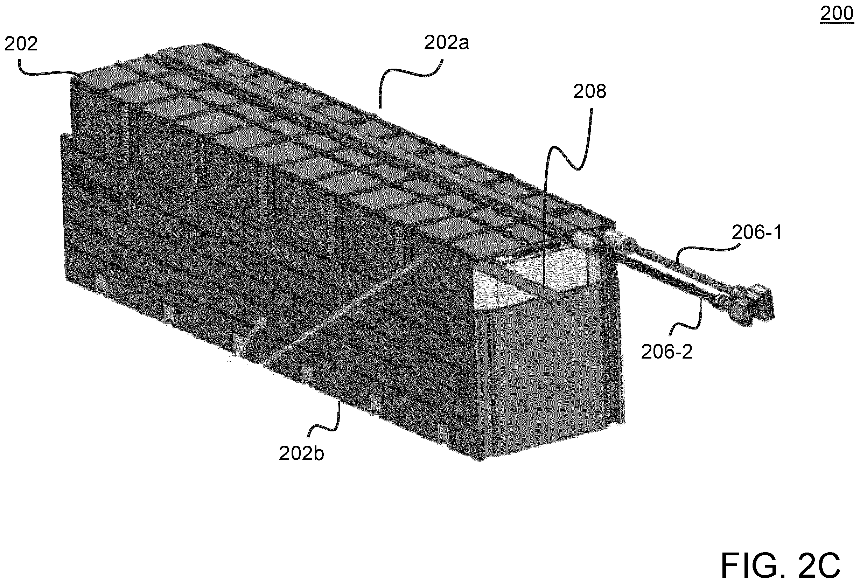

Referring now to FIGS. 2A-2C, shown are schematic diagrams of an example energy storage module container 200 of energy storage modules, according to some non-limiting embodiments or aspects. As shown in FIGS. 2A-2C, energy storage module container 200 may include at least one energy storage module 100 (e.g., a plurality or energy storage modules 100, a set of energy storage modules 100, and/or the like of), housing 202 (e.g., including top cover 202a and holder 202b), bar connections 204, first electrical connection 206-1 and second electrical connection 206-2 (collectively referred to as "electrical connections 206" and individually referred to as "electrical connection 206"), and/or communication connection 208. The number and arrangement of components shown are provided as an example. In some non-limiting embodiments or aspects, energy storage module container 200 may include additional components, fewer components, different components, or differently arranged components than those shown. Additionally or alternatively, a set of components (e.g., one or more components) of energy storage module container 200 may perform one or more functions described as being performed by another set of components of energy storage module container 200.

In some non-limiting embodiments or aspects, housing 202 may include plastic, metal, any combination thereof, and/or the like. For example, housing 202 may include a plastic housing.

In some non-limiting embodiments or aspects, housing 202 may be configured to hold at least one (e.g., a plurality of, a set of, and/or the like) energy storage modules 100. For example, as shown in FIG. 2A, housing 202 may be shaped to have three energy storage modules 100 uniformly distributed in an interior space defined by housing 202. In some non-limiting embodiments or aspects, there may be any number of energy storage modules 100, as described herein. For example, housing 202 may contain six energy storage modules 100, nine energy storage modules 100, twelve energy storage modules 100, and/or the like.

In some non-limiting embodiments or aspects, bar connections 204 may connect energy storage modules 100 within housing 202. For example, as shown in FIG. 2A, a first (e.g., left) bar connection 204 may connect second electrical connection S2 of a first (e.g., left) energy storage module 100 to first electrical connection S1 of a second (e.g., center) energy storage module 100, and a second (e.g., right) bar connection 204 may connect second electrical connection S2 of the second (e.g., center) energy storage module 100 to first electrical connection S1 of a third (e.g., right) energy storage module 100. As such, these energy storage modules 100 may be connected in series. In some non-limiting embodiments or aspects, energy storage modules 100 and/or bar connections 204 may be in other arrangements and/or have other connections (e.g., to connect energy storage modules 100 in series, in parallel, a combination of series and parallel connections, and/or the like, as described herein). In some non-limiting embodiments or aspects, bar connections 204 may include a conductive (e.g., electrically conductive) material, such as metal and/or the like.

In some non-limiting embodiments or aspects, electrical connections 206 may include a conductive (e.g., electrically conductive) material, such as metal and/or the like. For example, electrical connections 206 may include a wire, a cable, and/or the like. In some non-limiting embodiments or aspects, electrical connections 206 may allow for electrical connection between energy storage module container 200 (e.g., energy storage modules 100 within energy storage module container 200) and external components (e.g., other components of the power supply system external to housing 202).

In some non-limiting embodiments or aspects, first electrical connection 206-1 may be connected to first electrical connection S1 of at least one energy storage module 100. For example, first electrical connection 206-1 may be connected to first electrical connection S1 of a first (e.g., left) energy storage module 100 (e.g., of a group of energy storage modules 100 connected in series). In some non-limiting embodiments or aspects, second electrical connection 206-2 may be connected to second electrical connection S2 of at least one energy storage module 100. For example, second electrical connection 206-2 may be connected to second electrical connection S2 of a last (e.g., right) energy storage module 100 (e.g., of a group of energy storage modules 100 connected in series).

In some non-limiting embodiments or aspects, communication connection 208 may include at least one component that permits communication among other components. For example, communication connection 208 may include a bus connection (e.g., digital bus, such as controller area network bus (CAN-bus), isolated serial port Interface (isoSPI), any derivatives thereof, any combination thereof, and/or the like). In some non-limiting embodiments or aspects, communication connections 208 may allow for communicative connection between container energy storage modules 100 within energy storage module container 200 (e.g., module controllers 103 of such energy storage modules 103) and external components (e.g., other components of the power supply system external to housing 202, such as a system controller and/or the like). The system controller may provide a signal (e.g., command) via communication connection 208 to any of module controllers 103 for operating the switching elements 110 thereof (e.g., via one or more gate driver circuits) in a particular (e.g., controlled) manner.

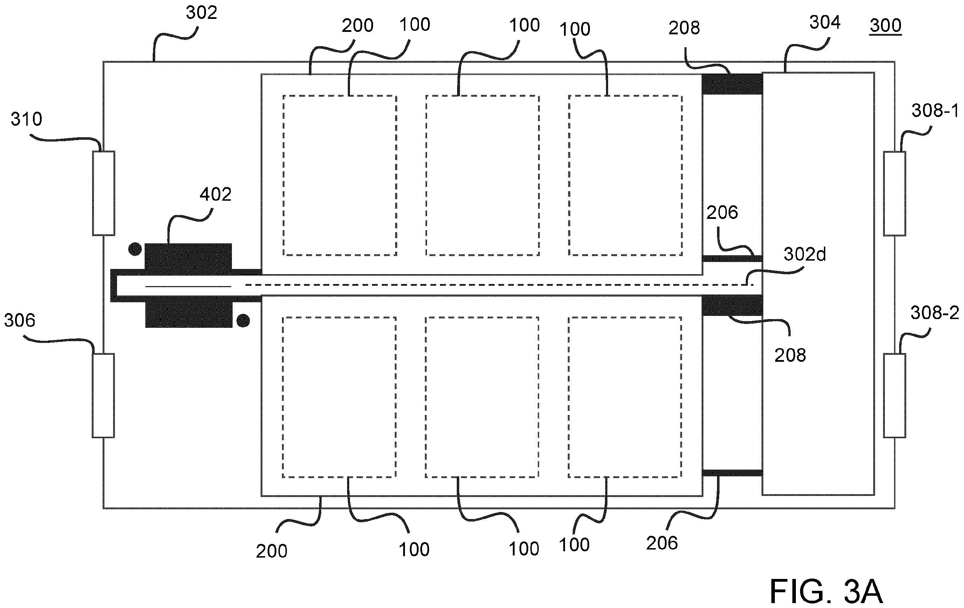

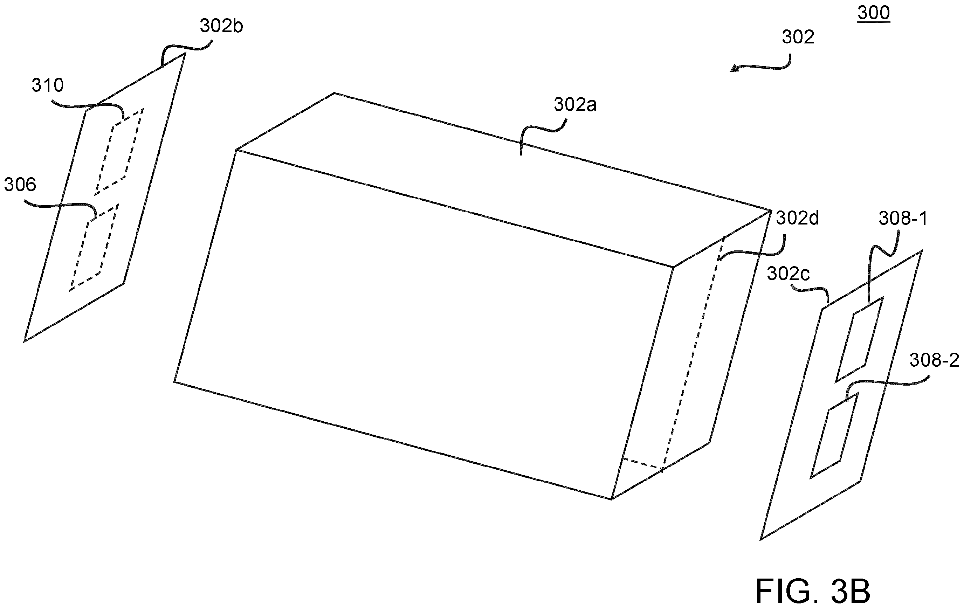

Referring now to FIGS. 3A and 3B, shown are schematic diagrams of an example electrical power system, shown here as a power supply system 300, according to some non-limiting embodiments or aspects. As shown in FIGS. 3A and 3B, power supply system 300 may include at least one energy storage module container 200 (e.g., each including at least one energy storage module 100), electrical connections 206, communication connections 208, housing 302, system controller 304, input connection 306, at least one output connection (e.g., first output connection 308-1 and/or second output connection 308-2, collectively referred to as "output connections 308," and individually referred to as "output connection 308"), and/or choke 402. In some non-limiting embodiments or aspects, power supply system 300 may also include communication connection 310. For brevity and clarity, electrical connections 206 and communication connections 208 inside energy storage module container 200 are not shown in FIG. 3A, but energy storage module(s) 100 may be connected to electrical connections 206 and/or communication connections 208, as described herein. For brevity and clarity, connections between energy storage module container 200 (and/or energy storage module(s) 100 thereof) and input connection 306, output connection(s) 308, and/or communication connection 310 are not shown in FIG. 3A, but energy storage module container 200 (and/or energy storage module(s) 100 thereof) may be connected to input connection 306, output connection(s) 308, and/or communication connection 310, as described herein. For brevity and clarity, connections between system controller 304 and input connection 306, output connection(s) 308, and/or communication connection 310 are not shown in FIG. 3A, but system controller 304 may be connected to input connection 306, output connection(s) 308, and/or communication connection 310, as described herein. The number and arrangement of components shown are provided as an example. In some non-limiting embodiments or aspects, power supply system 300 may include additional components, fewer components, different components, or differently arranged components than those shown. Additionally or alternatively, a set of components (e.g., one or more components) of power supply system 300 may perform one or more functions described as being performed by another set of components of power supply system 300. For example, in some non-limiting embodiments or aspects, choke 402 may be included in and/or a part of system controller 304.

In some non-limiting embodiments or aspects, housing 302 may include plastic, metal, any combination thereof, and/or the like. For example, housing 302 may include a metal housing, such as an aluminum housing.

In some non-limiting embodiments or aspects, housing 302 may be configured to hold at least one (e.g., a plurality of) energy storage container(s) 200 and/or at least one (e.g., a plurality of) energy storage modules(s) 100. For example, housing 302 may be configured to hold two energy storage containers 200, three energy storage containers 200, four energy storage containers 200, and/or the like. For the purpose of illustration, housing 302 may be configured to hold two energy storage containers 200, each of which may hold twelve energy storage modules(s) 100 (e.g., a total of 24 energy storage modules(s) 100). For the purpose of illustration, housing 302 may be configured to hold three energy storage containers 200, each of which may hold eight energy storage modules(s) 100 (e.g., a total of 24 energy storage modules(s) 100). In some non-limiting embodiments or aspects, other configurations are also possible, e.g., housing 302 may hold four energy storage containers 200, each of which may hold six energy storage modules(s) 100 (e.g., a total of 24 energy storage module(s) 100). For the purpose of illustration, housing 302 may be configured to hold two energy storage containers 200, each of which may hold three energy storage modules(s) 100 (e.g., a total of 6 energy storage modules(s) 100). In some non-limiting embodiments or aspects, energy storage container(s) 200 and/or energy storage module(s) 100 may be in other arrangements within housing 302.

In some non-limiting embodiments or aspects, housing 302 may include a plurality of compartments separated by dividers 302d (e.g., walls, barriers, and/or the like). For example, the number of compartments may be equal to the number of energy storage container(s) 200 (e.g., a respective compartment for each respective energy storage container 200). Each compartment may be separated from the adjacent compartment(s) by a divider 302d. For example, one divider 302d may separate an interior space of housing 302 into two compartments, two dividers 302d may separate an interior space of housing 302 into three compartments, and so on. In some non-limiting embodiments or aspects, divider 302d may be part of housing 302 and/or may include the same material as housing 302 (e.g., aluminum, metal, plastic, and/or the like).

In some non-limiting embodiments or aspects, as shown in FIG. 3B, housing 302 may include body 302a, first end cap 302b, second end cap 302c, and/or at least one divider 302d. In some non-limiting embodiments or aspects, body 302a and/or divider 302d may include a first material (e.g., metal, such as aluminum), and first end cap 302b and/or second end cap 302c may include a second material (e.g., plastic). In some non-limiting embodiments or aspects, at least one of first end cap 302b and/or second end cap 302c may include the same material as body 302a and/or divider 302d. In some non-limiting embodiments or aspects, first end cap 302b and second end cap 302c may be configured to (e.g., sized and shaped to) cover openings at respective ends of body 302a.

In some non-limiting embodiments or aspects, first end cap 302b and/or second end cap 302c may include (and/or may have a space to accommodate) input connection 306, output connection(s) 308, and/or communication connection 310. For the purpose of illustration, as shown in FIG. 3B, input connection 306 and communication connection 310 may be located at first end cap 302b, and output connections 308 may be located at second end cap 302c. In some non-limiting embodiments or aspects, input connection 306, output connection(s) 308, and/or communication connection 310 may be in other arrangements. For example, all of input connection 306, output connection(s) 308, and communication connection 310 may be located at the same end cap (e.g., one of first end cap 302b or second end cap 302c). As another example, input connection 306 may be located at one end cap, and communication connection 310 and output connection(s) 308 may be located at the other end cap. As another example, input connection 306 and output connection(s) 308 may be located at one end cap, and communication connection 310 may be located at the other end cap. As another example, first output connection 308-1 may be located at one end cap, and second output connection 308-2 may be located at the other end cap.

In some non-limiting embodiments or aspects, system controller 304 may include a controller and associated circuitry. For example, system controller 304 may include a microcontroller, a computing device, a processor, a microprocessor, a digital signal processor (DSP), and/or any processing component (e.g., a field-programmable gate array (FPGA), an application-specific integrated circuit (ASIC), etc.) that can be configured to perform at least one function. In some non-limiting embodiments or aspects, system controller 304 may be communicatively connected to energy storage module container 200 and/or energy storage module(s) 100 (e.g., module controller(s) 103 thereof) by communication connection 208. In some non-limiting embodiments or aspects, system controller 304 may be electrically connected to energy storage module container 200 and/or energy storage module(s) 100 (e.g., energy storage component(s) 102 thereof) by electrical connection(s) 206. In some non-limiting embodiments or aspects, choke 402 may be included in and/or a part of system controller 304.

In some non-limiting embodiments or aspects, input connection 306 may include at least one connector (e.g., at least one standardized electrical plug connector, e.g., for mains electric power and/or electrical devices compatible therewith). In some non-limiting embodiments or aspects, each output connection 308 may include at least one connector (e.g., at least one standardized electrical plug connector, e.g., for mains electric power and/or electrical devices compatible therewith). For example, first output connection 308-1 may include a connector (e.g., standardized electrical plug connector) suitable for 100-127 V (e.g., at a frequency of 60 Hz suitable for the United States of America, North America, etc.). For example, second output connection 308-2 may include a connector (e.g., standardized electrical plug connector) suitable for 200-240 V (e.g., at a frequency of 50 Hz suitable for the European Union, etc.). In some non-limiting embodiments or aspects, communication connection 310 may include at least one connector (e.g., at least one standardized communication plug connector). For example, communication connection 310 may include at least one of a universal serial bus (USB) connector (e.g., USB-A, USB-B, USB-C, USB power delivery (USB-PD), mini-USB, micro-USB, and/or the like), an ethernet connector, a coaxial cable connector, a pin connector, a CAN-bus connector, any combination thereof, and/or the like.

In some non-limiting embodiments or aspects, choke 402 may be electrically connected (e.g., coupled and/or the like) to energy storage module container(s) 200 and/or energy storage module(s) 100, as described herein. For example, a first energy storage module container 200 and/or a first set of energy storage modules 100 may be connected to a first connection (e.g., first end, first winding, and/or the like) of choke 402, as described herein. Additionally or alternatively, a second energy storage module container 200 and/or a second set of energy storage modules 100 may be connected to a second connection (e.g., second end, second winding, and/or the like) of choke 402, as described herein.

In some non-limiting embodiments or aspects, system controller 304 may command module controller(s) 103 of energy storage module(s) 100 to generate an output voltage based on a combination (e.g., sum and/or the like) of the respective module voltage of each respective energy storage module 100, as described herein. For example, by sequentially connecting multiple energy storage module(s) 100 in series in a time-shifted manner, a combined (e.g., summed) voltage may approximate an AC voltage waveform having a target amplitude (e.g., a voltage substantially equal to the nominal voltage of mains electric power, such as 100-127 V, 200-240 V, an/dor the like) and/or a target frequency (e.g., a frequency substantially equal to the nominal frequency of mains electric power, such as 60 Hz, 50 Hz, and/or the like), as described herein.

In some non-limiting embodiments or aspects, system controller 304 may command module controller(s) 103 of energy storage module(s) 100 to cause a respective duty cycle of a respective module voltage of each respective energy storage module 100 to generate an output voltage based on a combination (e.g., sum and/or the like) of the respective module voltage of each respective energy storage module 100, as described herein. For example, by modulating the duty cycle differently for multiple energy storage module(s) 100 connected in series, a combined (e.g., summed) voltage may approximate (e.g., better approximate) an AC voltage waveform having a target amplitude and/or a target frequency, as described herein. In some non-limiting embodiments or aspects, the duty cycle of the respective module voltage may relate to a switched voltage scheme such as a PWM type waveform. For example, system controller 304 may command module controller(s) 103 of energy storage modules 100 to switch their output voltage with certain frequency and/or duty-cycle. The exact number or range of the switching frequency is not essential to the scope or generality of the teachings of the present disclosure. As some non-limiting examples, the switching frequency of the system may be in the kHz range (1 kHz to 999 kHz). For example, the switching frequency and/or PWM frequency of the system may be between 40 kHz and 100 kHz. In some cases, the switching frequency and/or PWM frequency of the system may be at or around 90 kHz. In some non-limiting embodiments or aspects, module output may be switching (e.g., PWM) at a frequency between 1.5 kHz to 7.5 kHz. For example, module output may be switching (e.g., PWM) at a frequency between 3.5 kHz to 4.5 kHz. As a further example, module output may be switching (e.g., PWM) at a frequency at or around 3.75 kHz. As another example, module output may be switching (e.g., PWM) at a frequency at or around 4 kHz. In some non-limiting embodiments or aspects, the switching frequency or PWM frequency of the system may be proportional to a multiplication of the switching frequency and/or PWM frequency of the energy storage module 100 and the number of energy storage modules 100. It shall be appreciated that duty cycle may be anywhere between 0% and 100%, e.g., depending on the time at which the respective energy storage modules 100 are being operated. For example, 0% duty cycle for a given energy storage module 100may mean that the energy storage module 100is instructed to be deactivated or in a bypass mode (energy storage module 100not contributing to the output voltage, but still able to carry current), and 100% duty cycle may mean that that energy storage module 100is instructed to be switched on or activated in a given polarity. For example, by sweeping the duty cycle of a given energy storage module 100over time (e.g., between 0% and 100%), the effective output voltage of that energy storage module 100can be more finely incremented or decremented between voltage steps associated with full switching between two consecutive energy storage modules 100. Various energy storage modules 100may be orchestrated, e.g., by system controller 304, to generate an output voltage based on a combination of the respective module voltage of each respective energy storage module 100, as described herein.

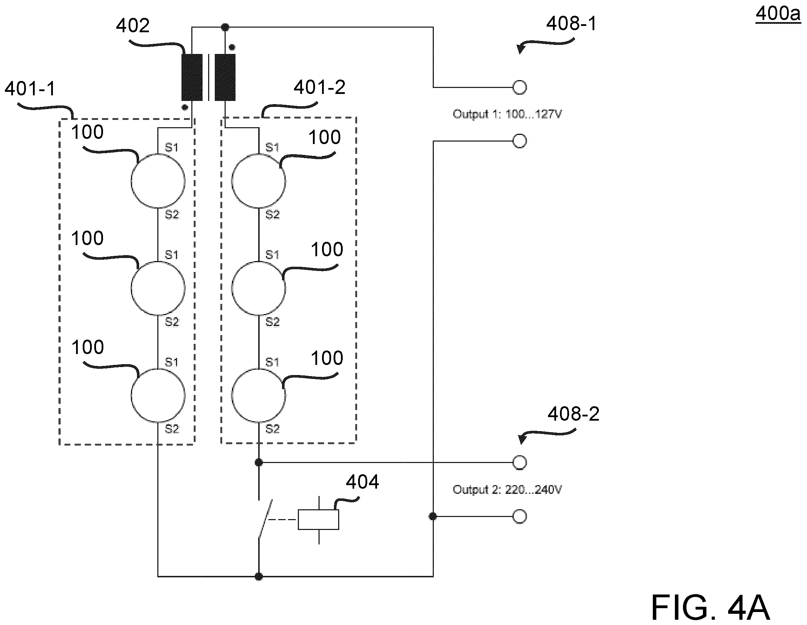

Referring now to FIG. 4A, shown is a circuit diagram of an example power supply system 400a, according to some non-limiting embodiments or aspects. In some non-limiting embodiments or aspects, power supply system 400a may be the same as or similar to power supply system 300. The number and arrangement of components shown are provided as an example. In some non-limiting embodiments or aspects, power supply system 400a may include additional components, fewer components, different components, or differently arranged components than those shown. Additionally or alternatively, a set of components (e.g., one or more components) of power supply system 400a may perform one or more functions described as being performed by another set of components of power supply system 400a. As shown in FIG. 4A, power supply system 400a may include set of energy storage modules (e.g., first set 401-1 of energy storage modules 100 and second set 401-2 of energy storage modules 100, collectively referred to as "sets 401," and individually referred to as "set 401"), choke 402, switch 404, and at least one output (e.g., first output 408-1 and/or second output 408-2, collectively referred to as "outputs 408," and individually referred to as "output 408").

In some non-limiting embodiments or aspects, first set 401-1 of energy storage modules 100 may include all energy storage modules 100 of at least one energy storage module container 200 (e.g., a first energy storage module container 200). Second set 401-2 of energy storage modules 100 may include all energy storage modules 100 of at least one other energy storage module container 200 (e.g., a second energy storage module container 200). It shall be appreciated that, in some non-limiting embodiments or aspects, any or both of the sets 401-1 and 401-2 may include more than one energy storage module container 200. In such cases, the more than one energy storage module container 200 in either set 401-1 or 401-2 may be series connected, and/or may be parallel connected. As such, when discussing energy storage modules 100 in either of the sets 401-1 or 401-2, these energy storage modules 100 may be grouped/divided in multiple energy storage module containers 200 in that set.

In some non-limiting embodiments or aspects, first set 401-1 of energy storage modules 100 may include at least some energy storage modules 100 from multiple energy storage module containers 200. For example, first set 401-1 of energy storage modules 100 may include all energy storage modules 100 from a first energy storage module container 200 and some of (e.g., half of) energy storage modules 100 of a second energy storage module container 200. Additionally, second set 401-2 of energy storage modules 100 may include at least some energy storage modules 100 from multiple energy storage module containers 200. For example, second set 401-2 of energy storage modules 100 may include all energy storage modules 100 from a third energy storage module container 200 and some of (e.g., the other half of) energy storage modules 100 of the second energy storage module container 200.

In some non-limiting embodiments or aspects, first set 401-1 of energy storage modules 100 may include a same number of energy storage modules 100 as second set 401-2 of energy storage modules 100. For example, a total number (e.g., M) of energy storage modules 100 may be equal to twice the number (e.g., N) of energy storage modules 100 of each set (e.g., M = 2N). For example, N may be any natural number greater than or equal to one, and M may be twice N. For the purpose of illustration, as shown in FIG. 4A, N may be three, and M may be six. As another example, N may be 9, and M may be 18. As another example, N may be 12, and M may be 24.

For the purpose of illustration, energy storage component(s) 102 of energy storage modules 100 may be lithium-ion cells. For example, each lithium-ion cell may have a nominal voltage of 3.6 V/cell, and six lithium-ion cells may be included in each energy storage module 100. If 24 total (e.g., N = 12, M = 24) energy storage modules 100 are connected in series, a maximum possible total output voltage may be up to 518.4 V. The actual output voltage may be less, depending on how energy storage modules 100 are controlled, as described herein.

In some non-limiting embodiments or aspects, first set 401-1 of energy storage modules 100 may be connected in series. For example, first set 401-1 of energy storage modules 100 may include N energy storage modules 100 connected in series.

In some non-limiting embodiments or aspects, second set 401-2 of energy storage modules 100 may be connected in series. For example, second set 401-2 of energy storage modules 100 may include N energy storage modules 100 connected in series.

In some non-limiting embodiments or aspects, choke 402 may be connected to first set 401-1 of energy storage modules 100 and second set 401-2 of energy storage modules 100. For example, as shown in FIG. 4A, choke 402 may be connected to first electrical connection S1 of one energy storage module 100 of first set 401-1 and to first electrical connection S1 of one energy storage module 100 of second set 401-2. Additionally or alternatively, choke 402 may be connected to second set 401-2 opposite from (e.g., on an opposite side from) where switch 404 is connected to second set 401-2. For example, switch 404 may be connected to second electrical connection S2 of another energy storage module 100 of second set 401-2 that is at an opposite end of the series-connected energy storage modules 100 from where choke 402 is connected.

In some non-limiting embodiments or aspects, choke 402 may include a first winding (e.g., a first inductor), a second winding (e.g., a second inductor). The choke 402 may also include a core (e.g., a toroidal core). In some non-limiting embodiments or aspects, the first winding of choke 402 may be connected to first set 401-1 of energy storage modules 100. Additionally or alternatively, the second winding of choke 402 may be connected to second set 401-2 of energy storage modules 100. A terminal of the first winding may have an electrical connection (e.g., connected together) to a terminal of the second winding. Thus, the two windings may share a common connection or terminal. As shown in FIG. 4A, such a common connection may be connected to first output 408-1. In some non-limiting embodiments or aspects, choke 402 may be in the form of a center-tapped choke (e.g., center-tapped inductor). For example, as shown in FIG. 4A, choke may include a connection such that the choke is between first set 401-1 and second set 401-2 of energy storage modules 100 when first set 401-1 and second set 401-2 are in series. In such a case, for the example shown in FIG. 4A, the center tap (e.g., the common connection between the first winding and the second winding) of the inductor may be connected to first output 408-1.

In some non-limiting embodiments or aspects, the first winding may be wound around at least a portion (e.g., a first portion) of the core, and/or the second winding may be wound around at least a portion (e.g., a second portion) of the core.

In some non-limiting embodiments or aspects, the first winding and the second winding may be bifilar windings around the toroidal core. For example, the first winding and the second winding may be parallel wound, series connected windings. As such, inductances of the first winding and the second winding may be the same or close to the same. Additionally, stray inductance may be reduced or minimized.

In some non-limiting embodiments or aspects, as shown in FIG. 4A, the voltage difference between windings of choke 402 (e.g., between a first winding of choke 402 connected to first set 401-1 and a second winding of choke 402 connected to second set 401-2) may be equal to (or substantially equal to) the voltage difference between the available voltage per energy storage module 100 (e.g., which may be different for each energy storage module 100). For example, system controller 304 may orchestrate the sets 401 so that the time-averaged voltage on both sets 401 is equal (e.g., no difference over a full (or multiple) PWM periods) and/or so that, within a PWM period, the voltage difference between sets may be close to zero (1V or -1 V), close to the available voltage of a single energy storage module 100 (e.g., 20 V or 21 V), or close to the sum of the available voltage of two energy storage modules 100 (e.g., 20 V + 21 V = 41 V), depending on how energy storage modules 100 are controlled (e.g., by system controller 304 or module controller 103).

In some non-limiting embodiments or aspects, switch 404 may be configured to switch between a first state and a second state. For example, upon switching of switch 404 to the first state (e.g., a closed state, an activated state, and/or the like), first set 401-1 of energy storage modules 100 may be connected in parallel with second set 401-2 of energy storage modules 100 to provide a first voltage to first output 408-1. Additionally or alternatively, upon switching of switch 404 to the second state (e.g., open state, deactivated state, and/or the like), first set 401-1 of energy storage modules 100 may be connected in series with second set 401-2 of energy storage modules 100 to provide a second voltage to second output 408-2.

In some non-limiting embodiments or aspects, switch 404 may include at least one of a switch, a contactor, any combination thereof, and/or the like. For example, switch 404 may include at least one of a single pole single throw (SPST) switch, a double pole double throw (DPDT) switch, a single pole double throw (SPDT) switch, a double pole single throw (DPST) switch, any combination thereof, and/or the like. For the purpose of illustration, as shown in FIG. 4A, switch 404 may include an SPST switch.

In some non-limiting embodiments or aspects, first output 408-1 may be associated with a first voltage. For example, the first voltage may be within a first range of 100-127 V AC (e.g., about 110 V) at a given frequency. It shall be appreciated that specifying a particular mains electric power frequency is not essential to the scope and generality of the teachings of the present disclosure, as different frequencies as desired can be implemented by driving the energy storage modules 100 as required. As an example, the 110 V AC may be delivered at or around 60 Hz frequency (e.g., as common in the United States). However, it is also possible to deliver 110 V AC at other frequencies, such as 50 Hz.

In some non-limiting embodiments or aspects, second output 408-2 may be associated with a second voltage at a given frequency. For example, the second voltage may be within a first range of 200-240 V AC (e.g., about 220 V). It shall be appreciated that specifying a particular mains electric power frequency is not essential to the scope and generality of the teachings of the present disclosure, as different frequencies as desired can be implemented by driving the energy storage modules 100 as required. As an example, the AC frequency may be at or around 50 Hz (e.g., as common in Europe). However, it is also possible to deliver 220 V AC at other frequencies, such as 60 Hz.

In some non-limiting embodiments or aspects, the first voltage (e.g., of first output 408-1) may be less than the second voltage (e.g., of second output 408-2). For example, the first voltage may be approximately half of the second voltage (e.g., half of the second voltage, within a tolerance range of half of the second voltage, and/or the like). As such, the same electrical system (e.g., power supply system 400a) may be configured in production for a given mains electric power domain, and/or power supply system 400a may be usable by the end-user in either of the two outputs 408, thereby allowing the user the flexibility to use electrical devices from different mains electric power domains. Accordingly, the electrical system (e.g., power supply system 400a) may be more efficient and/or less expensive to produce (e.g., by reducing the bill of materials), and the electrical system may also allow for equivalent effective output power irrespective of the outputs 408 being used.

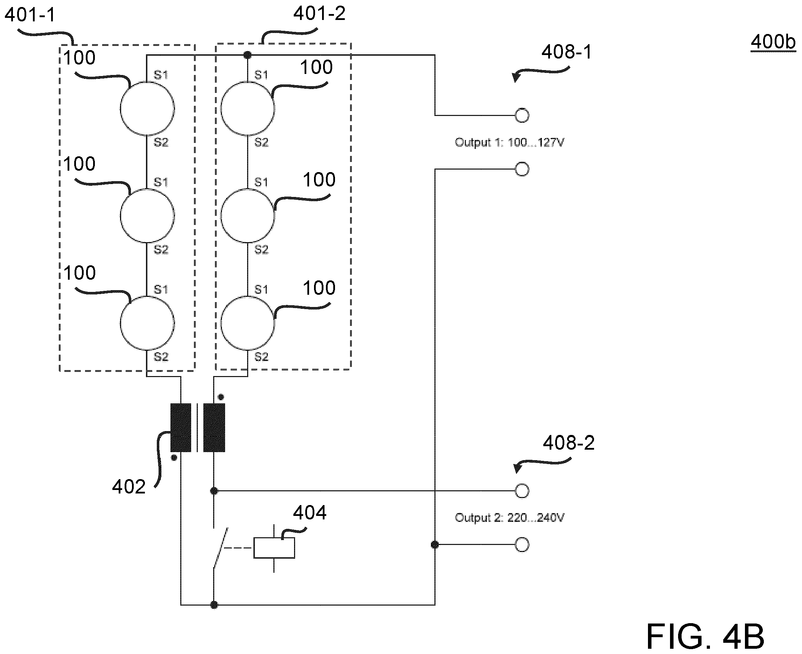

Referring now to FIG. 4B, shown is a circuit diagram of an example power supply system 400b, according to some non-limiting embodiments or aspects. In some non-limiting embodiments or aspects, power supply system 400b may be the same as or similar to power supply system 300. In some non-limiting embodiments or aspects, power supply system 400b may be the same as or similar to power supply system 400a, except that choke 402 may be arranged in a different location within the circuit. The number and arrangement of components shown are provided as an example. In some non-limiting embodiments or aspects, power supply system 400b may include additional components, fewer components, different components, or differently arranged components than those shown. Additionally or alternatively, a set of components (e.g., one or more components) of power supply system 400b may perform one or more functions described as being performed by another set of components of power supply system 400b. For brevity and clarity, the advantageous effects and possible alternatives discussed above with respect to power supply system 400a will not be repeated here. However, it shall be appreciated that those effects and alternatives can apply equally well here.

In some non-limiting embodiments or aspects, as shown in FIG. 4B, choke 402 may be connected to second electrical connection S2 of one energy storage module 100 of first set 401-1 and to second electrical connection S2 of one energy storage module 100 of second set 401-2. Additionally or alternatively, choke 402 (e.g., at least one winding thereof) may be connected between second set 401-2 and switch 404. For example, a first end of a winding (e.g., a second winding) of choke 402 may be connected to second electrical connection S2 of one energy storage module 100 of second set 401-2, and a second end of the winding may be connected to switch 404.

In some non-limiting embodiments or aspects, as shown in FIG. 4B, choke 402 may be connected such that one winding of the choke is connected at a first end of first set 401-1 and second set 401-2 of energy storage modules 100 and a second winding of the choke is connected at an opposite end of first set 401-1 and second set 401-2 of energy storage modules 100 when first set 401-1 and second set 401-2 are in series.

In some non-limiting embodiments or aspects, as shown in FIG. 4B, the voltage difference between windings of choke 402 (e.g., between a first winding of choke 402 connected to first set 401-1 and a second winding of choke 402 connected to second set 401-2) may be equal to (or substantially equal to) the total output voltage of power supply system 400b (e.g., when switch 404 is in the second/open state such that first set 401-1 and second set 401-2 are connected in series). As such, isolation between the windings of choke 402 in the arrangement shown in FIG. 4B may need to be greater than the isolation between the windings of choke 402 in the arrangement shown in FIG. 4A (e.g., due to the higher voltage difference between windings).

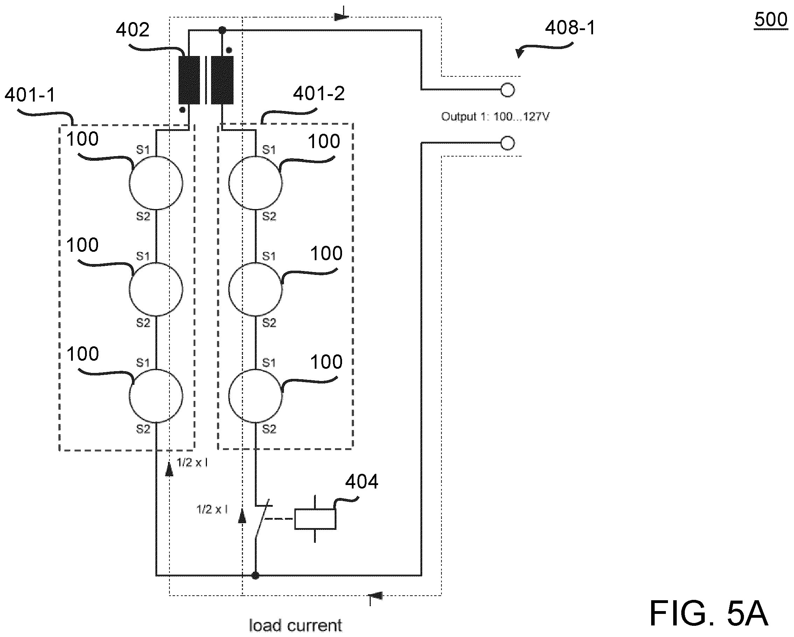

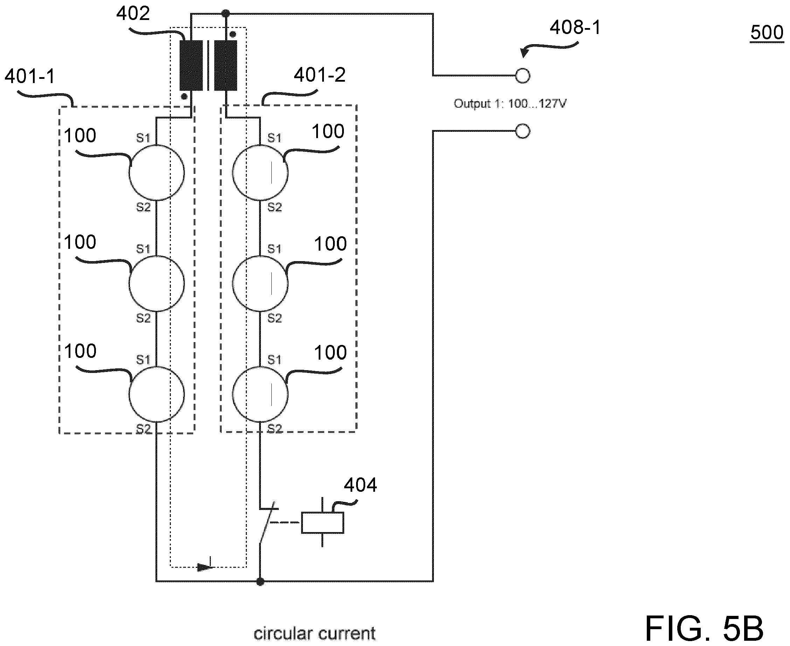

Referring now to FIGS. 5A and 5B, shown are circuit diagrams showing load and circular currents, respectively, of an example power supply system 500 in a first mode of operation, according to some non-limiting embodiments or aspects. In some non-limiting embodiments or aspects, power supply system 500 may be the same as or similar to power supply system 300. In some non-limiting embodiments or aspects, power supply system 500 may be the same as or similar to power supply system 400a when switch 404 is in the first state (e.g., closed state, activated state, and/or the like). The number and arrangement of components shown are provided as an example. In some non-limiting embodiments or aspects, power supply system 500 may include additional components, fewer components, different components, or differently arranged components than those shown. Additionally or alternatively, a set of components (e.g., one or more components) of power supply system 500 may perform one or more functions described as being performed by another set of components of power supply system 500.

In some non-limiting embodiments or aspects, a first load current through the first set 401-1 of energy storage modules may combine additively with a second load current through second set 401-2 of energy storage modules 100. For the purpose of illustration, as shown in FIG. 5A, for a load current I, the first load current through the first set 401-1 and the second load current through the second set 401-2 may each be approximately half of the load current (e.g., ½ I).

Hence, in some non-limiting embodiments or aspects, upon switching of switch 404 to the first state (e.g., closed state, activated state, and/or the like) to connect first set 401-1 of energy storage modules 100 in parallel with second set 401 - 2 of energy storage modules 100, a first magnetic flux of the first winding of choke 402 caused by a first load current through the first set 401-1 of energy storage modules 100 may combine subtractively with a second magnetic flux of the second winding of choke 402 caused by a second load current through second set 401-2 of energy storage modules 100. As such, the core of choke 402 may not be saturated by the load current(s) (e.g., for equally split first and second load currents). For example, the magnetic couplings of the windings may cancel out the modulation of the core by the load current such that the inductance is inactive for the load current.

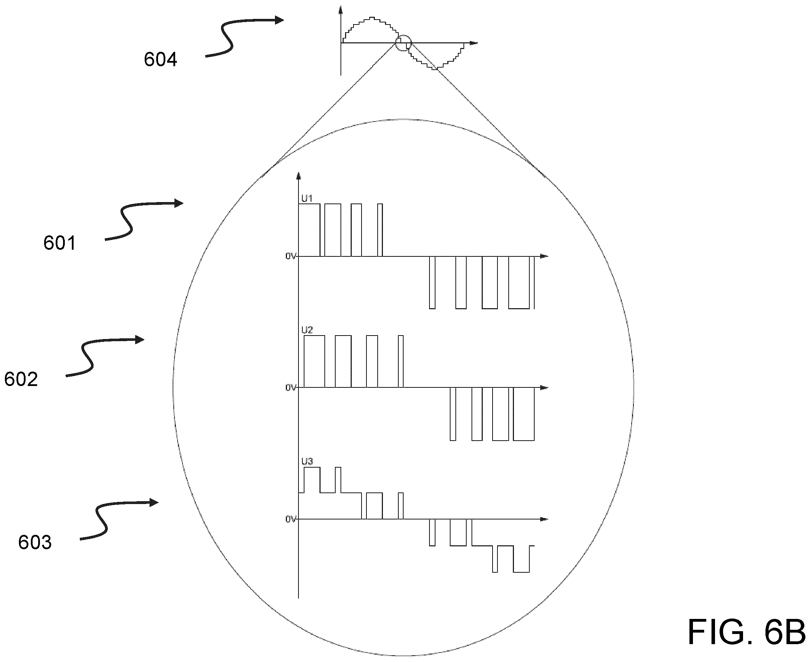

In some non-limiting embodiments or aspects, choke 402 may operate as an inductive voltage divider. For example, choke 402 may operate as an inductive voltage divider when switch 404 is in the first state (e.g., a closed state, an activated state, and/or the like) such that first set 401-1 and second set 401-2 are in parallel. In some non-limiting embodiments or aspects, the output voltages of the respective sets 401-1 and 401-2 may be orchestrated such that the steps (e.g., jumps) in voltage appearing at first output 408-1 may be reduced by the choke 402 acting as a voltage divider. As such, the effective level of the voltage jumps at first output 408-1 may be reduced (e.g., halved) by the choke, which may act as an inductive voltage divider. In this way, components of a filter (e.g., LC filter) at the output may be smaller (e.g., reduced inductance (L) and/or capacitance (C)) while maintaining a suitable filter effect. An example of this is described below with reference to FIG. 6B. It shall be appreciated that this can be particularly advantageous when module outputs are being modulated to a switched output, such as a PWM type output, as discussed herein.

In some non-limiting embodiments or aspects, switch 404 may be connected to second set 401-2 of energy storage modules 100. As such, switch 404 may only be required to carry half of the load current (e.g., ½ I) when switch 404 is in the first state (e.g., a closed state, an activated state, and/or the like) such that first set 401-1 and second set 401-2 are in parallel.

In some non-limiting embodiments or aspects, choke 402 may impede a circular (e.g., loop) current, which may flow between first set 401-1 and second set 401-2 of energy storage modules 100. This impedance may be leveraged especially effectively for high-frequency imbalances as discussed herein. For the purpose of illustration, as shown in FIG. 5B, a circular (e.g., loop) current may arise, for example, from a mismatch or imbalance between first set 401-1 and second set 401-2 of energy storage modules 100, as described herein. For example, due to a mismatch or imbalance between energy storage modules 100 of the two sets, a circular (e.g., loop) current may tend to flow between first set 401-1 and second set 401-2, and the direction of the flow of the circular (e.g., loop) current may depend upon the relative mismatch between first set 401-1 and second set 401-2. Choke 402 may impede a circular (e.g., loop) current. For example, the circular (e.g., loop current) may saturate the core of choke 402. For example, an unequal split of load current between the two sets 401 may saturate the core of choke 402. As another example, a loop current may tend to flow when the two sets 401-1 and 401-2 are operating in parallel (e.g., as shown in FIGS. 5A and 5B) and the outputs of any of the two sets 401-1 or 401-2 are switched (e.g., PWM) with respect to each other. In some non-limiting embodiments or aspects, the switching may cause unequal voltages at the outputs of the first set 401-1 and the second set 401-2, and as such, a high-frequency loop current may tend to flow between the sets 401-1 and 401-2. Choke 402 may offer high impedance to such loop current, while allowing load current which is in sync between the two sets 401-1 and 401-2 to flow relatively unimpeded. This can also be discussed by way of the following non-limiting example. Assuming that each of the sets 401 includes five energy storage modules 100, the state of charge may be such that, in the first set 401 - 1, each energy storage module 100 may be providing 19 V, while, in the second set 401-2, each energy storage module 100 may be providing 21 V. As such, there may be a 10 V difference (5 x 19 V = 95 V, while 5 x 21 V = 105 V) between the peak voltages of the first set 401-1 and the second set 401-2. Assuming that the output voltages of the sets 401 are being pulse width modulated at a frequency of, e.g., 90 kHz, the voltage difference of 10 V (DC) may be modulated to 0 V, +/-19 V, and +/- 21 V voltage difference at high-frequency (90 kHz). Time averaged output (within one 90 kHz period) of both sets 401 connected in parallel may be at or around 100 V. Choke 402 may exhibit low impedance for DC or low frequencies (e.g., below 1 kHz, such as 50 Hz or 60 Hz), and may exhibit significantly high impedance to 90 kHz current components. The above non-limiting example may further be used to explain the level-shifting of the voltage imbalance between the sets. For example, during switching (e.g., PWM) operation, the output of the first set 401-1 may switch between 95 V (5 x 19 V) and 114 V (6 x 19 V) to obtain a time-averaged output of 100 V, while the output of the second set 401-2 may switch between 84 V (4 x 21 V) and 105 V (5 x 105 V) to obtain a time-averaged output of 100 V. As such, the low-frequency (e.g., DC) voltage imbalance of 10 V is level shifted to the possible levels comprising: 11 V (95 V - 84 V), -10 V (95V- 105 V), 30 V (114 V - 84 V), and 9 V (114 V - 105 V).

In some non-limiting embodiments or aspects, choke 402 may allow the combined load current to flow essentially inductively unimpeded through choke 402, while the circular current may be inductively impeded, as described herein.

In some non-limiting embodiments or aspects, in addition to the components shown in FIGS. 5A and 5B, power supply system 500 may include second output 408-2. For brevity and clarity, second output 408-2 is not shown in FIGS. 5A and 5B because second output 408-2 would not be used while switch 404 is in the first state (e.g., because the closed switch may short the circuit across second output 408-2).

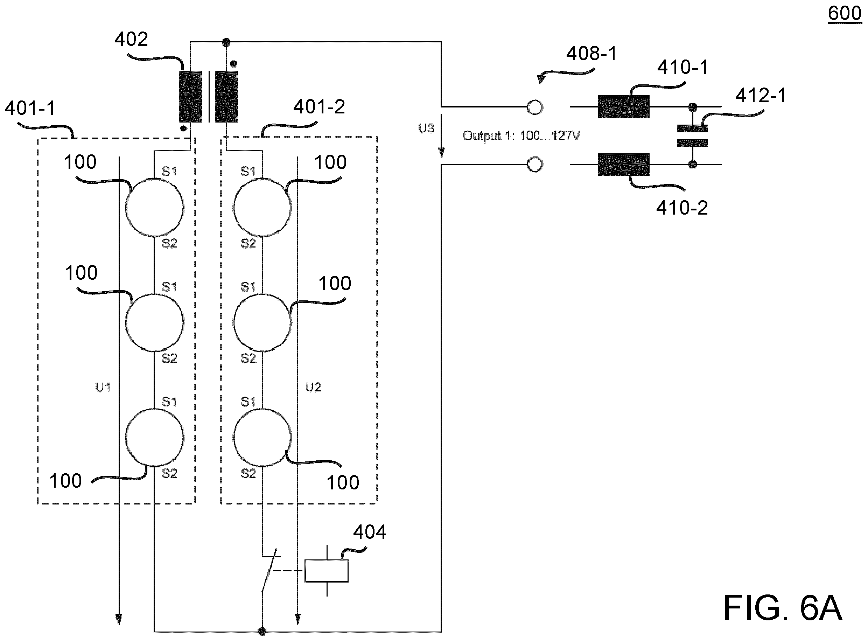

Referring now to FIG. 6A, shown is a circuit diagram of an example electrical power system, shown here as power supply system 600, in a first mode of operation, according to some non-limiting embodiments or aspects. In some non-limiting embodiments or aspects, power supply system 600 may be the same as or similar to power supply system 300. In some non-limiting embodiments or aspects, power supply system 600 may be the same as or similar to power supply system 400a and/or power supply system 500 when switch 404 is in the first state (e.g., closed state, activated state, and/or the like). The number and arrangement of components shown are provided as an example. In some non-limiting embodiments or aspects, power supply system 600 may include additional components, fewer components, different components, or differently arranged components than those shown. Additionally or alternatively, a set of components (e.g., one or more components) of power supply system 600 may perform one or more functions described as being performed by another set of components of power supply system 600.

In some non-limiting embodiments or aspects, power supply system 600 may include at least one inductor (e.g., first inductor 410-1 and/or second inductor 410-2, collectively referred to as "inductors 410," and individually referred to as "inductor 410") and/or at least one capacitor 412-1 connected to first output 408-1. For example, the arrangement including inductors 410 and capacitor 412-1 may act as a filter (e.g., LC filter) at first output 408-1. It shall be appreciated that the filter arrangement as shown in FIG. 6A may act as a low-pass filter for blocking high-frequency components (e.g., caused by switching elements 110 of energy storage modules 100) from being delivered to a load (e.g., electrical device and/or electrical consumer) connected to the output (e.g., the first output 408-1). In some non-limiting embodiments or aspects, because choke 402 may impart little to no inductive impedance to load currents in the first mode of operation (e.g., switch closed so that first set 401-1 and second set 401-2 are in parallel), inductors 410 may provide sufficient inductance (L) to operate as an LC filter with the capacitance (C) of capacitor 412-1.

In some non-limiting embodiments or aspects, voltage across first set 401-1 of energy storage modules 100 may be measured as indicated by arrow U1. Additionally or alternatively, voltage across second set 401-2 of energy storage modules 100 may be measured as indicated by arrow U2. Additionally or alternatively, voltage across first output 408-1 may be measured as indicated by arrow U3.

Referring now to FIG. 6B, shown are graphs of voltages (e.g., measured as indicated by arrows U1, U2, and U3 of FIG. 6A) of the example power supply system 600 of FIG. 6A, according to some non-limiting embodiments or aspects.

As shown in in FIG. 6B, graph 604 may include a complete waveform cycle at first output 408-1 (e.g., measured as indicated by arrow U3). Graphs 601, 602, and 603 are zoomed in graphs of the time period within the circle of graph 604. For example, graph 601 may show voltage across first set 401-1 of energy storage modules 100 (e.g., measured as indicated by arrow U1), and graph 602 may show voltage across second set 401-2 of energy storage modules 100 (e.g., measured as indicated by arrow U2). Graph 603 may show voltage across first output 408-1 (e.g., measured as indicated by arrow U3).

In some non-limiting embodiments or aspects, the module controllers 103 of respective energy storage modules 100 of first set 401-1 and second set 401-2 may cause (e.g., by or via the system controller 304, such as being commanded or controlled by system controller 304) a respective duty cycle of a respective module voltage of the respective energy storage module 100 to generate an output voltage (e.g., across first output 408-1 measured as indicated by arrow U3) based on a combination of the respective module voltage of each respective energy storage module. For example, the voltage measured at U3 (e.g., as shown in graph 603) may be based on (e.g., a combination of) the voltages measured across U1 (e.g., as shown in graph 601) and U2 (e.g., as shown in graph 602).

In some non-limiting embodiments or aspects, the module controllers 103 of respective energy storage modules 100 of first set 401-1 and second set 401-2 may cause (e.g., by or via the system controller 304, such as being commanded or controlled by system controller 304) first module voltages of first set 401-1 to be interleaved with second module voltages of second set 401-2. For the purpose of illustration, as shown in FIG. 6B, the voltage measured across U1 (e.g., as shown in graph 601) may be (at least partially) interleaved with the voltage measure across U2 (e.g., as shown in graph 602). For example, choke 402 may act as a voltage divider, as described herein, which may significantly reduce (e.g., halve and/or the like) the voltage steps appearing at any time in voltage U3. This may allow for smaller low-pass filter parts to remove high-frequency components (e.g., caused by the switching). This can make the system more compact and/or less expensive. It shall be appreciated that the reduction in the step size may be equivalent to the voltage divider ratio, which for a symmetrical structure between the two sets 401-1 and 401-2 may be one-half. A specific ratio is non-limiting to the scope or generality of the teachings of the present disclosure. The interleaving may be achieved by any suitable switching sequence between U1 and U2 that permits either one of these voltages to switch at any given time. It shall also be appreciated that any loop current which could be caused during the regions in which U1 and U2 are at different voltage levels may be impeded by the choke 402, as described herein. Since the voltage steps as shown in FIG. 6B may be done at high-frequency (at or above kHz range), the impedance offered by choke 402 to such transient currents may be much higher than the impedance offered by the choke to the load current.

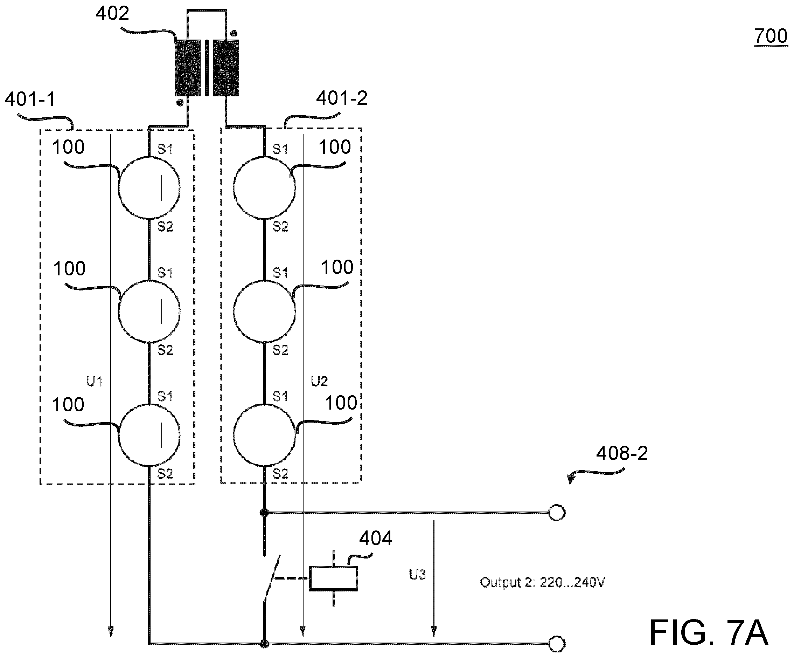

Referring now to FIG. 7A, shown is a circuit diagram of an example electrical system, shown as power supply system 700, in a second mode of operation, according to some non-limiting embodiments or aspects. In some non-limiting embodiments or aspects, power supply system 700 may be the same as or similar to power supply system 300. In some non-limiting embodiments or aspects, power supply system 700 may be the same as or similar to power supply system 400a when switch 404 is in the second state (e.g., open state, deactivated state, and/or the like). The number and arrangement of components shown are provided as an example. In some non-limiting embodiments or aspects, power supply system 700 may include additional components, fewer components, different components, or differently arranged components than those shown. Additionally or alternatively, a set of components (e.g., one or more components) of power supply system 700 may perform one or more functions described as being performed by another set of components of power supply system 700.

In some non-limiting embodiments or aspects, voltage across first set 401-1 of energy storage modules 100 may be measured as indicated by arrow U1. Additionally or alternatively, voltage across second set 401-2 of energy storage modules 100 may be measured as indicated by arrow U2. Additionally or alternatively, voltage across second output 408-2 may be measured as indicated by arrow U3.

In some non-limiting embodiments or aspects, in addition to the components shown in FIG. 7A, power supply system 700 may include first output 408-1. For brevity and clarity, first output 408-1 is not shown in FIG. 7A because first output 408-1 would not be used while switch 404 is in the second state (e.g., because the open switch would prevent first set 401-1 from being in parallel with second set 401-2).

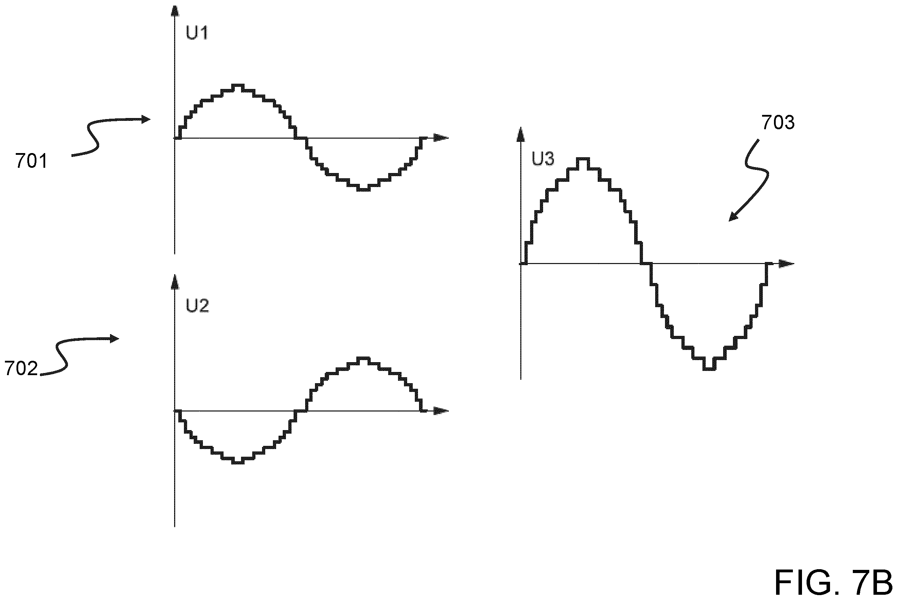

Referring now to FIG. 7B, shown are graphs of voltages (e.g., measured as indicated by arrows U1, U2, and U3 of FIG. 7A) of the example power supply system 700 of FIG. 7A, according to some non-limiting embodiments or aspects.

As shown in in FIG. 7B, graph 701 may show voltage across first set 401-1 of energy storage modules 100 (e.g., measured as indicated by arrow U1), and graph 702 may show voltage across second set 401-2 of energy storage modules 100 (e.g., measured as indicated by arrow U2). Graph 703 may show voltage across second output 408-2 (e.g., measured as indicated by arrow U3).

In some non-limiting embodiments or aspects, system controller 304 may command and/or control the module controllers 103 of respective energy storage modules 100 of first set 401-1 and second set 401-2 to cause first module voltages of first set 401-1 of energy storage modules 100 to be inverted with respect to second module voltages of second set 401-2 of energy storage modules 100. For example, the voltages measured across U1 (e.g., as shown in graph 601) may be inverted with respect to the voltages measured across U2 (e.g., as shown in graph 602).

In some non-limiting embodiments or aspects, the voltage measured at U3 (e.g., as shown in graph 703) may be based on (e.g., a combination of, a sum of, and/or the like) the voltages measured across U1 (e.g., as shown in graph 601) and U2 (e.g., as shown in graph 602).

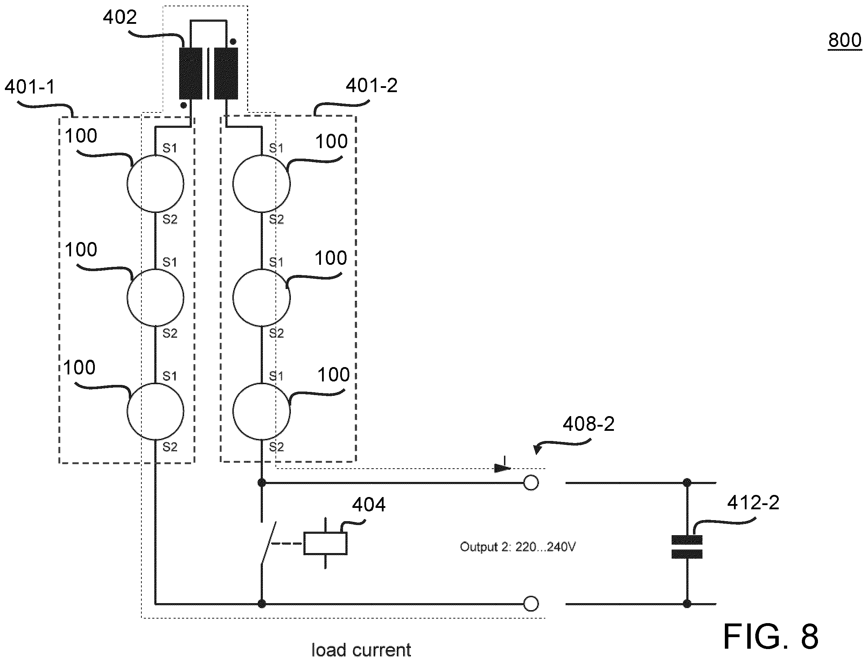

Referring now to FIG. 8, shown is a circuit diagram of an example power supply system 800 in a second mode of operation, according to some non-limiting embodiments or aspects. In some non-limiting embodiments or aspects, power supply system 800 may be the same as or similar to power supply system 300. In some non-limiting embodiments or aspects, power supply system 800 may be the same as or similar to power supply system 400a and/or power supply system 700 when switch 404 is in the second state (e.g., open state, deactivated state, and/or the like). The number and arrangement of components shown are provided as an example. In some non-limiting embodiments or aspects, power supply system 800 may include additional components, fewer components, different components, or differently arranged components than those shown. Additionally or alternatively, a set of components (e.g., one or more components) of power supply system 800 may perform one or more functions described as being performed by another set of components of power supply system 800.

In some non-limiting embodiments or aspects, power supply system 800 may include at least one capacitor 412-2 connected to second output 408-2. For example, choke 402 and capacitor 412-2 may act as a filter (e.g., LC filter) at second output 408-2. In some non-limiting embodiments or aspects, because choke 402 imparts inductance (e.g., inductive impedance) to load currents in the second mode of operation (e.g., switch opened so that first set 401-1 and second set 401-2 are in series), choke 402 may provide sufficient inductance (L) to operate as an LC filter with the capacitance (C) of capacitor 412-2 (e.g., without the need for another separate inductor at second output 408-2). For example, this may save costs and/or provide an electrical power system suitable for multiple voltage domains (e.g., mains electric power domains). This can also result in a more compact multi-domain system by preventing at least one large filter component.

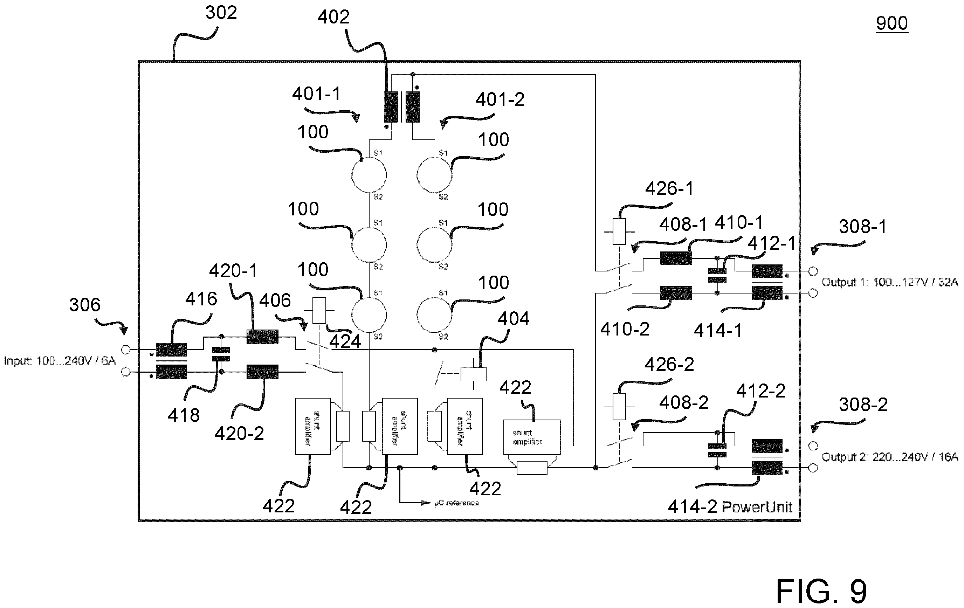

Referring now to FIG. 9, shown is a circuit diagram of an example power supply system 900, according to some non-limiting embodiments or aspects. In some non-limiting embodiments or aspects, power supply system 900 may be the same as or similar to power supply system 300. In some non-limiting embodiments or aspects, power supply system 900 may be the same as or similar to power supply system 400a, power supply system 500, power supply system 600, power supply system 700, and/or power supply system 800. The number and arrangement of components shown are provided as an example. In some non-limiting embodiments or aspects, power supply system 900 may include additional components, fewer components, different components, or differently arranged components than those shown. Additionally or alternatively, a set of components (e.g., one or more components) of power supply system 900 may perform one or more functions described as being performed by another set of components of power supply system 900.

In some non-limiting embodiments or aspects, as shown in FIG. 9, input connection 306 may be connected to input choke 416. Input choke 416 may be connected to input capacitor 418 and/or at least one input inductor (e.g., first input inductor 420-1 and/or second input inductor 420-2, collectively referred to as "input inductors 420," and individually referred to as "input inductor 420"). For example, input choke 416 may be provided for electromagnetic compatibility (EMC) reasons. Similarly, input capacitor 418 may be provided as an EMC capacitor (and/or class-X capacitor), which may stabilize the input voltage and/or make the input less impedant at higher frequencies. For example, input inductor(s) 420 may be used to operate the electrical system 900 in a controlled current mode.

In some non-limiting embodiments or aspects, first output connection 308-1 may be connected to first output choke 414-1. First output choke 414-1 may be connected to at least one of capacitor 412-1 and/or inductors 410.

In some non-limiting embodiments or aspects, second output connection 308-2 may be connected to second output choke 414-2. Second output choke 414-2 may be connected to capacitor 412-2.

In some non-limiting embodiments or aspects, each of the chokes (e.g., input choke 416, first output choke 414-1, and/or second output choke 414-2) may be common-mode chokes and/or the like, e.g., used for EMC performance. It shall be appreciated that further discussion of EMC inductors or capacitors is not essential to the scope or generality of the present teachings.

In some non-limiting embodiments or aspects, input switch 424 may selectively connect and/or disconnect input 406 from first set 401-1 and second set 401-2 of energy storage modules 100. In some non-limiting embodiments or aspects, to operate in a third mode of operation (e.g., a charging mode of operation) input switch 424 at input 406 may be switched to a first state (e.g., closed, activated, and/or the like), and/or switch 404 may be in a second state (e.g., open state, deactivated state, and/or the like) during the third (e.g., charging) mode of operation. For example, switching input switch 424 to the first state (e.g., closed, activated, and/or the like) may allow current to flow from input connection 306 through input 406 to first set 401-1 and second set 401-2 of energy storage modules 100 (e.g., to charge energy storage modules 100). In some non-limiting embodiments or aspects, a power source (e.g., mains electric power, generator power, renewable power (e.g., solar, wind, and/or the like), and/or the like) may be connected to input connection 306. In some non-limiting embodiments or aspects, system controller 300 may control module controllers of energy storage modules 100 to charge energy storage components 102 thereof (e.g., based on power from the power source).

In some non-limiting embodiments or aspects, to discontinue the third mode of operation (e.g., stop charging) and/or to prevent current from flowing to input connection 306 when power supply system 900 is not in the third (e.g., charging) mode of operation, input switch 424 at input 406 may be switched to a second state (e.g., open, deactivated, and/or the like).

In some non-limiting embodiments or aspects, at least one output switching element (e.g., first output switch 426-1 and/or second output switch 426-1, collectively referred to as "output switches 426," and individually referred to as "output switch 426") may selectively connect and/or disconnect outputs 408 from first set 401-1 and second set 401-2 of energy storage modules 100.

In some non-limiting embodiments or aspects, to operate in the first mode of operation, in addition to switching of switch 404 to a first state (e.g., closed, activated and/or the like), first output switch 426-1 may be switched to a first state (e.g., closed, activated and/or the like). For example, this may allow current to flow from first set 401-1 and second set 401-2 of energy storage modules 100 through first output 408-1 (and inductors 410 and/or capacitor 412-1) to first output connection 308-1 (e.g., to supply power to a load connected to first output connection 308-1). In some non-limiting embodiments or aspects, to prevent current from flowing to first output connection 308-1 when power supply system 900 is not in the first mode of operation, first output switch 426-1 may be switched to a second state (e.g., opened, deactivated and/or the like).

In some non-limiting embodiments or aspects, to operate in the second mode of operation, in addition to switching of switch 404 to a second state (e.g., opened, deactivated and/or the like), second output switch 426-2 may be switched to a first state (e.g., closed, activated and/or the like). For example, this may allow current to flow from first set 401-1 and second set 401-2 of energy storage modules 100 through second output 408-2 (and capacitor 412-2) to second output connection 308-2 (e.g., to supply power to a load connected to second output connection 308-2). In some non-limiting embodiments or aspects, to prevent current from flowing to second output connection 308-2 when power supply system 900 is not in the second mode of operation, second output switch 426-2 may be switched to a second state (e.g., opened, deactivated and/or the like).

In some non-limiting embodiments or aspects, each of input switch 424 and output switches 426 may include at least one of a switch, a contactor, a transistor, any combination thereof, and/or the like. For example, each of input switch 424 and output switches 426 may include at least one of an SPST switch, a DPDT switch, an SPDT switch, a DPST switch, any combination thereof, and/or the like. For example, each of input switch 424 and output switches 426 may include at least one of a DPDT switch or a DPST switch. For the purpose of illustration, as shown in FIG. 9, each of input switch 424 and output switches 426 may include a DPST switch or a DPDT switch.

In some non-limiting embodiments or aspects, power supply system 900 may include current sensors 422, which may be in communication with system controller 304 (e.g., a microcontroller). In some non-limiting embodiments or aspects, each current sensor 422 may include a shunt amplifier. For example, each shunt amplifier may refer to a common potential (e.g., reference voltage), to which system controller 304 (e.g., a microcontroller) also may refer. In some non-limiting embodiments or aspects, at least some (e.g., all, a subset, and/or the like) of current sensors 422 may be any other suitable type of current sensor. For example, a current sensor 422 may include measuring voltage drop across a resistor connected in series (e.g., to at least one of first set 401-1 and/or second set 401-2 of energy storage modules 100), e.g., to measure the current flowing through the resistor (and/or any component in series with the resistor). In some non-limiting embodiments or aspects, at least one current sensor 422 may be of a different type than another current sensor 422. For example, a current sensor 422 connected to of first set 401-1 of energy storage modules 100 may be of a different type than another current sensor 422 connected to second set 401-2 of energy storage modules 100.

In some non-limiting embodiments or aspects, by measuring current at locations of current sensors 422, the following may be measured (e.g., by system controller 304 and/or the like): output current (e.g., in a redundant manner), input current (e.g., in a redundant manner), circular current (e.g., if strings are connected in parallel). In some non-limiting embodiments or aspects, current sensors 402 may measure current flowing through each of first set 401-1 and second set 401-2 of energy storage modules 100. As such, relative measurements may be performed to detect if a circular (e.g., loop) current is flowing between first set 401-1 and second set 401-2 of energy storage modules 100. For example, such relative measurements may be used to detect that the load current is divided evenly between the sets. Such measurements also may be used (e.g., by system controller 304) for orchestrating the operation of energy storage modules 100, e.g., in such a manner that the circular (e.g., loop) current may be reduced (e.g., eliminated). Additionally or alternatively, such orchestration may also include disabling certain energy storage modules 100 in any of sets 401, even if such disabling causes an unequal number of active energy storage modules 100 between the sets 401. This may help running the system 900, for example, even if energy storage modules 100 between sets 401 have different charge levels. Additionally or alternatively, such orchestration may include first module voltages of first set 401-1 being interleaved with second module voltages of second set 401-2. As shown in FIG. 6B, interleaving of the module voltages can be done by phase shifting output voltage of one set with respect to the output of the other set. Additionally or alternatively, it is possible to use a different switching scheme to achieve a similar benefit (e.g., any suitable switching sequence between U1 and U2 that permits either one of these voltages to switch at any given time.). For example, an orchestration involving switching U1 "ON" first, then switching U2 "ON", followed by switching U2 "OFF" and then switching U1 "OFF" may also cause divided voltage steps in voltage U3. It shall be appreciated that other ways may also be possible, e.g., by swapping switching of U1 and U2, which may involve switching U2 "ON" first, then switching U1 "ON", followed by switching U1 "OFF" and then switching U2 "OFF," which may also cause divided voltage steps in voltage U3. Additionally or alternatively, such orchestration may include tolerating, or even in some non-limiting embodiments or aspects, creating, an imbalance in voltages between the first set 401-1 and the second set 401-2. This may result in the loop current which tends to flow from one set 401 to the other set 401 to be a low frequency current which can be used, e.g., to equalize state of charge between the two sets 401. Choke 402, even in such non-limiting embodiments or aspects, may block the high frequency currents, but may allow low frequency or DC current to flow from the set 401 having a higher voltage than the other set 401. As such, power supply system 900 may be more robust, flexible, and balanced. In some non-limiting embodiments or aspects, current sensors 422 may be leveraged for making absolute measurements, such as determining total current flowing through first set 401-1 and/or second set 401-2 of energy storage modules 100. It shall be appreciated that said imbalance may be caused by unequal number of energy storage modules 100 operating in one set 401 as compared to the number of energy storage modules 100 operating in the other set 401. Additionally or alternatively, the imbalance may be due to unequal charge level between the two sets 401.

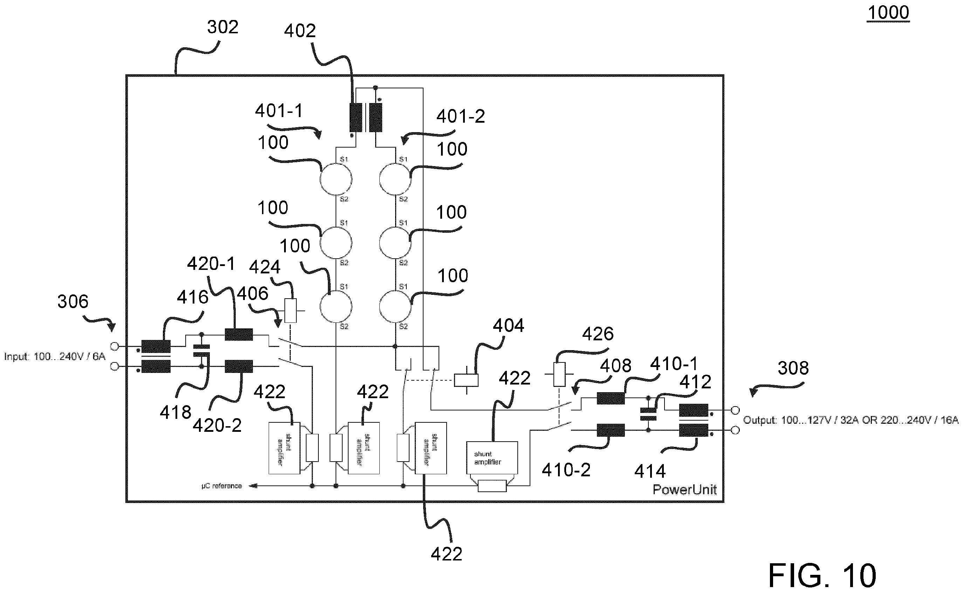

Referring now to FIG. 10, shown is a circuit diagram of an example power supply system 1000, according to some non-limiting embodiments or aspects. In some non-limiting embodiments or aspects, power supply system 1000 may be the same as or similar to power supply system 300. In some non-limiting embodiments or aspects, power supply system 1000 may be the same as or similar to power supply system 400a, power supply system 500, power supply system 600, power supply system 700, power supply system 800, and/or power supply system 900, except that a single output 408 (and single output switch 426, single output capacitor 412, and single output connection 308) may be used, switch 404 may include a DPDT switch. The number and arrangement of components shown are provided as an example. In some non-limiting embodiments or aspects, power supply system 900 may include additional components, fewer components, different components, or differently arranged components than those shown. Additionally or alternatively, a set of components (e.g., one or more components) of power supply system 900 may perform one or more functions described as being performed by another set of components of power supply system 900.

In some non-limiting embodiments or aspects, switch 404 may include a DPDT switch. For example, the DPDT switch may be configured to switch between a first state and a second state. For example, upon switching the DPDT switch to the first state, first set 401-1 of energy storage modules 100 may be connected in parallel with second set 401-2 of energy storage modules 100 to provide a first voltage to output 408. Additionally or alternatively, upon switching the DPDT switch to the second state, first set 401-1 of energy storage modules 100 may be connected in series with second set 401-2 of energy storage modules 100 to provide a second voltage to output 408.

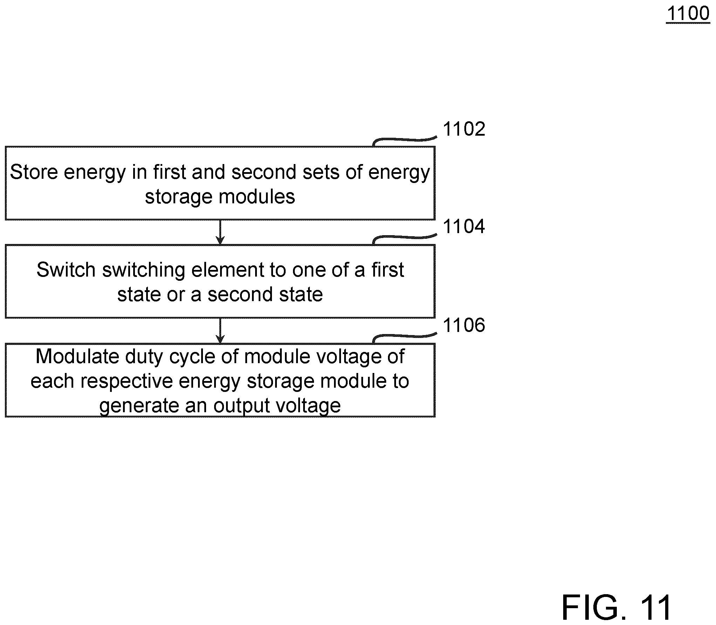

Referring now to FIG. 11, shown is a flow diagram of an example method 1100 for using a power supply system, according to some non-limiting embodiments or aspects. The steps shown in FIG. 11 are for example purposes only. It will be appreciated that additional, fewer, different, and/or a different order of steps may be used in some non-limiting embodiments or aspects. In some non-limiting embodiments or aspects, a step may be automatically performed in response to performance and/or completion of a prior step. In some non-limiting embodiments or aspects, one or more of the steps of method 1100 may be performed (e.g., completely, partially, and/or the like) by system controller 304. In some non-limiting embodiments or aspects, one or more of the steps of method 1100 may be performed (e.g., completely, partially, and/or the like) by another system, another device, another group of systems, or another group of devices, separate from or including system controller 304, such as module controller 103, energy storage module 100, power supply system 300, and/or the like.

As shown in FIG. 11, at step 1102, method 1100 may include storing energy in each energy storage module 100 of first set 401-1 of energy storage modules 100 and second set 401-2 of energy storage modules 100, as described herein.

In some non-limiting embodiments or aspects, storing energy may include charging each energy storage module 100 of the first set 401-1 of energy storage modules 100 and/or and the second set 401-2 of energy storage modules 100. For example, the power supply system (e.g., 300, 400a, 400b, 500, 600, 700, 800, 900, 1000) may include at least one input 406. Charging may include connecting a power source to the input(s) 406 and/or charging each energy storage module 100 (e.g., of first set 401-1 and/or second set 401-2 of energy storage modules 100) based on power from the power source.

As shown in FIG. 11, at step 1104, method 1100 may include switching of switch 404 to one of a first state or a second state, as described herein. For example, the first state may connect the first set 401-1 of energy storage modules 100 in parallel with the second set 401-2 of energy storage modules 100, as described herein. The second state may connect the first set 401-1 of energy storage modules 100 in series with the second set 401-2 of energy storage modules 100, as described herein.

In some non-limiting embodiments or aspects, switching of switch 404 may include switching of switch 404 to the first state to connect the first set 401-1 of energy storage modules 100 in parallel with the second set 401-2 of energy storage modules 100, as described herein. In some non-limiting embodiments or aspects, method 1100 may further include interleaving first module voltages of the first set 401-1 of energy storage modules 100 with second module voltages of the second set 401-2 of energy storage modules 100, as described herein.

In some non-limiting embodiments or aspects, switching of switch 404 may include switching the switch 404 to the second state to connect first set 401-1 of energy storage modules 100 in series with second set 401-2 of energy storage modules 100, as described herein. In some non-limiting embodiments or aspects, method 1100 may further include inverting first module voltages of first set 401-1 of energy storage modules 100 with respect to second module voltages of second set 401-2 of energy storage modules 100, as described herein.

As shown in FIG. 11, at step 1106, method 1100 may include modulating a respective duty cycle of a respective module voltage of each respective energy storage module 100 to generate an output voltage based on a combination of the respective module voltage of each respective energy storage module 100, as described herein. For example, the output voltage may include one of a first voltage associated with switch 404 being in the first state or a second voltage associated with switch 404 being in the second state.

In some non-limiting embodiments or aspects, the power supply system (e.g., 300, 400a, 400b, 500, 600, 700, 800, 900, 1000) may include at least one output 408. For example, method 1100 may further include supplying energy to a load connected to the output(s) based on the output voltage.

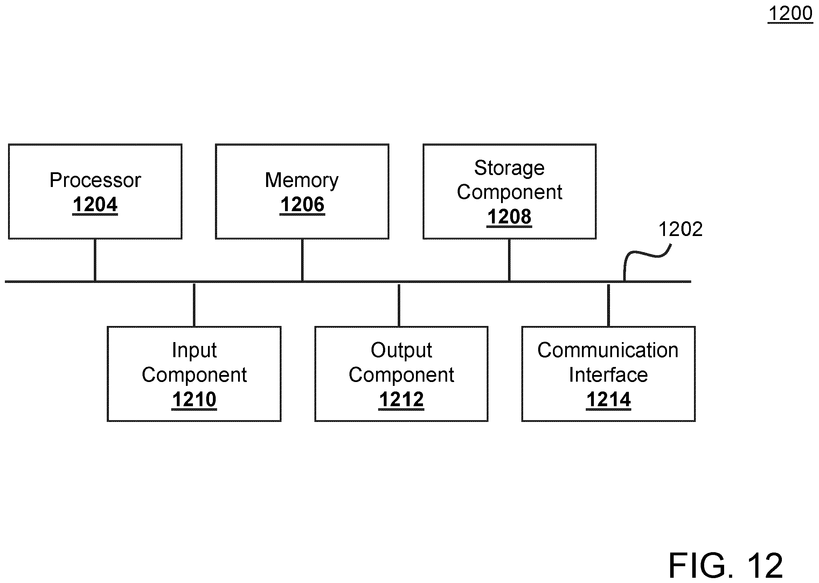

Referring now to FIG. 12, shown is a diagram of example components of a device 1200 according to non-limiting embodiments. Device 1200 may correspond to at least one of module controller 103 and/or system controller 304, as an example. In some non-limiting embodiments or aspects, such controllers may include at least one device 1200 and/or at least one component of device 1200. The number and arrangement of components shown are provided as an example. In some non-limiting embodiments or aspects, device 1200 may include additional components, fewer components, different components, or differently arranged components than those shown. Additionally or alternatively, a set of components (e.g., one or more components) of device 1200 may perform one or more functions described as being performed by another set of components of device 1200.

As shown in FIG. 12, device 1200 may include bus 1202, processor 1204, memory 1206, storage component 1208, input component 1210, output component 1212, and communication interface 1214. Bus 1202 may include a component that permits communication among the components of device 1200. In some non-limiting embodiments or aspects, processor 1204 may be implemented in hardware, firmware, or a combination of hardware and software. For example, processor 1204 may include a microcontroller, a processor (e.g., a central processing unit (CPU), a graphics processing unit (GPU), an accelerated processing unit (APU), etc.), a microprocessor, a digital signal processor (DSP), and/or any processing component (e.g., a field-programmable gate array (FPGA), an application-specific integrated circuit (ASIC), etc.) that can be programmed to perform a function. Memory 1206 may include random access memory (RAM), read only memory (ROM), and/or another type of dynamic or static storage device (e.g., flash memory, magnetic memory, optical memory, etc.) that stores information and/or instructions for use by processor 1204.

With continued reference to FIG. 12, storage component 1208 may store information and/or software related to the operation and use of device 1200. For example, storage component 1208 may include a hard disk (e.g., a magnetic disk, an optical disk, a magneto-optic disk, a solid-state disk, etc.) and/or another type of computer-readable medium. Input component 1210 may include a component that permits device 1200 to receive information, such as via user input (e.g., a touch screen display, a keyboard, a keypad, a mouse, a button, a switch, a microphone, etc.). Additionally or alternatively, input component 1210 may include a sensor for sensing information. Output component 1212 may include a component that provides output information from device 1200 (e.g., a display, a speaker, one or more light-emitting diodes (LEDs), etc.). Communication interface 1214 may include a transceiver-like component (e.g., a transceiver, a separate receiver and transmitter, etc.) that enables device 1200 to communicate with other devices, such as via a wired connection, a wireless connection, or a combination of wired and wireless connections. Communication interface 1214 may permit device 1200 to receive information from another device and/or provide information to another device. For example, communication interface 1214 may include an Ethernet interface, an optical interface, a coaxial interface, an infrared interface, a radio frequency (RF) interface, a universal serial bus (USB) interface, a Wi-Fi^{®} interface, a cellular network interface, and/or the like.

Device 1200 may perform one or more processes described herein. Device 1200 may perform these processes based on processor 1204 executing software instructions stored by a computer-readable medium, such as memory 1206 and/or storage component 1208. A computer-readable medium may include any non-transitory memory device. A memory device includes memory space located inside of a single physical storage device or memory space spread across multiple physical storage devices. Software instructions may be read into memory 1206 and/or storage component 1208 from another computer-readable medium or from another device via communication interface 1214. When executed, software instructions stored in memory 1206 and/or storage component 1208 may cause processor 1204 to perform one or more processes described herein. Additionally or alternatively, hardwired circuitry may be used in place of or in combination with software instructions to perform one or more processes described herein. Thus, embodiments described herein are not limited to any specific combination of hardware circuitry and software. The term "configured to," as used herein, may refer to an arrangement of software, device(s), and/or hardware for performing and/or enabling one or more functions (e.g., actions, processes, steps of a process, and/or the like). For example, "a processor configured to" may refer to a processor that executes software instructions (e.g., program code) that cause the processor to perform one or more functions. It shall be appreciated that the present teachings also disclose a software program product comprising instructions which when executed by a suitable computer processor cause the computer processor to perform the methods herein disclosed.

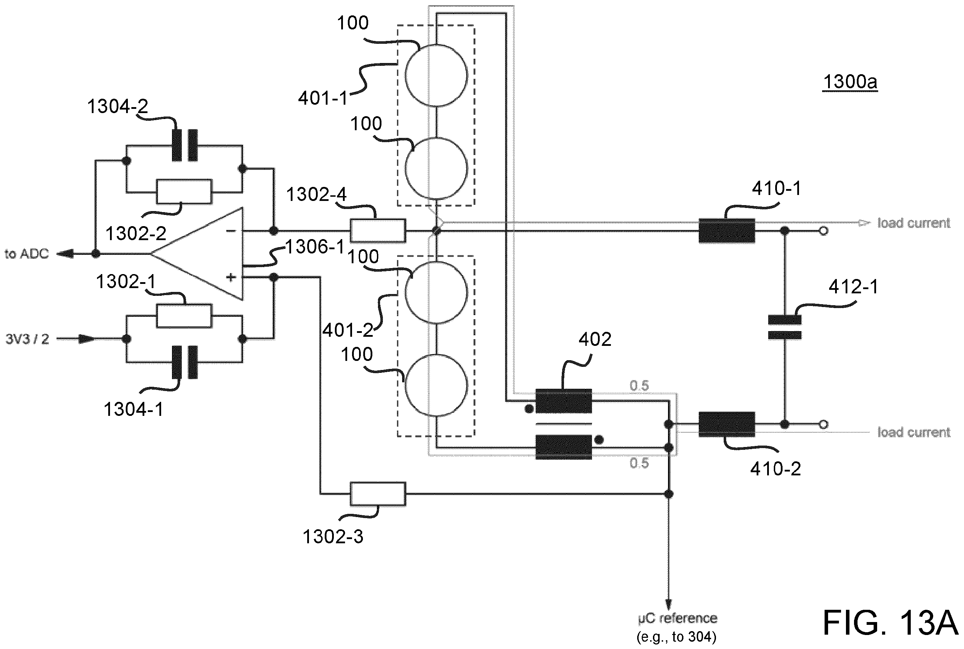

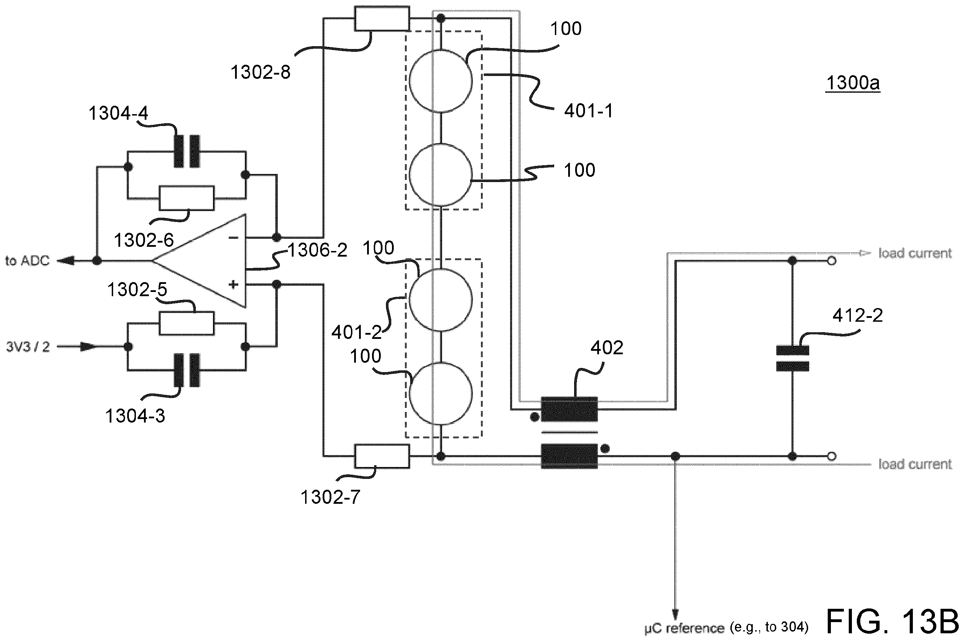

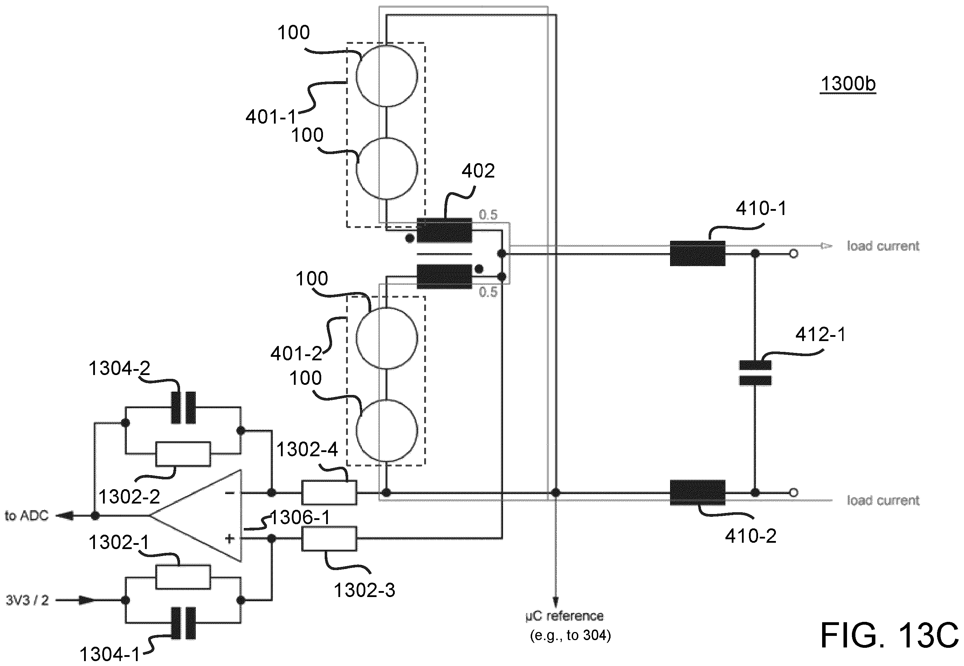

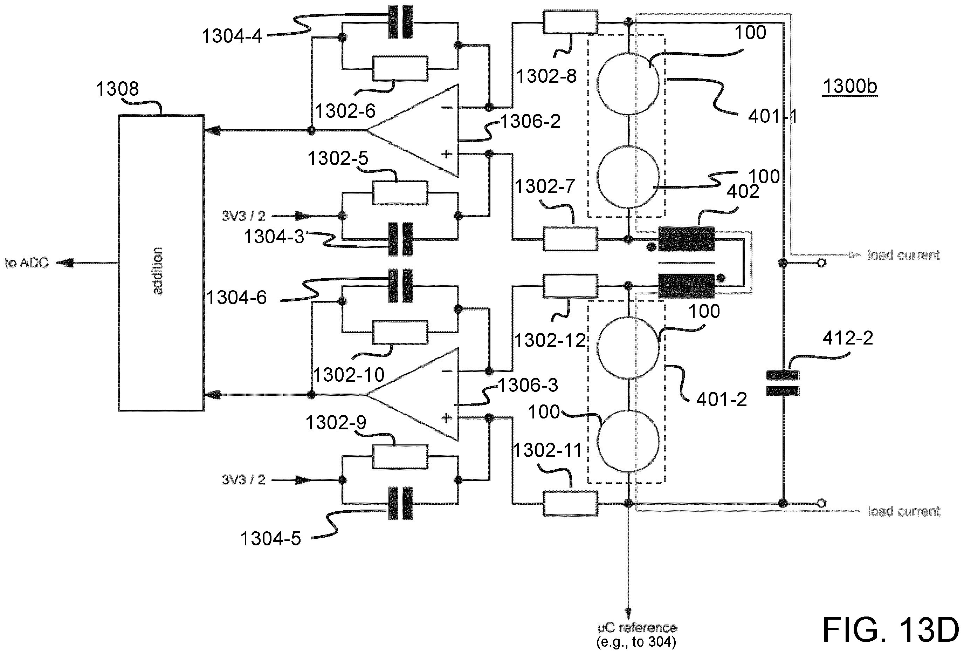

Referring now to FIGS. 13A-13D. shown are circuit diagrams of electrical systems, shown in these examples as power supply systems 1300a and 1300b with voltage sensing, according to some non-limiting embodiments or aspects. For example, as shown in FIGS. 13A and 13B, the choke may be arranged as shown in FIG. 4B. As shown in FIGS. 13C and 13D, the choke may be arranged as shown in FIG. 4A (e.g., center-tapped). In some non-limiting embodiments or aspects, power supply systems 1300a and 1300b may be the same as or similar to power supply system 300. In some non-limiting embodiments or aspects, power supply systems 1300a and 1300b may be the same as or similar to power supply system 400a, 400b, power supply system 500, power supply system 600, power supply system 700, power supply system 800, power supply system 900, and/or power supply system 1000.

With reference to FIGS. 13A and 13B, first set 401-1 of voltage sources (e.g., energy storage modules 100) and second set 401-2 of voltage sources (e.g., energy storage modules 100) may be connected via an inductor (e.g., choke 402). In a first mode of operation, as shown in FIG. 13A, the first set 401-1 and second set 401-2 may be in parallel, as described herein. In a second mode of operation, as shown in FIG. 13B, the first set 401-1 and second set 401-2 may be in series, as described herein.

With reference to FIG. 13A, when in the first mode of operation, first differential amplifier 1306-1 may be configured to measure a total voltage across the parallel-connected first set 401-1 and second set 401-2 of voltage sources (e.g., energy storage modules 100). In some non-limiting embodiments or aspects, resistors 1302 (e.g., first resistor 1302-1, second resistor 1302-2, third resistor 1302-3, and fourth resistor 1302-4) and capacitors 1304 (e.g., first capacitor 1304-1 and second capacitor 1304-2) may be connected to perform filtering and/or determine response of the circuit components, as described herein. For example, capacitors 1304 may filter and/or determine response to high-frequency components of electrical signals, and resistors 1302 may filter and/or determine response to low-frequency components of electrical signals. In some non-limiting embodiments or aspects, the output of first differential amplifier 1306-1 may be connected to an ADC, as described herein.

With reference to FIG. 13B, when in the second mode of operation, second differential amplifier 1306-2 may be configured to measure a total voltage across the series-connected first set 401-1 and second set 401-2 of voltage sources (e.g., energy storage modules 100). In some non-limiting embodiments or aspects, resistors 1302 (e.g., fifth resistor 1302-5, sixth resistor 1302-6, seventh resistor 1302-7, and eighth resistor 1302-8) and capacitors 1304 (e.g., third capacitor 1304-3 and fourth capacitor 1304-4) may be connected to perform filtering and/or determine response of the circuit components, as described herein. For example, capacitors 1304 may filter and/or determine response to high-frequency components of electrical signals, and resistors 1302 may filter and/or determine response to low-frequency components of electrical signals. In some non-limiting embodiments or aspects, the output of second differential amplifier 1306-2 may be connected to an ADC, as described herein.

With reference to FIGS. 13C and 13D, first set 401-1 of voltage sources (e.g., energy storage modules 100) and a second set 401-2 of voltage sources (e.g., energy storage modules 100) may be connected via an inductor (e.g., choke 402). In a first mode of operation, as shown in FIG. 13C, the first set 401-1 and second set 401-2 may be in parallel, as described herein. In a second mode of operation, as shown in FIG. 13D, the first set 401-1 and second set 401-2 may be in series, as described herein.

With reference to FIG. 13C, when in the first mode of operation, first differential amplifier 1306-1 may be configured to measure a total voltage across the parallel-connected first set 401-1 and second set 401-2 of voltage sources (e.g., energy storage modules 100). In some non-limiting embodiments or aspects, resistors 1302 (e.g., first resistor 1302-1, second resistor 1302-2, third resistor 1302-3, and fourth resistor 1302-4) and capacitors 1304 (e.g., first capacitor 1304-1 and second capacitor 1304-2) may be connected to perform filtering and/or determine response of the circuit components, as described herein. For example, capacitors 1304 may filter and/or determine response to high-frequency components of electrical signals, and resistors 1302 may filter and/or determine response to low-frequency components of electrical signals. In some non-limiting embodiments or aspects, the output of first differential amplifier 1306-1 may be connected to an ADC, as described herein.

With reference to FIG. 13D, when in the second mode of operation, the inductor (e.g., choke 402) is disposed in a series connection between first set 401-1 and second set 401-2. As such, the inductor may introduce a phase shift and/or otherwise make direct measurement of voltage across the series-connected first set 401-1 and the second set 401-2 difficult /or unsuitable for control of the circuitry (e.g., for control circuitry, such as system controller 304 and/or module controller 103 that controls energy storage components 100). To address this and effectively measure voltage before the inductor (e.g., choke 402), second differential amplifier 1306-2 may be configured to measure a first voltage across first set 401-1 of voltage sources (e.g., energy storage modules) to generate a first signal (e.g., at the output of second differential amplifier 1306-2), and/or third differential amplifier 1306-3 may be configured to measure a second voltage across second set 401-2 of voltage sources (e.g., energy storage modules 100) to generate a second signal (e.g., at the output of third differential amplifier 1306-3).

In some non-limiting embodiments or aspects, resistors 1302 (e.g., fifth resistor 1302-5, sixth resistor 1302-6, seventh resistor 1302-7, and eighth resistor 1302-8 for second differential amplifier 1306-2 and/or ninth resistor 1302-9, tenth resistor 1302-10, eleventh resistor 1302-11, and twelfth resistor 1302-12 for third differential amplifier 1306-3) and capacitors 1304 (e.g., third capacitor 1304-3 and fourth capacitor 1304-4 for second differential amplifier 1306-2 and/or fifth capacitor 1304-5 and sixth capacitor 1304-6 for third differential amplifier 1306-3) may be connected to perform filtering and/or determine response of the circuit components, as described herein. For example, capacitors 1304 may filter and/or determine response to high-frequency components of electrical signals, and resistors 1302 may filter and/or determine response to low-frequency components of electrical signals.

In some non-limiting embodiments or aspects, the outputs of at least one of second differential amplifier 1306-2 and/or third differential amplifier 1306-3 may be connected to an ADC, as described herein. For example, as shown in FIG. 13D, the outputs of second differential amplifier 1306-2 and third differential amplifier 1306-3 may be connected to circuitry 1308 (e.g., addition circuitry, such as analog components configured to add the signals generated by the outputs of second differential amplifier 1306-2 and third differential amplifier 1306-3, digital components configured to add the signals generated by the outputs of second differential amplifier 1306-2 and third differential amplifier 1306-3, any combination thereof and/or the like. In some non-limiting embodiments or aspects, the output of circuitry 1308 may be connected to an ADC, as described herein.

In some non-limiting embodiments or aspects, circuitry 1308 may include an additional amplifier (e.g., op-amp), which may be configured to additively combine the output of second differential amplifier 1306-2 and third differential amplifier 1306-3.

In some non-limiting embodiments or aspects, circuitry 1308 may be configured to convert at least one analog voltage signal (e.g., the output of any of first differential amplifier 1306-1, second differential amplifier 1306-2, and/or third differential amplifier 1306-3) to at least one digital output. For example, circuitry 1308 may convert the output of second differential amplifier 1306-2 to a (second) digital output and/or convert the output of third differential amplifier 1306-3 to a (third) digital output.

In some non-limiting embodiments or aspects, circuitry 1308 may remove a DC offset from each digital output to provide a respective intermediate digital output (e.g., a second intermediate digital output and/or a third intermediate digital output). Additionally or alternatively, circuitry 1308 may additively combine the digital outputs (e.g., sum the second digital output and/or the third digital output, sum the second intermediate digital output and the third intermediate digital output, and/or the like).

In some non-limiting embodiments or aspects, circuitry (e.g., circuitry 1308, the ADC(s), system controller 304, module controllers 103, any combination thereof, and/or the like) may be configured to monitor an output voltage of the power supply system. For example, the circuitry (e.g., circuitry 1308, the ADC(s), system controller 304, module controllers 103, any combination thereof, and/or the like) may be configured to evaluate a total voltage signal based on a first signal (e.g., the output from second differential amplifier 1306-2) and a second signal (e.g., the output from third differential amplifier 1306-3). Additionally or alternatively, the circuitry (e.g., circuitry 1308, the ADC(s), system controller 304, module controllers 103, any combination thereof, and/or the like) may be configured to calculate the output voltage from the total voltage signal (and/or from at least one of the first signal, the second signal, or any combination thereof).

In some non-limiting embodiments or aspects, the circuitry (e.g., circuitry 1308, the ADC(s), system controller 304, module controllers 103, any combination thereof, and/or the like) may be configured to control the output voltage based on the total voltage signal and/or the calculated output voltage. For example, the circuitry (e.g., circuitry 1308, the ADC(s), system controller 304, module controllers 103, any combination thereof, and/or the like) may be configured to control energy storage modules 100 of the first set 401-1 and the second set 401-2 based on the total voltage signal and/or the calculated output voltage.

With reference to FIGS. 13A-13D, in some non-limiting embodiments or aspects, a fixed reference voltage may be provided to at least one of the differential amplifiers (e.g., first differential amplifier 1306-1, second differential amplifier 1306-2, third differential amplifier 1306-3, or any combination thereof). For example, the fixed reference voltage may be substantially half (e.g., half, essentially half, approximately half, within a tolerance range of half, and/or the like) of a reference voltage of an ADC. As shown in FIGS. 13A-13D, for example, the reference voltage of an ADC may be 3.3V, and the fixed reference voltage may be 3.3 V/2 = 1.65 V (indicated as 3V3 / 2 in the drawings) may be provided to first differential amplifier 1306-1, second differential amplifier 1306-2, and third differential amplifier 1306-3.

In some non-limiting embodiments or aspects, each differential amplifier (e.g., first differential amplifier 1306-1, second differential amplifier 1306-2, and third differential amplifier 1306-3) may include an operational amplifier (op-amp) with appropriate resistors 1302 (e.g., feedback resistors) connected thereto. For example, referring to FIGS. 13A and 13C, first differential amplifier 1306-1 (e.g., a first op-amp) may have feedback resistor 1302-1 and feedback resistor 1302-2 as well as input resistor 1302-3 and input resistor 1302-4. The output of first differential amplifier 1306-1 (e.g., a first op-amp) may be based on the values of the resistors (e.g., the ratio of the value of feedback resistor 1302-2 to the value of input resistor 1302-4) and the voltage at the inputs to first differential amplifier 1306-1 (e.g., a difference between the voltages at the first and second inputs of first differential amplifier 1306-1).

For example, referring to FIGS. 13B and 13D, second differential amplifier 1306-2 (e.g., a second op-amp) may have feedback resistor 1302-5 and feedback resistor 1302-6 as well as input resistor 1302-7 and input resistor 1302-8. The output of second differential amplifier 1306-2 (e.g., a second op-amp) may be based on the values of the resistors (e.g., the ratio of the value of feedback resistor 1302-6 to the value of input resistor 1302-8) and the voltage at the inputs to second differential amplifier 1306-2 (e.g., a difference between the voltages at the first and second inputs of second differential amplifier 1306-2). Third differential amplifier 1306-3 (e.g., a third op-amp) may have feedback resistor 1302-9 and feedback resistor 1302-10 as well as input resistor 1302-11 and input resistor 1302-12. The output of third differential amplifier 1306-3 (e.g., a third op-amp) may be based on the values of the resistors (e.g., the ratio of the value of feedback resistor 1302-10 to the value of input resistor 1302-12) and the voltage at the inputs to third differential amplifier 1306-3 (e.g., a difference between the voltages at the first and second inputs of third differential amplifier 1306-3).

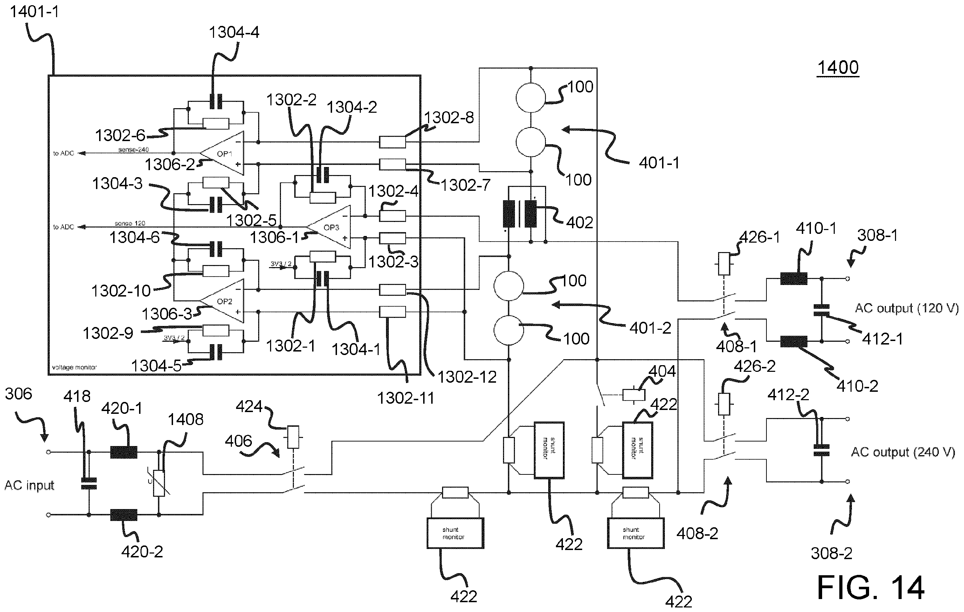

Referring now to FIG. 14, shown is a circuit diagram of an electrical system, shown in this example as a power supply system 1400, according to some non-limiting embodiments or aspects. In some non-limiting embodiments or aspects, power supply system 1400 may be the same as or similar to power supply system 300. In some non-limiting embodiments or aspects, power supply system 1400 may be the same as or similar to power supply system 400a, power supply system 500, power supply system 600, power supply system 700, power supply system 800, power supply system 900, power supply system 1000, and/or power supply system 1300b.

As shown in FIG. 14, first set 401-1 of voltage sources (e.g., energy storage modules 100) and a second set 401-2 of voltage sources (e.g., energy storage modules 100) may be connected via an inductor (e.g., choke 402). In a first mode of operation (e.g., when switch 404 is in a first state), the first set 401-1 and second set 401-2 may be in parallel, as described herein. In a second mode of operation (e.g., when switch 404 is in a second stage), the first set 401-1 and second set 401-2 may be in series, as described herein. In some non-limiting embodiments or aspects, to operate in a third mode of operation (e.g., a charging mode of operation), input switch 424 at input 406 may be switched to a first state (e.g., closed, activated, and/or the like), and/or switch 404 may be in a second state (e.g., open state, deactivated state, and/or the like) during the third (e.g., charging) mode of operation, as described herein. In some non-limiting embodiments or aspects, first voltage monitor circuitry 1401-1 may be included to monitor output voltage in the first and second modes of operation. Additionally or alternatively, second voltage monitor circuitry 1401-2 may be included to monitor input voltage in the third mode of operation (e.g., charging).

When in the first mode of operation, first differential amplifier 1306-1 may be configured to measure a total voltage across the parallel-connected first set 401-1 and second set 401-2 of voltage sources (e.g., energy storage modules 100).

When in the second mode of operation, the inductor (e.g., choke 402) may be disposed in a series connection between first set 401-1 and second set 401-2. As such, the inductor may introduce a phase shift and/or otherwise make direct measurement of voltage across the series-connected first set 401-1 and the second set 401-2 difficult /or unsuitable for control of the circuitry (e.g., for control circuitry, such as system controller 304 and/or module controller 103 that controls energy storage components 100). To address this and effectively measure voltage before the inductor (e.g., choke 402), second differential amplifier 1306-2 may be configured to measure a first voltage across first set 401-1 of voltage sources (e.g., energy storage modules) to generate a first signal (e.g., at the output of second differential amplifier 1306-2), and/or third differential amplifier 1306-3 may be configured to measure a second voltage across second set 401-2 of voltage sources (e.g., energy storage modules 100) to generate a second signal (e.g., at the output of third differential amplifier 1306-3).

In some non-limiting embodiments or aspects, a fixed reference voltage may be provided to at least one of the differential amplifiers (e.g., first differential amplifier 1306-1, second differential amplifier 1306-2, third differential amplifier 1306-3, or any combination thereof). For example, the fixed reference voltage may be substantially half (e.g., half, essentially half, approximately half, within a tolerance range of half, and/or the like) of a reference voltage of an ADC, as described herein. As shown in FIG. 14, the fixed reference voltage may be provided as input to first differential amplifier 1306-1 and third differential amplifier 1306-3.

In some non-limiting embodiments or aspects, the output of third differential amplifier 1306-3 may be connected as a reference voltage to an input of second differential amplifier 1306-2, as described herein. As such, the resulting output of second differential amplifier 1306-2 may be proportionate to the combination (e.g., sum) of voltages of the first set 401-1 and second set 401-2 of voltage sources (e.g., energy storage modules 100). For example, the resulting output of second differential amplifier 1306-2 may be scaled to be between 0 V and the reference voltage of the ADC (e.g., 3.3 V), and/or may be centered around the fixed reference voltage (e.g., 1.65 V = 3.3 V/2). By connecting the output of third differential amplifier 1306-3 as a reference voltage to an input of second differential amplifier 1306-2 in this manner, resources may be conserved, for example, because a single measurement channel (e.g., ADC channel) may be used to measure the output voltage in the second mode of operation (e.g., as opposed to two ADC channels, with one for second differential amplifier 1306-2 and one for third differential amplifier 1306-3). For example, the output of second differential amplifier 1306-2 when connected in this manner may be the sum of what would otherwise be (e.g., if not connected in this manner) a first signal (e.g., the output of second differential amplifier 1306-2 based on voltage measured across first set 401-1 of voltage sources) and a second signal (e.g., the output of third differential amplifier 1306-3 based on voltage measured across second set 401-2 of voltage sources) centered around the fixed reference voltage (e.g., 1.65 V = 3.3 V/2), and this output of second differential amplifier 1306-2 when connected in this manner may be input directly into an ADC.

In some non-limiting embodiments or aspects, the output of first differential amplifier 1306-1 and the output of second differential amplifier 1306-2 may be connected to an ADC, as described herein. In some non-limiting embodiments or aspects, the outputs of first differential amplifier 1306-1 and/or second differential amplifier 1306-2 may be connected to the ADC via an analog multiplexer (MUX) (not shown). In some non-limiting embodiments or aspects, the outputs of first differential amplifier 1306-1 and/or second differential amplifier 1306-2 may be connected to the ADC directly (e.g., without an analog MUX). For example, the output of first differential amplifier 1306-1 may be connected to an ADC channel (e.g., first ADC channel) and the output of second differential amplifier 1306-2 may be connected to another ADC channel (e.g., second ADC channel).

In some non-limiting embodiments or aspects, circuitry (e.g., the ADC(s), system controller 304, module controllers 103, any combination thereof, and/or the like) may be configured to monitor an output voltage of the power supply system. For example, the circuitry (e.g., the ADC(s), system controller 304, module controllers 103, any combination thereof, and/or the like) may be configured to evaluate a total voltage signal based on the output of first differential amplifier 1306-1 in the first mode of operation and/or the output of second differential amplifier 1306-2 in the second mode of operation. Additionally or alternatively, the circuitry (e.g., the ADC(s), system controller 304, module controllers 103, any combination thereof, and/or the like) may be configured to calculate the output voltage from the voltage signals (e.g., the output of first differential amplifier 1306-1 in the first mode of operation and/or the output of second differential amplifier 1306-2 in the second mode of operation).

In some non-limiting embodiments or aspects, the circuitry (e.g., the ADC(s), system controller 304, module controllers 103, any combination thereof, and/or the like) may be configured to control the output voltage based on the calculated output voltage (e.g., based on the output of first differential amplifier 1306-1 in the first mode of operation and/or the output of second differential amplifier 1306-2 in the second mode of operation). For example, the circuitry (e.g., the ADC(s), system controller 304, module controllers 103, any combination thereof, and/or the like) may be configured to control energy storage modules 100 of the first set 401-1 and the second set 401-2 based on the calculated output voltage.

In some non-limiting embodiments or aspects, at least one of the differential amplifiers (e.g., first differential amplifier 1306-1, second differential amplifier 1306-2, third differential amplifier 1306-3, or any combination thereof) may be configured to perform a filtering operation. For example, the filtering operation may include a low-pass filtering operation. In some non-limiting embodiments or aspects, resistors 1302 (e.g., first resistor 1302-1, second resistor 1302-2, third resistor 1302-3, and fourth resistor 1302-4 for first differential amplifier 1306-1, fifth resistor 1302-5, sixth resistor 1302-6, seventh resistor 1302-7, and eighth resistor 1302-8 for second differential amplifier 1306-2, and/or ninth resistor 1302-9, tenth resistor 1302-10, eleventh resistor 1302-11, and twelfth resistor 1302-12 for third differential amplifier 1306-3) and capacitors 1304 (e.g., first capacitor 1304-1 and second capacitor 1304-2 for first differential amplifier 1306-1, third capacitor 1304-3 and fourth capacitor 1304-4 for second differential amplifier 1306-2 and/or fifth capacitor 1304-5 and sixth capacitor 1304-6 for third differential amplifier 1306-3) may be connected to perform filtering and/or determine response of the circuit components, as described herein. For example, capacitors 1304 may filter and/or determine response to high-frequency components of electrical signals, and resistors 1302 may filter and/or determine response to low-frequency components of electrical signals. As such, the differential amplifier(s) may simultaneously perform filtering and/or anti-aliasing operations prior to feeding signal(s) to the ADC.

In some non-limiting embodiments or aspects, the output voltage (e.g., at first output 408-1 and/or second output 408-2) may be provided by at least some voltage sources (e.g., energy storage modules 100) from the first set 401-1 and/or the second set 401-2.

In some non-limiting embodiments or aspects, evaluating the total voltage signal may include inputting the output of second differential amplifier 1306-2 to the ADC. In some non-limiting embodiments or aspects, the total voltage signal (e.g., the output of second differential amplifier 1306-2) may include a sum based on the voltages of first set 401-1 (e.g., a first signal) and second set 401-2 (e.g., a second signal).

In some non-limiting embodiments or aspects, the output voltage may be calculated without measuring a voltage at an output (e.g., first output 408-1, second output 408-2, first output connection 308-1, and/or second output connection 308-2). For example, the output voltage may be calculated based on the outputs of the differential amplifier(s), as described herein, without measuring a voltage at the output(s) power supply system 1400.

In some non-limiting embodiments or aspects, the fixed reference voltage may be connected to a first input of third differential amplifier 1306-3 via fifth capacitor 1304-5 and ninth resistor 1302-9. An output of third differential amplifier 1306-3 may be connected to a second input of third differential amplifier 1306-3 via sixth capacitor 1304-6 and a tenth resistor 1302-10. The output of third differential amplifier 1306-3 may be connected to a first input of second differential amplifier 1306-2 via third capacitor 1304-3 and fifth resistor 1302-5. An output of second differential amplifier 1306-2 may be connected to a second input of second differential amplifier 1306-2 via fourth capacitor 1304-4 and sixth resistor 1302-6.

In some non-limiting embodiments or aspects, a first side of first set 401-1 may be connected to the first input of second differential amplifier 1306-2 via at least one seventh resistor 1302-7, and a second side of first set 401-1 may be connected to the second input of second differential amplifier 1306-2 via at least one eight resistor 1302-8. In some non-limiting embodiments or aspects, a first side of second set 401-2 may be connected to the first input of third differential amplifier 1306-3 via at least one eleventh resistor 1302-11, and a second side of second set 401-2 may be connected to the second input of third differential amplifier 1306-3 via at least one twelfth resistor 1302-12.

In some non-limiting embodiments or aspects, the first side of first set 401-1 may be connected to a first winding of choke 402. The second side of second set 401-2 may be connected to a second winding of choke 402.

In some non-limiting embodiments or aspects, switch 404 may be configured to switch between a first state associated with the first mode of operation and a second state associated with the second mode of operation, as described herein. In some non-limiting embodiments or aspects, upon switching switch 404 to the first state, first set 401-1 is connected in parallel with second set 401-2, and the circuitry (e.g., analog MUX1309, the ADC(s), system controller 304, module controllers 103, any combination thereof, and/or the like) may be configured to measure the output voltage based on the output of first differential amplifier 1306-1. Upon switching switch 404 to the second state, first set 401-1 may be connected in series with second set 401-2, and the circuitry (e.g., analog MUX1309, the ADC(s), system controller 304, module controllers 103, any combination thereof, and/or the like) may be configured to measure the voltage based on the output of second differential amplifier 1306-2.

In some non-limiting embodiments or aspects, an additional amplifier (e.g., op-amp) may be configured to additively combine the output of second differential amplifier 1306-2 and third differential amplifier 1306-3 (e.g., rather than connecting the output of third differential amplifier 1306-3 as a reference voltage/input to second differential amplifier 1306-2).

In some non-limiting embodiments or aspects, the ADC(s) may be configured to convert at least one analog voltage signal (e.g., the output of any of first differential amplifier 1306-1, second differential amplifier 1306-2, and/or third differential amplifier 1306-3) to at least one digital output. For example, the ADC(s) may convert the output of first differential amplifier 1306-1 to a first digital output and/or convert the output of second differential amplifier 1306-2 to a second digital output.

In some non-limiting embodiments or aspects, thermistor 1408 may be connected to input 406.

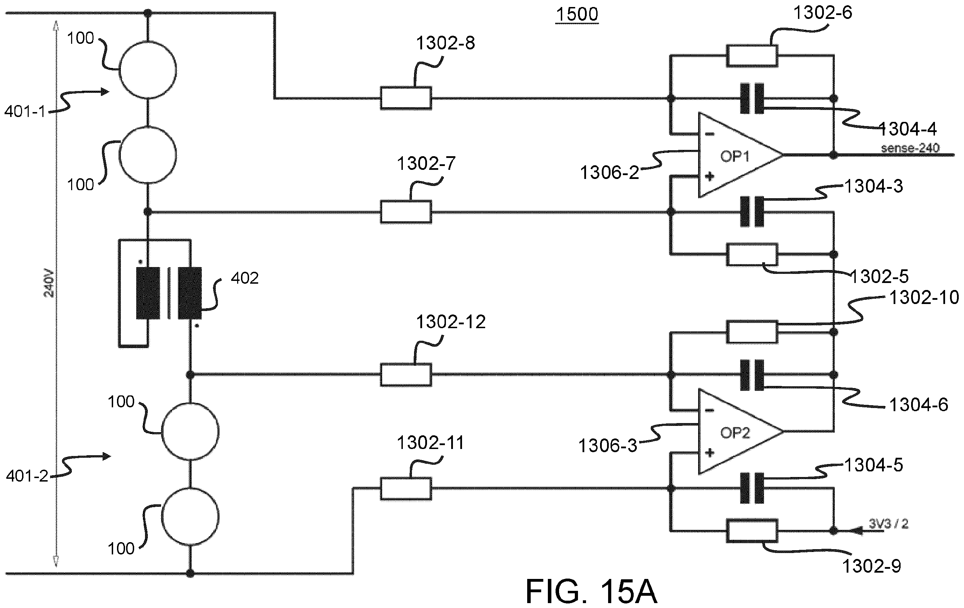

Referring now to FIGS. 15A-15C, shown are circuit diagrams of an example power supply system 1500 with voltage sensing, according to some non-limiting embodiments or aspects. In some non-limiting embodiments or aspects, power supply system 1500 may be the same as or similar to power supply system 300. In some non-limiting embodiments or aspects, power supply system 1500 may be the same as or similar to power supply system 400a, power supply system 500, power supply system 600, power supply system 700, power supply system 800, power supply system 900, power supply system 1000, power supply system 1300b, and/or power supply system 1400. In some non-limiting embodiments or aspects, power supply 1500 may be operating in a second mode of operation, in which the first set 401-1 and second set 401-2 may be in series, as described herein.

In some non-limiting embodiments or aspects, filtering operations performed by the differential amplifier(s) (e.g., second differential amplifier 1306-2 and/or third differential amplifier 1306-6) may be based on the resistors and/or the capacitors connected thereto.

A first configuration, as shown in FIG. 15A, may include seventh resistor 1302-7 and eighth resistor 1302-8 connected between first set 401-1 and second differential amplifier 1306-2. Additionally, zero capacitors may be connected between these resistors (e.g., seventh resistor 1302-7 and eighth resistor 1302-8) and second differential amplifier 1306-2. Eleventh resistor 1302-11 and twelfth resistor 1302-12 may be connected between second set 401-2 and third differential amplifier 1306-3. Additionally, zero capacitors may be connected between these resistors (e.g., eleventh resistor 1302-11 and twelfth resistor 1302-12) and third differential amplifier 1306-3.

In some non-limiting embodiments or aspects, resistors (e.g., seventh resistor 1302-7 and eighth resistor 1302-8) may be connected to perform filtering and/or determine response of the circuit components, as described herein. For example, capacitors may filter and/or determine response to high-frequency components of electrical signals, and resistors may filter and/or determine response to low-frequency components of electrical signals. For example, in the first configuration as shown in FIG. 15A, the frequency response of the circuit may be that of a first-order low-pass filter.

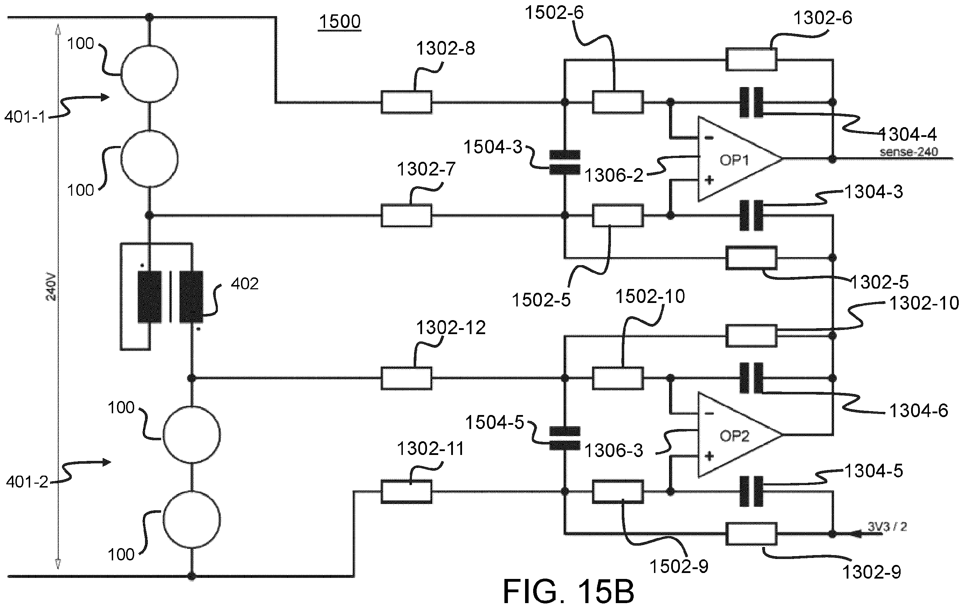

A second configuration, as shown in FIG. 15B, may include additional resistors 1502-5 and 1502-6 between the respective resistors (e.g., seventh resistor 1302-7 and eighth resistor 1302-8) and second differential amplifier 1306-2. Additionally, capacitor 1504-3 may be connected between the upper resistors (e.g., eighth resistor 1302-8 and additional resistor 1502-6) and lower resistors (e.g., seventh resistor 1302-7 and additional resistor 1502-5). Also, additional resistors 1502-9 and 1502-10 may be connected between the respective resistors (e.g., eleventh resistor 1302-11 and twelfth resistor 1302-12) and third differential amplifier 1306-3. Additionally, capacitor 1504-5 may be connected between the upper resistors (e.g., twelfth resistor 1302-12 and additional resistor 1502-10) and lower resistors (e.g., eleventh resistor 1302-1 and additional resistor 1502-9).

In some non-limiting embodiments or aspects, resistors (e.g., seventh resistor 1302-7, eighth resistor 1302-8, resistor 1502-5, and resistor 1502-6 for second differential amplifier 1306-2 and eleventh resistor 1302-11, twelfth resistor 1302-12, resistor 1502-9, and resistor 1502-10 for third differential amplifier 1306-3) and capacitor(s) (e.g., capacitor 1504-3 for second differential amplifier 1306-2 and capacitor 1504-5 for third differential amplifier 1306-3) may be connected to perform filtering and/or determine response of the circuit components, as described herein. For example, capacitors may filter and/or determine response to high-frequency components of electrical signals, and resistors may filter and/or determine response to low-frequency components of electrical signals. For example, in the second configuration as shown in FIG. 15B, the frequency response of the circuit may be that of a second-order low-pass filter.

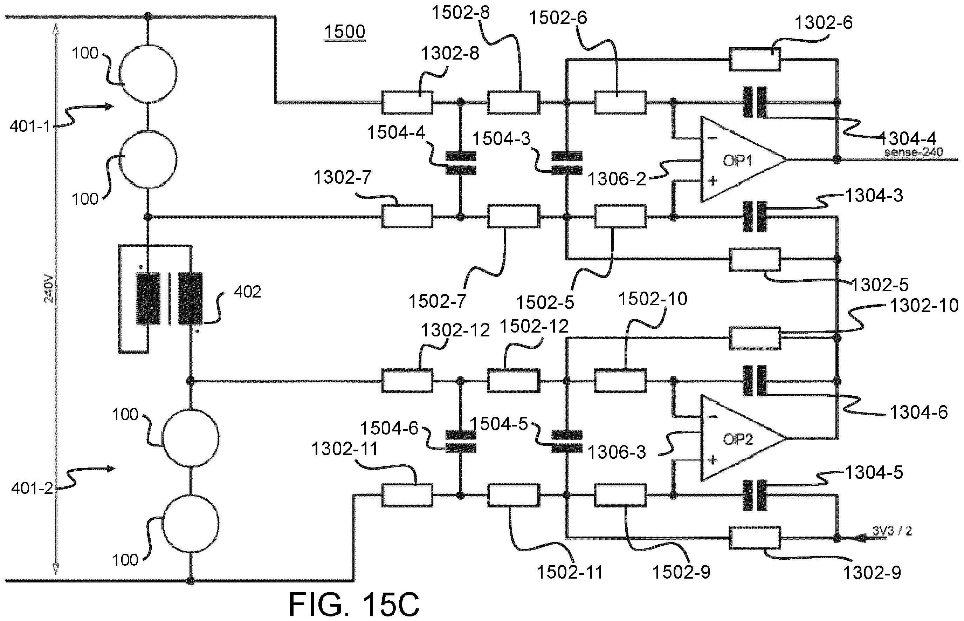

A third configuration, as shown inf FIG. 15C, includes additional resistors 1502-7 and 1502-8 and capacitor 1504-4 (e.g., for second differential amplifier 1306-2). Also, additional resistors 1502-11 and 1502-12 and capacitor 1504-6 may be included (e.g., for third differential amplifier 1306-3).

In some non-limiting embodiments or aspects, resistors (e.g., seventh resistor 1302-7, eighth resistor 1302-8, resistor 1502-5, resistor 1502-6, resistor 1502-7, and resistor 1502-8 for second differential amplifier 1306-2 and eleventh resistor 1302-11, twelfth resistor 1302-12, resistor 1502-9, resistor 1502-10, resistor 1502-11, and resistor 1502-12 for third differential amplifier 1306-3) and capacitor(s) (e.g., capacitor 1504-3 and capacitor 1504-4 for second differential amplifier 1306-2 and capacitor 1504-5 and capacitor 1504-6 for third differential amplifier 1306-3) may be connected to perform filtering and/or determine response of the circuit components, as described herein. For example, capacitors may filter and/or determine response to high-frequency components of electrical signals, and resistors may filter and/or determine response to low-frequency components of electrical signals. For example, in the third configuration as shown in FIG. 15C, the frequency response of the circuit may be that of a third-order low-pass filter.

With reference to FIGS. 15A-15C, the order of filtering may be selected, e.g., to achieve a target response. For example, a lower order of filtering may be selected (e.g., to reduce resources, reduce waste, and/or reduce cost) if the response achieved by the lower order of filtering is sufficient (e.g., within a target range, allows for the system to perform satisfactorily and/or without a tolerance range, and/or the like). A higher order of filtering may be selected if one or more lower orders of filtering do not achieve response that is sufficient.

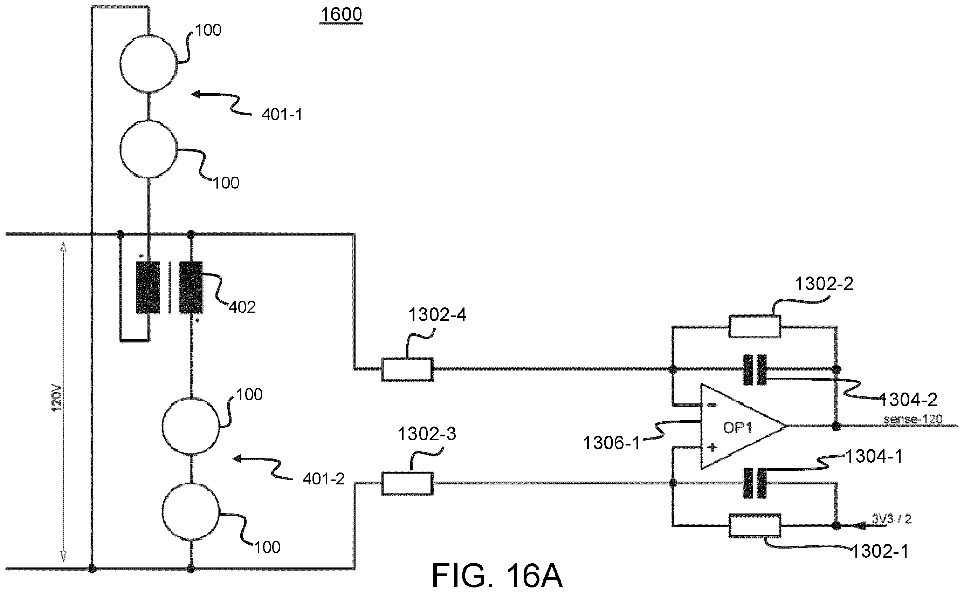

Referring now to FIGS. 16A-16C, shown are circuit diagrams of an example power supply system 1600 with voltage sensing, according to some non-limiting embodiments or aspects. In some non-limiting embodiments or aspects, power supply system 1600 may be the same as or similar to power supply system 300. In some non-limiting embodiments or aspects, power supply system 1600 may be the same as or similar to power supply system 400a, power supply system 500, power supply system 600, power supply system 700, power supply system 800, power supply system 900, power supply system 1000, power supply system 1300b, power supply system 1400, and/or power supply system 1500. In some non-limiting embodiments or aspects, power supply 1600 may be operating in a first mode of operation, in which the first set 401-1 and second set 401-2 may be in parallel, as described herein.

In some non-limiting embodiments or aspects, filtering operations performed by the differential amplifier(s) (e.g., first differential amplifier 1306-1) may be based on the resistors and/or the capacitors connected thereto.

A first configuration, as shown in FIG. 16A, may include third resistor 1302-3 and fourth resistor 1302-4 connected between first differential amplifier 1306-1 and first set 401-1 and second set 401-2. Additionally, zero capacitors may be connected between these resistors (e.g., third resistor 1302-3 and fourth resistor 1302-4) and first differential amplifier 1306-1.

In some non-limiting embodiments or aspects, resistors (e.g., third resistor 1302-3 and fourth resistor 1302-4) may be connected to perform filtering and/or determine response of the circuit components, as described herein. For example, capacitors may filter and/or determine response to high-frequency components of electrical signals, and resistors may filter and/or determine response to low-frequency components of electrical signals. For example, in the first configuration as shown in FIG. 16A, the frequency response of the circuit may be that of a first-order low-pass filter.

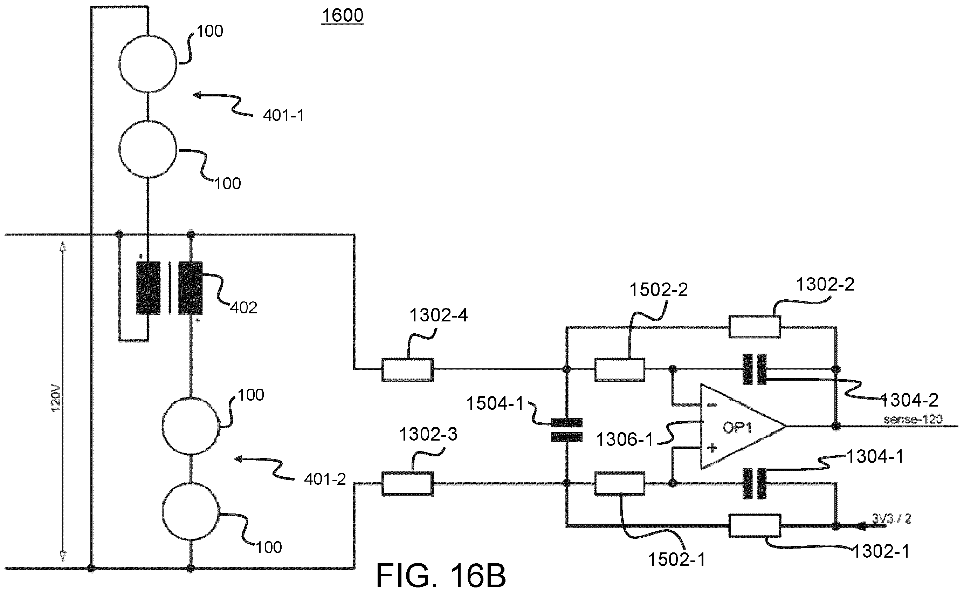

A second configuration, as shown in FIG. 16B, may include additional resistors 1502-1 and 1502-2 and capacitor 1504-1. In some non-limiting embodiments or aspects, resistors (e.g., third resistor 1302-3, fourth resistor 1302-4, resistor 1502-1, and resistor 1502-2) and capacitor(s) (e.g., capacitor 1504-1) may be connected to perform filtering and/or determine response of the circuit components, as described herein. For example, capacitors may filter and/or determine response to high-frequency components of electrical signals, and resistors may filter and/or determine response to low-frequency components of electrical signals. For example, in the second configuration as shown in FIG. 16B, the frequency response of the circuit may be that of a second-order low-pass filter.

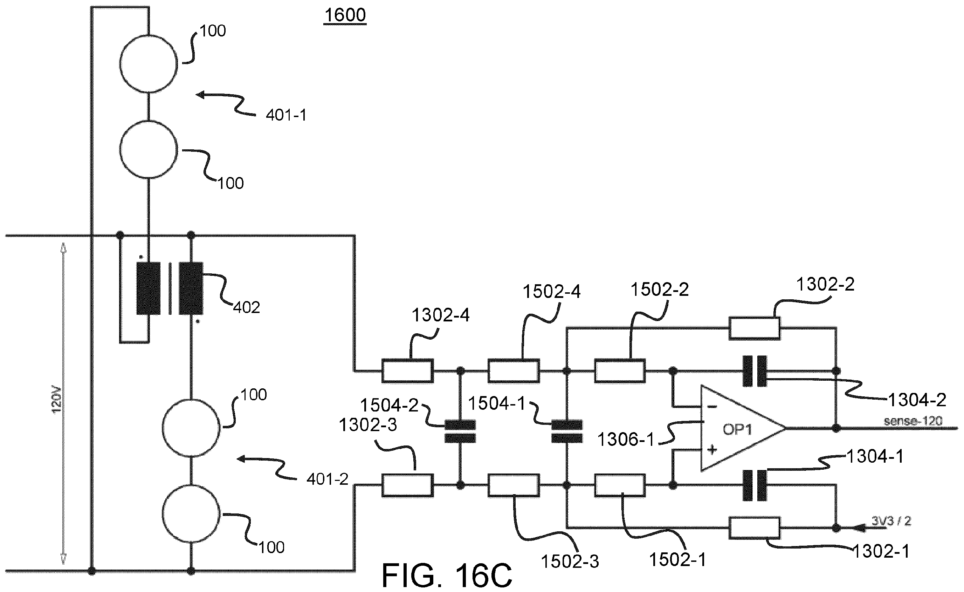

A third configuration, as shown in FIG. 16C, may include additional resistors 1502-3 and 1502-4 and capacitor 1504-2. In some non-limiting embodiments or aspects, resistors (e.g., third resistor 1302-3, fourth resistor 1302-4, resistor 1502-1, resistor 1502-2, resistor 1502-3, and resistor 1502-4) and capacitor(s) (e.g., capacitor 1504-1 and capacitor 1504-2) may be connected to perform filtering and/or determine response of the circuit components, as described herein. For example, capacitors may filter and/or determine response to high-frequency components of electrical signals, and resistors may filter and/or determine response to low-frequency components of electrical signals. For example, in the third configuration as shown in FIG. 16C, the frequency response of the circuit may be that of a third-order low-pass filter.

With reference to FIGS. 16A-16C, the order of filtering may be selected, e.g., to achieve a target response. For example, a lower order of filtering may be selected (e.g., to reduce resources, reduce waste, and/or reduce cost) if the response achieved by the lower order of filtering is sufficient (e.g., within a target range, allows for the system to perform satisfactorily and/or without a tolerance range, and/or the like). A higher order of filtering may be selected if one or more lower orders of filtering do not achieve response that is sufficient.

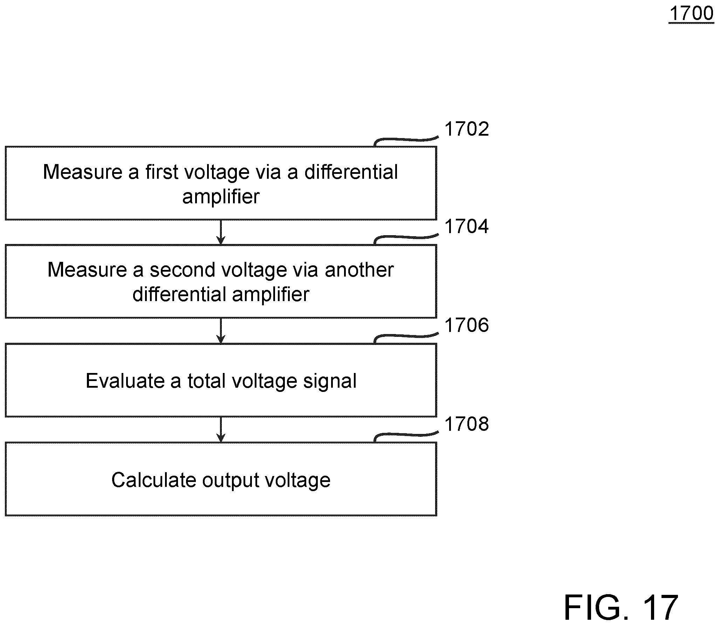

Referring now to FIG. 17, shown is a flow diagram of an example method 1700 of monitoring voltages of a power supply system, according to some non-limiting embodiments or aspects. The steps shown in FIG. 17 are for example purposes only. It will be appreciated that additional, fewer, different, and/or a different order of steps may be used in some non-limiting embodiments or aspects. In some non-limiting embodiments or aspects, a step may be automatically performed in response to performance and/or completion of a prior step. In some non-limiting embodiments or aspects, one or more of the steps of method 1700 may be performed (e.g., completely, partially, and/or the like) by system controller 304. In some non-limiting embodiments or aspects, one or more of the steps of method 1700 may be performed (e.g., completely, partially, and/or the like) by another system, another device, another group of systems, or another group of devices, separate from or including system controller 304, such as module controller 103, energy storage module 100, power supply system 300, and/or the like.

As shown in FIG. 17, at step 1702, method 1700 may include measuring a first voltage via a differential amplifier. For example, second differential amplifier 1306-2 may measure a first voltage across first set 401-1 of voltage sources to generate a first signal, as described herein.

As shown in FIG. 17, at step 1704, method 1700 may include measuring a second voltage via another differential amplifier. For example, third differential amplifier 1306-3 may measure a second voltage across the second set 401-2 of voltage sources to generate a second signal, as described herein.

As shown in FIG. 17, at step 1706, method 1700 may include evaluating a total voltage signal. For example, circuitry (e.g., the ADC(s), system controller 304, module controllers 103, any combination thereof, and/or the like) may evaluate a total voltage signal based on the first signal and the second signal, as described herein.

As shown in FIG. 17, at step 1708, method 1700 may include calculating the output voltage. For example, circuitry (e.g., the ADC(s), system controller 304, module controllers 103, any combination thereof, and/or the like) may calculate the output voltage from the total voltage signal, as described herein.

Further non-limiting embodiments or aspects are set forth in the following numbered clauses:
Clause 1: A method for monitoring an output voltage of a power circuit comprising a first set of voltage sources and a second set of voltage sources, wherein the first set of voltage sources and the second set of voltage sources are connected via an inductor, wherein in a mode of operation the inductor is disposed in a series connection between the first set of voltage sources and the second set of voltage sources, the method comprising: measuring, via a first differential amplifier, a first voltage across the first set of voltage sources to generate a first signal; measuring, via a second differential amplifier, a second voltage across the second set of voltage sources to generate a second signal; evaluating a total voltage signal based on the first signal and the second signal; and calculating the output voltage from the total voltage signal.
Clause 2: The method of clause 1, further comprising controlling the output voltage based on the total voltage signal.
Clause 3: The method of clause 1 or clause 2, further comprising providing a fixed reference voltage to at least one of the first differential amplifier, the second differential amplifier, or any combination thereof.
Clause 4: The method of any of clauses 1-3, wherein the fixed reference voltage comprises substantially half of a reference voltage of an analog-to-digital converter (ADC).
Clause 5: The method of any of clauses 1-4, wherein the fixed reference voltage is provided to the second differential amplifier, the method further comprising: providing the second signal generated by the second differential amplifier as a reference voltage to the first differential amplifier.
Clause 6: The method of any of clauses 1-5, further comprising performing a filtering operation by at least one of the first differential amplifier, the second differential amplifier, or any combination thereof.
Clause 7: The method of any of clauses 1-6, wherein the filtering operation comprises a low-pass filtering operation.
Clause 8: The method of any of clauses 1-7, wherein a plurality of resistors and zero or more capacitors are connected to the at least one of the first differential amplifier, the second differential amplifier, or any combination thereof, wherein performing the filtering operation comprises performing the filtering operation based on the plurality of resistors and the zero or more capacitors.
Clause 9: The method of any of clauses 1-8, wherein the plurality of resistors comprises two resistors for each of the first differential amplifier and the second differential amplifier, wherein the zero or more capacitors comprises zero capacitors, and wherein the filtering operation comprises a first order filtering operation.
Clause 10: The method of any of clauses 1-9, wherein the plurality of resistors comprises four resistors for each of the first differential amplifier and the second differential amplifier, wherein the zero or more capacitors comprises one capacitor for each of the first differential amplifier and the second differential amplifier, and wherein the filtering operation comprises a second-order filtering operation.
Clause 11: The method of any of clauses 1-10, wherein the plurality of resistors comprises six resistors for each of the first differential amplifier and the second differential amplifier, wherein the zero or more capacitors comprises two capacitors for each of the first differential amplifier and the second differential amplifier, and wherein the filtering operation comprises a third-order filtering operation.
Clause 12: The method of any of clauses 1-11, wherein the first set of voltage sources comprises a first set of energy storage modules, and wherein the second set of voltage sources comprises a second set of energy storage modules.
Clause 13: The method of any of clauses 1-12, wherein at least one energy storage module of the first set of energy storage modules or the second set of energy storage modules comprises an inverter circuit.
Clause 14: The method of any of clauses 1-13, wherein the inverter circuit comprises an H-bridge inverter circuit.
Clause 15: The method of any of clauses 1-14, wherein an output of at least one energy storage module of the first set of energy storage modules or the second set of energy storage modules comprises a pulse-width modulation (PWM) waveform.
Clause 16: The method of any of clauses 1-15, wherein the inductor comprises a choke.
Clause 17: The method of any of clauses 1-16, wherein the output voltage is provided by at least some voltage sources from the first set of voltage sources and the second set of voltage sources.
Clause 18: The method of any of clauses 1-17, wherein evaluating the total voltage signal comprises inputting at least one of the first signal, the second signal, or any combination thereof to an analog-to-digital converter.
Clause 19: The method of any of clauses 1-18, wherein the total voltage signal comprises a sum of the first signal and the second signal.
Clause 20: The method of any of clauses 1-19, wherein calculating the output voltage comprises calculating the output voltage based on the total voltage signal without measuring a voltage at an output of the power circuit.
Clause 21: An electrical system comprising: a power circuit comprising a first set of voltage sources and a second set of voltage sources, the first set of voltage sources and the second set of voltage sources connected via an inductor, wherein in a mode of operation the inductor is disposed in a series connection between the first set and the second set; a first differential amplifier configured to measure a first voltage across the first set of voltage sources to generate a first signal; a second differential amplifier configured to measure a second voltage across the second set of voltage sources to generate a second signal; circuitry configured to monitor an output voltage of the power circuit by evaluating a total voltage signal using the first signal and the second signal and calculating the output voltage from the total voltage signal.
Clause 22: The system of clause 21, wherein the circuitry is further configured to control the output voltage based on the total voltage signal.
Clause 23: The system of clause 21 or clause 22, wherein a fixed reference voltage is provided to at least one of the first differential amplifier, the second differential amplifier, or any combination thereof.
Clause 24: The system of any of clauses 21-23, wherein the fixed reference voltage comprises substantially half of a reference voltage of an analog-to-digital converter (ADC).
Clause 25: The system of any of clauses 21-24, wherein the fixed reference voltage is provided to the second differential amplifier, and wherein the second signal generated by the second differential amplifier is provided as a reference voltage to the first differential amplifier.
Clause 26: The system of any of clauses 21-25, wherein at least one of the first differential amplifier, the second differential amplifier, or any combination thereof is configured to perform a filtering operation.
Clause 27: The system of any of clauses 21-26, wherein the filtering operation comprises a low-pass filtering operation.
Clause 28: The system of any of clauses 21-27, wherein a plurality of resistors and zero or more capacitors are connected to the at least one of the first differential amplifier, the second differential amplifier, or any combination thereof, wherein performing the filtering operation comprises performing the filtering operation based on the plurality of resistors and the zero or more capacitors.
Clause 29: The system of any of clauses 21-28, wherein the plurality of resistors comprises two resistors for each of the first differential amplifier and the second differential amplifier, wherein the zero or more capacitors comprises zero capacitors, and wherein the filtering operation comprises a first order filtering operation.
Clause 30: The system of any of clauses 21-29, wherein the plurality of resistors comprises four resistors for each of the first differential amplifier and the second differential amplifier, wherein the zero or more capacitors comprises one capacitor for each of the first differential amplifier and the second differential amplifier, and wherein the filtering operation comprises a second-order filtering operation.
Clause 31: The system of any of clauses 21-30, wherein the plurality of resistors comprises six resistors for each of the first differential amplifier and the second differential amplifier, wherein the zero or more capacitors comprises two capacitors for each of the first differential amplifier and the second differential amplifier, and wherein the filtering operation comprises a third-order filtering operation.
Clause 32: The system of any of clauses 21-31, wherein the first set of voltage sources comprises a first set of energy storage modules, and wherein the second set of voltage sources comprises a second set of energy storage modules.
Clause 33: The system of any of clauses 21-32, wherein at least one energy storage module of the first set of energy storage modules or the second set of energy storage modules comprises an inverter circuit.
Clause 34: The system of any of clauses 21-33, wherein the inverter circuit comprises an H-bridge inverter circuit.
Clause 35: The system of any of clauses 21-34, wherein an output of at least one energy storage module of the first set of energy storage modules or the second set of energy storage modules comprises a pulse-width modulation (PWM) waveform.
Clause 36: The system of any of clauses 21-35, wherein the inductor comprises a choke.
Clause 37: The system of any of clauses 21-36, wherein the output voltage is provided by at least some voltage sources from the first set of voltage sources and the second set of voltage sources.
Clause 38: The system of any of clauses 21-37, wherein evaluating the total voltage signal comprises inputting at least one of the first signal, the second signal, or any combination thereof to an analog-to-digital converter.
Clause 39: The system of any of clauses 21-38, wherein the total voltage signal comprises a sum of the first signal and the second signal.
Clause 40: The system of any of clauses 21-39, wherein calculating the output voltage comprises calculating the output voltage based on the total voltage signal without measuring a voltage at an output of the power circuit.
Clause 41: The system of any of clauses 21-40, wherein a fixed reference voltage is connected to a first input of the second differential amplifier via a first capacitor and a first resistor, wherein an output of the second differential amplifier is connected to a second input of the second amplifier via a second capacitor and a second resistor, wherein the output of the second differential amplifier is connected to a first input of the first differential amplifier via a third capacitor and a third resistor, and wherein an output of the first differential amplifier is connected to a second input of the first differential amplifier via a fourth capacitor and a fourth resistor.
Clause 42: The system of any of clauses 21-41, wherein a first side of the first set of voltage sources is connected to the first input of the first differential amplifier via at least one fifth resistor, wherein a second side of the first set of voltage sources is connected to the second input of the first differential amplifier via at least one sixth resistor, wherein a first side of the second set of voltage sources is connected to the first input of the second amplifier via at least one seventh resistor, wherein a second side of the second set of voltage sources is connected to is connected to the second input of the second amplifier via at least one eighth resistor, wherein the first side of the first set of voltage sources is connected to a first winding of the inductor, and wherein the second side of the second set of voltage sources is connected to a second winding of the inductor.
Clause 43: The system of any of clauses 21-42, wherein the at least one fifth resistor comprises a plurality of fifth resistors and the at least one sixth resistor comprises a plurality of sixth resistors, wherein at least one fifth capacitor is connected between at least one pair of the plurality of fifth resistors and at least one pair of the plurality of sixth resistors, wherein the at least one seventh resistor comprises a plurality of seventh resistors and the at least one eighth resistor comprises a plurality of eighth resistors, and wherein at least one sixth capacitor is connected between at least one pair of the plurality of seventh resistors and at least one pair of the plurality of eighth resistors.
Clause 44: The system of any of clauses 21-43, wherein an output of the second differential amplifier is connected to a first input of the first differential amplifier, and wherein an output of the first differential amplifier is connected to an analog-to-digital converter (ADC).
Clause 45: The system of any of clauses 21-44, further comprising a third differential amplifier connected to the inductor, wherein an output of the third amplifier is connected to the ADC.
Clause 46: The system of any of clauses 21-45, further comprising: a switch configured to switch between a first state associated with a first mode of operation and a second state associated with a second mode of operation, wherein the mode of operation comprises the second mode of operation, wherein, upon switching the switch to the first state, the first set of voltage sources are connected in parallel with the second set of voltage sources and the circuitry is configured to measure the output voltage based on the output of the third amplifier, and wherein, upon switching the switch to the second state, the first set of voltage sources are connected in series with the second set of voltage sources and the circuitry is configured to measure the voltage based on the output of the first amplifier.
Clause 47: The system of any of clauses 21-46, further comprising a third differential amplifier configured to additively combine the output of the first amplifier and the output of the second amplifier.
Clause 48: The system of any of clauses 21-47, wherein the circuitry comprises at least one analog-to-digital converter (ADC), and wherein the at least one ADC is configured to convert at least one of the first signal, the second signal, or any combination thereof to at least one digital output.
Clause 49: The system of any of clauses 21-48, wherein the at least one ADC is configured to convert the first signal to a first digital output and convert the second signal to a second digital output.
Clause 50: The system of any of clauses 21-49, wherein the circuitry is further configured to: remove a direct current (DC) offset from the first digital output to provide a first intermediate digital output; remove the DC offset from the second digital output to provide a second intermediate digital output; and additively combined the first intermediate digital output and the second intermediate digital output.
Clause 51: A computer program product for monitoring an output voltage of a power circuit comprising a first set of voltage sources and a second set of voltage sources, the first set of voltage sources and the second set of voltage sources connected via an inductor, wherein in a mode of operation the inductor is disposed in a series connection between the first set and the second set, the computer program product comprising at least one non-transitory computer-readable medium including program instructions that, when executed by at least one processor, cause the at least one processor to: evaluate a total voltage signal using a first signal and a second signal, wherein the first signal was generated by a first differential amplifier measuring a first voltage across the first set of voltage sources and the second signal was generated by a second differential amplifier measuring a second voltage across the second set of voltage sources; and calculate the output voltage from the total voltage signal.
Clause 52: The computer program product of clause 51, wherein the instructions, when executed by the at least one processor, further cause the at least one processor to control the output voltage based on the total voltage signal.
Clause 53: The computer program product of clause 51 or clause 52, wherein a fixed reference voltage is provided to at least one of the first differential amplifier, the second differential amplifier, or any combination thereof.
Clause 54: The computer program product of any of clauses 51-53, wherein the fixed reference voltage comprises substantially half of a reference voltage of an analog-to-digital converter (ADC).
Clause 55: The computer program product of any of clauses 51-54, wherein the fixed reference voltage is provided to the second differential amplifier, and wherein the second signal generated by the second differential amplifier is provided as a reference voltage to the first differential amplifier.
Clause 56: The computer program product of any of clauses 51-55, wherein at least one of the first differential amplifier, the second differential amplifier, or any combination thereof is configured to perform a filtering operation.
Clause 57: The computer program product of any of clauses 51-56, wherein the filtering operation comprises a low-pass filtering operation.
Clause 58: The computer program product of any of clauses 51-57, wherein a plurality of resistors and zero or more capacitors are connected to the at least one of the first differential amplifier, the second differential amplifier, or any combination thereof, wherein performing the filtering operation comprises performing the filtering operation based on the plurality of resistors and the zero or more capacitors.
Clause 59: The computer program product of any of clauses 51-58, wherein the plurality of resistors comprises two resistors for each of the first differential amplifier and the second differential amplifier, wherein the zero or more capacitors comprises zero capacitors, and wherein the filtering operation comprises a first order filtering operation.
Clause 60: The computer program product of any of clauses 51-59, wherein the plurality of resistors comprises four resistors for each of the first differential amplifier and the second differential amplifier, wherein the zero or more capacitors comprises one capacitor for each of the first differential amplifier and the second differential amplifier, and wherein the filtering operation comprises a second-order filtering operation.
Clause 61: The computer program product of any of clauses 51-60, wherein the plurality of resistors comprises six resistors for each of the first differential amplifier and the second differential amplifier, wherein the zero or more capacitors comprises two capacitors for each of the first differential amplifier and the second differential amplifier, and wherein the filtering operation comprises a third-order filtering operation.
Clause 62: The computer program product of any of clauses 51-61, wherein the first set of voltage sources comprises a first set of energy storage modules, and wherein the second set of voltage sources comprises a second set of energy storage modules.
Clause 63: The computer program product of any of clauses 51-62, wherein at least one energy storage module of the first set of energy storage modules or the second set of energy storage modules comprises an inverter circuit.
Clause 64: The computer program product of any of clauses 51-63, wherein the inverter circuit comprises an H-bridge inverter circuit.
Clause 65: The computer program product of any of clauses 51-64, wherein an output of at least one energy storage module of the first set of energy storage modules or the second set of energy storage modules comprises a pulse-width modulation (PWM) waveform.
Clause 66: The computer program product of any of clauses 51-65, wherein the inductor comprises a choke.
Clause 67: The computer program product of any of clauses 51-66, wherein the output voltage is provided by at least some voltage sources from the first set of voltage sources and the second set of voltage sources.
Clause 68: The computer program product of any of clauses 51-67, wherein evaluating the total voltage signal comprises inputting at least one of the first signal, the second signal, or any combination thereof to an analog-to-digital converter.
Clause 69: The computer program product of any of clauses 51-68, wherein the total voltage signal comprises a sum of the first signal and the second signal.
Clause 70: The computer program product of any of clauses 51-69, wherein calculating the output voltage comprises calculating the output voltage based on the total voltage signal without measuring a voltage at an output of the power circuit.
Clause 71: The computer program product of any of clauses 51-70, wherein a fixed reference voltage is connected to a first input of the second differential amplifier via a first capacitor and a first resistor, wherein an output of the second differential amplifier is connected to a second input of the second amplifier via a second capacitor and a second resistor, wherein the output of the second differential amplifier is connected to a first input of the first differential amplifier via a third capacitor and a third resistor, and wherein an output of the first differential amplifier is connected to a second input of the first differential amplifier via a fourth capacitor and a fourth resistor.
Clause 72: The computer program product of any of clauses 51-71, wherein a first side of the first set of voltage sources is connected to the first input of the first differential amplifier via at least one fifth resistor, wherein a second side of the first set of voltage sources is connected to the second input of the first differential amplifier via at least one sixth resistor, wherein a first side of the second set of voltage sources is connected to the first input of the second amplifier via at least one seventh resistor, wherein a second side of the second set of voltage sources is connected to is connected to the second input of the second amplifier via at least one eighth resistor, wherein the first side of the first set of voltage sources is connected to a first winding of the inductor, and wherein the second side of the second set of voltage sources is connected to a second winding of the inductor.
Clause 73: The computer program product of any of clauses 51-72, wherein the at least one fifth resistor comprises a plurality of fifth resistors and the at least one sixth resistor comprises a plurality of sixth resistors, wherein at least one fifth capacitor is connected between at least one pair of the plurality of fifth resistors and at least one pair of the plurality of sixth resistors, wherein the at least one seventh resistor comprises a plurality of seventh resistors and the at least one eighth resistor comprises a plurality of eighth resistors, and wherein at least one sixth capacitor is connected between at least one pair of the plurality of seventh resistors and at least one pair of the plurality of eighth resistors.
Clause 74: The computer program product of any of clauses 51-73, wherein an output of the second differential amplifier is connected to a first input of the first differential amplifier, and wherein an output of the first differential amplifier is connected to an analog-to-digital converter (ADC).
Clause 75: The computer program product of any of clauses 51-74, wherein the power circuit further comprises a third differential amplifier connected to the inductor, wherein an output of the third amplifier is connected to the ADC.
Clause 76: The computer program product of any of clauses 51-75, wherein the power circuit further comprises a switch configured to switch between a first state associated with a first mode of operation and a second state associated with a second mode of operation, wherein the mode of operation comprises the second mode of operation, wherein, upon switching the switch to the first state, the first set of voltage sources are connected in parallel with the second set of voltage sources and the instructions, when executed by the at least one processor, further cause the at least one processor to measure the output voltage based on the output of the third amplifier, and wherein, upon switching the switch to the second state, the first set of voltage sources are connected in series with the second set of voltage sources and the instructions, when executed by the at least one processor, further cause the at least one processor to measure the voltage based on the output of the first amplifier.
Clause 77: The computer program product of any of clauses 51-76, wherein the power circuit further comprises a third differential amplifier configured to additively combine the output of the first amplifier and the output of the second amplifier.
Clause 78: The computer program product of any of clauses 51-77, wherein the power circuit further comprises at least one analog-to-digital converter (ADC), and wherein the at least one ADC is configured to convert at least one of the first signal, the second signal, or any combination thereof to at least one digital output.
Clause 79: The computer program product of any of clauses 51-78, wherein the at least one ADC is configured to convert the first signal to a first digital output and convert the second signal to a second digital output.
Clause 80: The computer program product of any of clauses 51-79, wherein the instructions, when executed by the at least one processor, further cause the at least one processor to: remove a direct current (DC) offset from the first digital output to provide a first intermediate digital output; remove the DC offset from the second digital output to provide a second intermediate digital output; and additively combine the first intermediate digital output and the second intermediate digital output.
Clause 81: A system (e.g., a power circuit and/or an electrical system) comprising means for performing the steps of any of the above method clauses.
Clause 82: A software product comprising instructions which when executed by a suitable system (e.g., a power circuit and/or an electrical system comprising one or more controllers) causes the system (e.g., via any of the one or more controllers) to perform the steps of any of the above method clauses.

Although embodiments have been described in detail for the purpose of illustration, it is to be understood that such detail is solely for that purpose and that the disclosure is not limited to the disclosed embodiments or aspects, but, on the contrary, is intended to cover modifications and equivalent arrangements that are within the spirit and scope of the appended claims. For example, it is to be understood that the present disclosure contemplates that, to the extent possible, one or more features of any embodiment or aspect can be combined with one or more features of any other embodiment or aspect.

## Claims

1. A method for monitoring an output voltage of a power circuit comprising a first set of voltage sources and a second set of voltage sources, wherein the first set of voltage sources and the second set of voltage sources are connected via an inductor, wherein in a mode of operation the inductor is disposed in a series connection between the first set of voltage sources and the second set of voltage sources, the method comprising:
measuring, via a first differential amplifier, a first voltage across the first set of voltage sources to generate a first signal;
measuring, via a second differential amplifier, a second voltage across the second set of voltage sources to generate a second signal;
evaluating a total voltage signal based on the first signal and the second signal; and
calculating the output voltage from the total voltage signal.

2. The method of claim 1, further comprising controlling the output voltage based on the total voltage signal.

3. The method of claim 1 or claim 2, further comprising providing a fixed reference voltage to at least one of the first differential amplifier, the second differential amplifier, or any combination thereof.

4. The method of claim 3, wherein the fixed reference voltage is provided to the second differential amplifier, the method further comprising:
providing the second signal generated by the second differential amplifier as a reference voltage to the first differential amplifier.

5. The method of any of claims 1-4, further comprising performing a filtering operation by at least one of the first differential amplifier, the second differential amplifier, or any combination thereof, preferably the filtering operation comprising a low-pass filtering operation.

6. The method of claim 5, wherein a plurality of resistors and zero or more capacitors are connected to the at least one of the first differential amplifier, the second differential amplifier, or any combination thereof, wherein performing the filtering operation comprises performing the filtering operation based on the plurality of resistors and the zero or more capacitors.

7. The method of claim 6, wherein the plurality of resistors comprises two resistors for each of the first differential amplifier and the second differential amplifier, wherein the zero or more capacitors comprises zero capacitors, and wherein the filtering operation comprises a first order filtering operation.

8. The method of claim 6, wherein the plurality of resistors comprises four resistors for each of the first differential amplifier and the second differential amplifier, wherein the zero or more capacitors comprises one capacitor for each of the first differential amplifier and the second differential amplifier, and wherein the filtering operation comprises a second-order filtering operation.

9. The method of claim 6, wherein the plurality of resistors comprises six resistors for each of the first differential amplifier and the second differential amplifier, wherein the zero or more capacitors comprises two capacitors for each of the first differential amplifier and the second differential amplifier, and wherein the filtering operation comprises a third-order filtering operation.

10. The method of any of claims 1-9, wherein the output voltage is provided by at least some voltage sources from the first set of voltage sources and the second set of voltage sources.

11. The method of any of claims 1-10, wherein evaluating the total voltage signal comprises inputting at least one of the first signal, the second signal, or any combination thereof to an analog-to-digital converter.

12. The method of any of claims 1-11, wherein the total voltage signal comprises a sum of the first signal and the second signal.

13. The method of any of claims 1-12, wherein calculating the output voltage comprises calculating the output voltage based on the total voltage signal without measuring a voltage at an output of the power circuit.

14. A system comprising means for performing the steps of any of the above method claims.

15. A software product comprising instructions which when executed by a suitable system causes the system to perform the steps of any of the above method claims.
